# EUROPEAN PATENT SPECIFICATION

(11) **EP 4 438 607 B1**
(45) Date of publication and mention of the grant of the patent: **22.07.2026**
(21) Application number: 24167032.2
(22) Date of filing: 27.03.2024
(51) Int. Cl.: C07F 5/02, C07F 7/08, C07F 7/30, H10K 85/00, C09K 11/06, H10K 85/60

(54) **POLYCYCLIC COMPOUND AND ORGANIC LIGHT EMITTING DEVICE INCLUDING THE SAME**
POLYCYCLISCHE VERBINDUNG UND ORGANISCHE LICHTEMITTIERENDE VORRICHTUNG DAMIT
COMPOSÉ POLYCYCLIQUE ET DISPOSITIF ÉLECTROLUMINESCENT ORGANIQUE LE COMPRENANT

(30) Priority: 28.03.2023 KR 20230040734; 19.02.2024 KR 20240023591
(43) Date of publication of application: 02.10.2024
(73) Proprietor: SFC Co., Ltd., Cheongju-si, Chungcheongbuk-do 28122 (KR)
(72) Inventor: KIM, Ji-hwan, 28122 Cheongju-si (KR); PARK, Kyung-hwa, 28122 Cheongju-si (KR); JO, Hyeon-jun, 28122 Cheongju-si (KR); WOO, Seong-eun, 28122 Cheongju-si (KR); KANG, Soo-kyung, 28122 Cheongju-si (KR); LEE, Da-yeon, 28122 Cheongju-si (KR); CHOI, Hui-jae, 28122 Cheongju-si (KR); LEE, Ji-hyun, 28122 Cheongju-si (KR); JOO, Sung-hoon, 28122 Cheongju-si (KR)
(74) Representative: Grosse, Felix Christopher

(56) References cited:
- EP-A1- 4 056 577
- WO-A1-2021/107678
- US-A1- 2021 305 514
- DATABASE REAXYS [online] 1 January 2021 (2021-01-01), SFC: "SFC POLYCYCLIC AROMATIC COMPOUND AND ORGANOELECTROLUMINESCENT DEVICE USING THE SAME - US2021/305514; (2021); (A1)", XP093214002, Database accession no. XRN = 57905263, 57905293, 57905357, 57905376
- DATABASE CAPLUS [online] 1 January 2021 (2021-01-01), LG CHEM CO. ET AL: "Preparation of boron-containing heterocycle compound for organic light-emitting device - WO 2021107678 A1", XP093214003, Database accession no. 2021:1210245

## Description

The present invention relates to a polycyclic compound employed in an organic layer (for example, a light emitting layer) of an organic light emitting device and an organic light emitting device including the polycyclic compound.

Organic light emitting devices are self-luminous devices in which electrons injected from an electron injecting electrode (cathode) recombine with holes injected from a hole injecting electrode (anode) in a light emitting layer to form excitons, which emit light while releasing energy. Such organic light emitting devices have the advantages of low driving voltage, high luminance, large viewing angle, and short response time and can be applied to full-color light emitting flat panel displays. Due to these advantages, organic light emitting devices have received attention as next-generation light sources.

The above characteristics of organic light emitting devices are achieved by structural optimization of organic layers of the devices and are supported by stable and efficient materials for the organic layers, such as hole injecting materials, hole transport materials, light emitting materials, electron transport materials, electron injecting materials, and electron blocking materials. However, more research still needs to be done to develop structurally optimized structures of organic layers for organic light emitting devices and stable and efficient materials for organic layers of organic light emitting devices.

Particularly, for maximum efficiency in a light emitting layer, an appropriate combination of energy band gaps of a host and a dopant is required such that holes and electrons migrate to the dopant through stable electrochemical paths to form excitons. The publications EP4056577A1, US2021/305514A1 and WO2021/107678A1 describe known polycyclic compounds employed as dopants in an organic layer of organic light emitting devices.

Therefore, the present invention is intended to provide a polycyclic compound with a specific fused ring structure and an organic light emitting device including a light emitting layer that employs the polycyclic compound as a dopant material, achieving significantly long lifetime and improved luminous efficiency.

One aspect of the present invention provides a polycyclic compound with a specific fused ring structure and which is defined in appended claim 1.

A further aspect of the present invention provides an organic light emitting device including the polycyclic compound as a dopant for a light emitting layer.

The organic light emitting device of the present invention includes a light emitting layer in which the polycyclic compound having a specific fused ring structure is employed as a dopant. The use of the dopant ensures high efficiency and long lifetime of the organic light emitting device. Due to these advantages, the organic light emitting device of the present invention can find useful applications in not only lighting systems but also a variety of displays, including flat panel displays, flexible displays, and wearable displays.

The present invention will now be described in more detail.

Disclosed herein but not forming part of the present invention is a polycyclic compound represented by Formula 1: 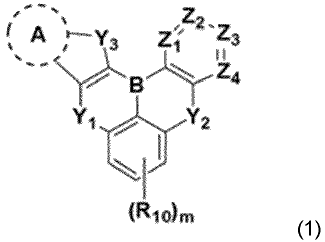
**wherein** Y₃ is selected from O, S, and NR₁, Y₁ and Y₂ are the same as or different from each other and are each independently selected from NR₂, O, S, Se, CR₃R₄, SiR₅R₆, and GeR₇R₈, A is selected from substituted or unsubstituted C₆-C₅₀ aromatic hydrocarbon rings, substituted or unsubstituted C₃-C₅₀ aliphatic hydrocarbon rings, substituted or unsubstituted C₂-C₅₀ aromatic heterocyclic rings, substituted or unsubstituted C₂-C₅₀ aliphatic heterocyclic rings, and rings in which a substituted or unsubstituted C₃-C₃₀ aliphatic ring and a C₃-C₃₀ aromatic ring are fused together, R₁ to R₈ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, Z₁ to Z₄ are the same as or different from each other and are each independently CR₉ or N, provided that when two or more of Z₁ to Z₄ are CR₉, the groups R₉ are the same as or different from each other, R₉ are the same as or different from each other and are each independently selected from hydrogen, deuterium, substituted or unsubstituted C₆-C₅₀ aryl, substituted or unsubstituted C₂-C₅₀ heteroaryl, substituted or unsubstituted C₃-C₅₀ cycloalkyl, cyclic groups in which a substituted or unsubstituted C₃-C₃₀ aliphatic ring and a C₅-C₃₀ aromatic ring are fused together, and substituted or unsubstituted amine, m is an integer of 3, the groups R₁₀ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted amine, substituted or unsubstituted silyl, substituted or unsubstituted germanium, nitro, cyano, and halogen, with the proviso that at least one of the groups R₁₀ is other than hydrogen or deuterium, that at least two of Z₁ to Z₄ are CR₉, and that at least two of the groups R₉ are other than hydrogen or deuterium and each includes at least one structure represented by Structural Formula A: 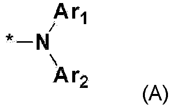
wherein Ar₁ and Ar₂ are the same as or different from each other and are each independently selected from substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, with the proviso that each of R₁ to R₈ is optionally linked to an adjacent substituent to form an alicyclic or aromatic mono- or polycyclic ring, that R₃ and R₄ are optionally linked to each other to form an alicyclic or aromatic mono- or polycyclic ring, that R₅ and R₆ are optionally linked to each other to form an alicyclic or aromatic mono- or polycyclic ring, and that R₇ and R₈ are optionally linked to each other to form an alicyclic or aromatic mono- or polycyclic ring;
or Formula 2: 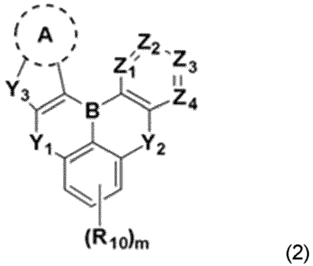
wherein A, Y₁ to Y₃, Z₁ to Z₄, R₁₀, and m are as defined in Formula 1.

According to one embodiment disclosed herein but not according to the present invention, the polycyclic compound of Formula 1 may be represented by Formula 1-1: 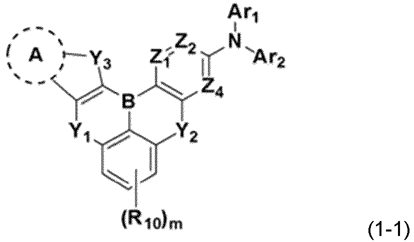
wherein Z₁, Z₂, and Z₄ are the same as or different from each other and are each independently CR₉ or N, provided that when two or more of Z₁, Z₂, and Z₄ are CR₉, the groups R₉ are the same as or different from each other, with the proviso that one or more of Z₁, Z₂, and Z₄ are CR₉ and at least one of the groups R₉ is other than hydrogen or deuterium, and A, R₉, R₁₀, Ar₁, Ar₂, m, and Y₁ to Y₃ are as defined in Formulas 1 and 2; and the polycyclic compound of Formula 2 may be represented by Formula 2-1: 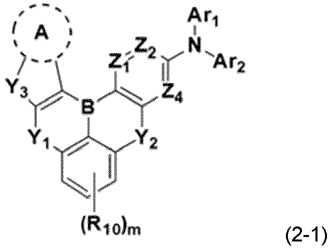
wherein A, Y₁ to Y₃, Z₁, Z₂, Z₄, Ar₁, Ar₂, R₁₀, and m are as defined in Formula 2-1.

According to one embodiment disclosed herein but not according to the present invention, Z₂ in each of Formulas 1 and 2 may be CR₉.

According to one embodiment disclosed herein but not according to the present invention, R₉ may be selected from substituted or unsubstituted C₆-C₃₀ aryl and substituted or unsubstituted C₂-C₃₀ heteroaryl.

According to one embodiment disclosed herein but not according to the present invention, both Y₁ and Y₂ in each of Formulas 1 and 2 may be NR₂.

According to one embodiment disclosed herein but not according to the present invention, at least one of the groups R₁₀ may be selected from substituted or unsubstituted C₆-C₃₀ aryl, substituted or unsubstituted C₂-C₃₀ heteroaryl, and substituted or unsubstituted C₁-C₃₀ silyl.

As used herein, the term "substituted" in the definitions of Ar₁, Ar₂, A, Y₁ to Y₃, Z₁ to Z₄, and R₁₀ in Structural Formula 1, Formula 1, and Formula 2 indicates substitution with one or more substituents selected from deuterium, C₁-C₂₄ alkyl, C₁-C₂₄ haloalkyl, C₂-C₂₄ alkenyl, C₂-C₂₄ alkynyl, C₃-C₃₀ cycloalkyl, C₁-C₂₄ heteroalkyl, C₆-C₃₀ aryl, C₇-C₃₀ arylalkyl, C₇-C₃₀ alkylaryl, C₂-C₃₀ heteroaryl, C₂-C₃₀ heteroarylalkyl, cyclic groups in which a C₃-C₂₄ aliphatic ring and a C₅-C₂₄ aromatic ring are fused together, C₁-C₂₄ alkoxy, C₁-C₃₀ amine, C₁-C₃₀ silyl, C₁-C₃₀ germanium, C₆-C₂₄ aryloxy, C₆-C₂₄ arylthionyl, cyano, halogen, hydroxyl, and nitro, or a combination thereof. The term "unsubstituted" in the same definition indicates having no substituent. One or more hydrogen atoms in each of the substituents are optionally replaced by deuterium atoms and two or more adjacent ones of the substituents are optionally linked to each other to form an alicyclic or aromatic mono- or polycyclic ring.

In the "substituted or unsubstituted C₁-C₃₀ alkyl", "substituted or unsubstituted C₆-C₅₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "optionally linked to each other or an adjacent group to form a ring" means that the corresponding adjacent substituents are bonded to each other or each of the corresponding substituents is bonded to an adjacent group to form a substituted or unsubstituted alicyclic or aromatic ring. The term "adjacent group" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other. Optionally, the paired substituents each lose one hydrogen radical and are linked to each other to form a ring. The carbon atoms in the resulting alicyclic, aromatic mono- or polycyclic ring may be replaced by one or more heteroatoms such as O, S, N, P, Si, and Ge.

In the present disclosure, the alkyl groups may be straight or branched. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 2-methylpentyl, 4-methylhexyl, and 5-methylhexyl groups.

In the present disclosure, specific examples of the arylalkyl groups include, but are not limited to, phenylmethyl(benzyl), phenylethyl, phenylpropyl, naphthylmethyl, and naphthylethyl.

In the present disclosure, specific examples of the alkylaryl groups include, but are not limited to, tolyl, xylenyl, dimethylnaphthyl, t-butylphenyl, t-butylnaphthyl, and t-butylphenanthryl.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkenyl group is a non-aromatic cyclic unsaturated hydrocarbon group having one or more carbon-carbon double bonds. The cycloalkenyl group may be, for example, cyclopropenyl, cyclobutenyl, cyclopentenyl, cyclohexenyl, cycloheptenyl, 1,3-cyclohexadienyl, 1,4-cyclohexadienyl, 2,4-cycloheptadienyl or 1,5-cyclooctadienyl but is not limited thereto.

The aromatic hydrocarbon rings or aryl groups may be monocyclic or polycyclic ones. As used herein, the term "polycyclic" means that the aromatic hydrocarbon ring may be directly attached or fused to one or more other cyclic groups. The other cyclic groups may be aromatic hydrocarbon rings and other examples thereof include aliphatic heterocyclic rings, aliphatic hydrocarbon rings, and aromatic heterocyclic rings. Examples of the monocyclic aryl groups include, but are not limited to, phenyl, biphenyl, and terphenyl. Examples of the polycyclic aryl groups include naphthyl, anthracenyl, phenanthrenyl, pyrenyl, perylenyl, tetracenyl, chrysenyl, fluorenyl, acenaphathcenyl, triphenylene, and fluoranthrene groups.

The aromatic heterocyclic rings or heteroaryl groups refer to aromatic groups containing one or more heteroatoms such as O, S, N, P, Si, and Ge. Examples of the aromatic heterocyclic rings or heteroaryl groups include, but are not limited to, thiophene, furan, pyrrole, imidazole, thiazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isoxazolyl, oxadiazolyl, thiadiazolyl, benzothiazolyl, and phenothiazinyl groups.

The aliphatic hydrocarbon rings or cycloalkyl groups refer to non-aromatic rings consisting only of carbon and hydrogen atoms. The aliphatic hydrocarbon ring is intended to include monocyclic and polycyclic ones and may be optionally substituted with one or more other substituents. As used herein, the term "polycyclic" means that the aliphatic hydrocarbon ring may be directly attached or fused to one or more other cyclic groups. The other cyclic groups may be aliphatic hydrocarbon rings and other examples thereof include aliphatic heterocyclic rings, aromatic hydrocarbon rings, and aromatic heterocyclic rings. Specific examples of the aliphatic hydrocarbon rings include, but are not limited to, cycloalkyl groups such as cyclopropyl, cyclobutyl, cyclopentyl, adamantyl, bicycloheptanyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, and cyclooctyl, cycloalkanes such as cyclohexane and cyclopentane, and cycloalkenes such as cyclohexene and cyclobutene.

The aliphatic heterocyclic rings or heterocycloalkyl groups refer to aliphatic rings containing one or more heteroatoms such as O, S, N, P, Si, and Ge. The aliphatic heterocyclic ring is intended to include monocyclic or polycyclic ones and may be optionally substituted with one or more other substituents. As used herein, the term "polycyclic" means that the aliphatic heterocyclic ring such as heterocycloalkyl or heterocycloalkane may be directly attached or fused to one or more other cyclic groups. The other cyclic groups may be aliphatic heterocyclic rings and other examples thereof include aliphatic hydrocarbon rings, aromatic hydrocarbon rings, and aromatic heterocyclic rings.

The cyclic groups in which an aliphatic ring and an aromatic ring are fused together refers to mixed aliphatic-aromatic cyclic groups in which at least one aliphatic ring and at least one aromatic ring are linked and fused together and which are overall non-aromatic. More specifically, the cyclic groups in which an aliphatic ring and an aromatic ring are fused together may be an aromatic hydrocarbon cyclic group fused with an aliphatic hydrocarbon ring, an aromatic hydrocarbon cyclic group fused with an aliphatic heterocyclic ring, an aromatic heterocyclic group fused with an aliphatic hydrocarbon ring, an aromatic heterocyclic group fused with an aliphatic heterocyclic ring, an aliphatic hydrocarbon cyclic group fused with an aromatic hydrocarbon ring, an aliphatic hydrocarbon cyclic group fused with an aromatic hydrocarbon ring, an aliphatic heterocyclic group fused with an aromatic hydrocarbon ring, and an aliphatic heterocyclic group fused with an aromatic heterocyclic ring. Specific examples of the cyclic groups in which an aliphatic ring and an aromatic ring are fused together include tetrahydronaphthyl, tetrahydrobenzocycloheptene, tetrahydrophenanthrene, tetrahydroanthracenyl, octahydrotriphenylene, tetrahydrobenzothiophene, tetrahydrobenzofuranyl, tetrahydrocarbazole, and tetrahydroquinoline. The cyclic groups in which an aliphatic ring and an aromatic ring are fused together may be interrupted by at least one heteroatom other than carbon. The heteroatom may be, for example, O, S, N, P, Si or Ge.

The alkoxy group may be specifically a methoxy, ethoxy, propoxy, isobutyloxy, sec-butyloxy, pentyloxy, iso-amyloxy or hexyloxy group but is not limited thereto.

The silyl group is intended to include -SiH₃, alkylsilyl, arylsilyl, alkylarylsilyl, arylheteroarylsilyl, and heteroarylsilyl. The arylsilyl refers to a silyl group obtained by substituting one, two or three of the hydrogen atoms in -SiH₃ with aryl groups. The alkylsilyl refers to a silyl group obtained by substituting one, two or three of the hydrogen atoms in -SiH₃ with alkyl groups. The alkylarylsilyl refers to a silyl group obtained by substituting one of the hydrogen atoms in -SiH₃ with an alkyl group and the other two hydrogen atoms with aryl groups or substituting two of the hydrogen atoms in -SiH₃ with alkyl groups and the remaining hydrogen atom with an aryl group. The arylheteroarylsilyl refers to a silyl group obtained by substituting one of the hydrogen atoms in -SiH₃ with an aryl group and the other two hydrogen atoms with heteroaryl groups or substituting two of the hydrogen atoms in -SiH₃ with aryl groups and the remaining hydrogen atom with a heteroaryl group. The heteroarylsilyl refers to a silyl group obtained by substituting one, two or three of the hydrogen atoms in -SiH₃ with heteroaryl groups. The arylsilyl group may be, for example, substituted or unsubstituted monoarylsilyl, substituted or unsubstituted diarylsilyl, or substituted or unsubstituted triarylsilyl. The same applies to the alkylsilyl and heteroarylsilyl groups.

Each of the aryl groups in the arylsilyl, heteroarylsilyl, and arylheteroarylsilyl groups may be a monocyclic or polycyclic one. Each of the heteroaryl groups in the arylsilyl, heteroarylsilyl, and arylheteroarylsilyl groups may be a monocyclic or polycyclic one.

Specific examples of the silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl. One or more of the hydrogen atoms in each of the silyl groups may be substituted with the substituents mentioned in the aryl groups.

The amine group is intended to include -NH₂, alkylamine, arylamine, arylheteroarylamine, and heteroarylamine. The arylamine refers to an amine group obtained by substituting one or two of the hydrogen atoms in -NH₂ with aryl groups. The alkylamine refers to an amine group obtained by substituting one or two of the hydrogen atoms in -NH₂ with alkyl groups. The alkylarylamine refers to an amine group obtained by substituting one of the hydrogen atoms in -NH₂ with an alkyl group and the other hydrogen atom with an aryl group. The arylheteroarylamine refers to an amine group obtained by substituting one of the hydrogen atoms in -NH₂ with an aryl group and the other hydrogen atom with a heteroaryl group. The heteroarylamine refers to an amine group obtained by substituting one or two of the hydrogen atoms in -NH₂ with heteroaryl groups. The arylamine may be, for example, substituted or unsubstituted monoarylamine, substituted or unsubstituted diarylamine, or substituted or unsubstituted triarylamine. The same applies to the alkylamine and heteroarylamine groups.

Each of the aryl groups in the arylamine, heteroarylamine, and arylheteroarylamine groups may be a monocyclic or polycyclic one. Each of the heteroaryl groups in the arylamine, heteroarylamine, and arylheteroarylamine groups may be a monocyclic or polycyclic one.

The germanium group is intended to include -GeH₃, alkylgermanium, arylgermanium, heteroarylgermanium, alkylarylgermanium, alkylheteroarylgermanium, and arylheteroarylgermanium. The definitions of the substituents in the germanium groups follow those described for the silyl groups, except that the silicon (Si) atom in each silyl group is changed to a germanium (Ge) atom.

Specific examples of the germanium groups include trimethylgermane, triethylgermane, triphenylgermane, trimethoxygermane, dimethoxyphenylgermane, diphenylmethylgermane, diphenylvinylgermane, methylcyclobutylgermane, and dimethylfurylgermane. One or more of the hydrogen atoms in each of the germanium groups may be substituted with the substituents mentioned in the aryl groups.

The cycloalkyl, aryl, and heteroaryl groups in the cycloalkyloxy, aryloxy, heteroaryloxy, cycloalkylthioxy, arylthioxy, and heteroarylthioxy groups are the same as those exemplified above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. Specific examples of the arylthioxy groups include, but are not limited to, phenylthioxy, 2-methylphenylthioxy, and 4-tert-butylphenylthioxy groups.

The halogen group may be, for example, fluorine, chlorine, bromine or iodine.

According to the present invention, the polycyclic compound is selected from the following compounds 1 to 57:

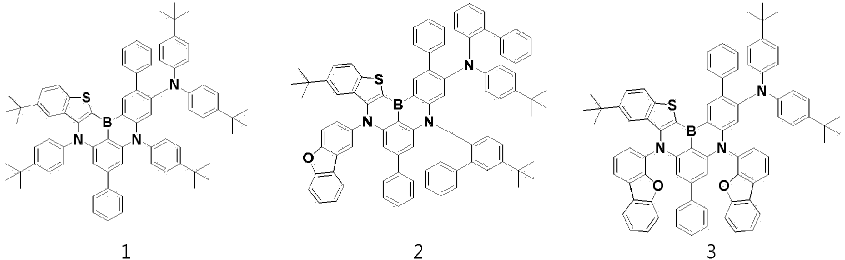

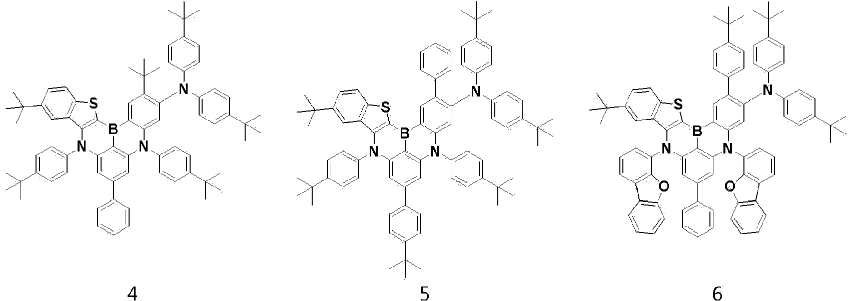

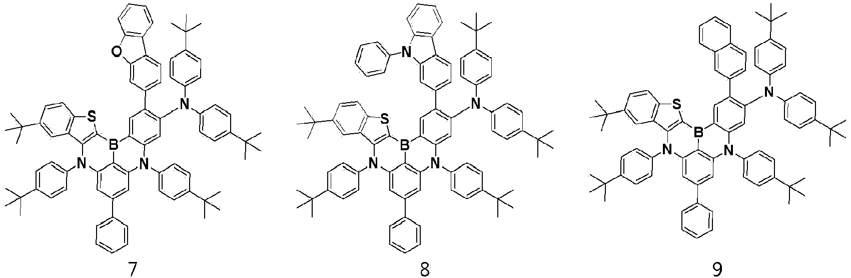

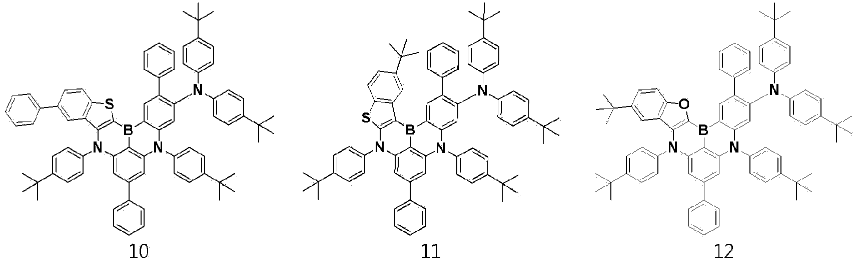

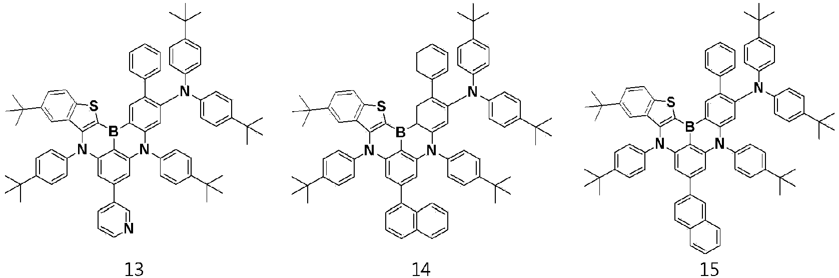

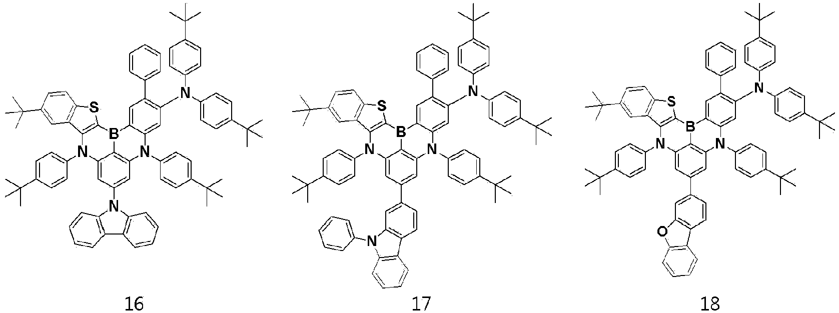

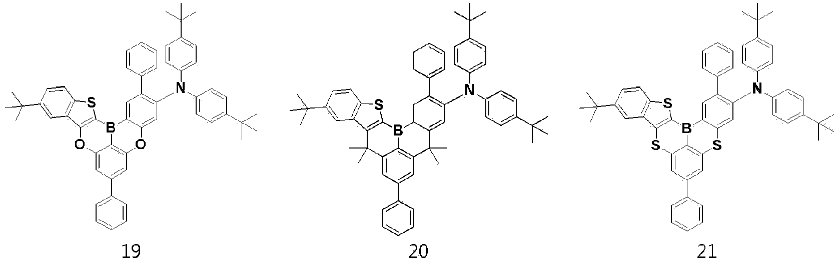

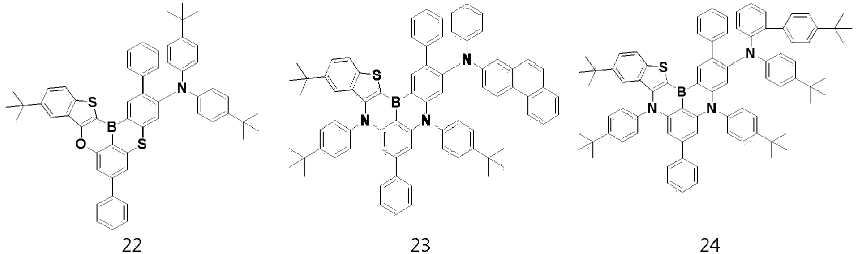

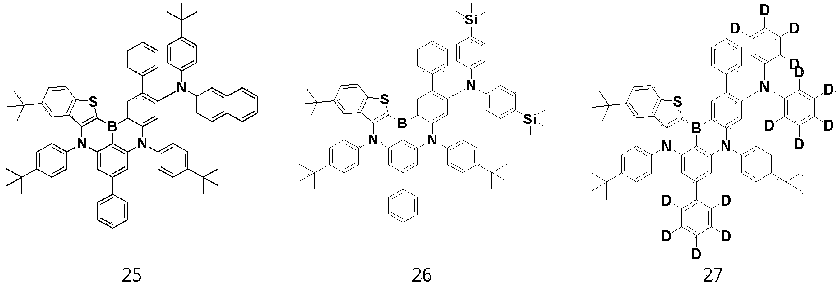

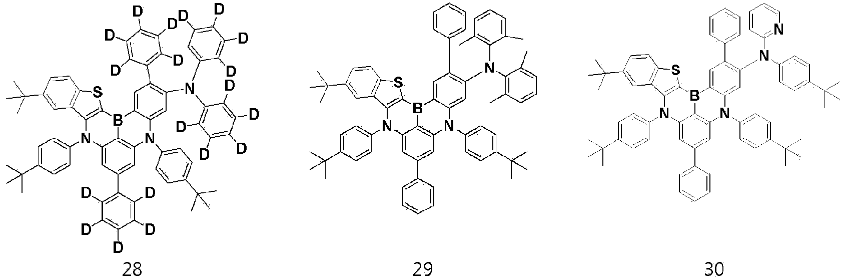

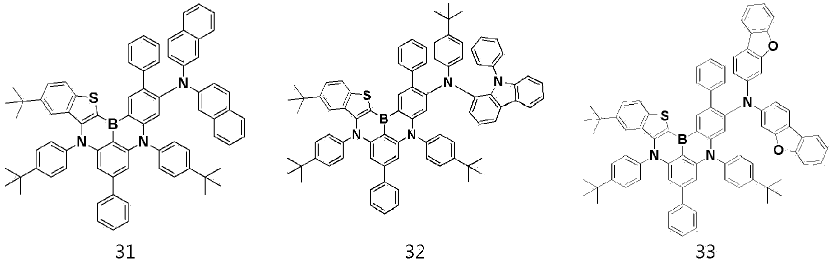

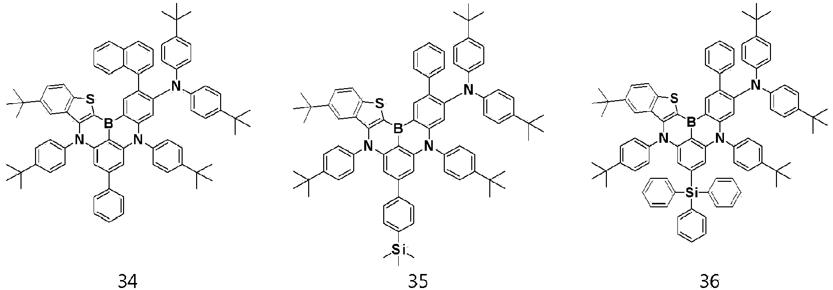

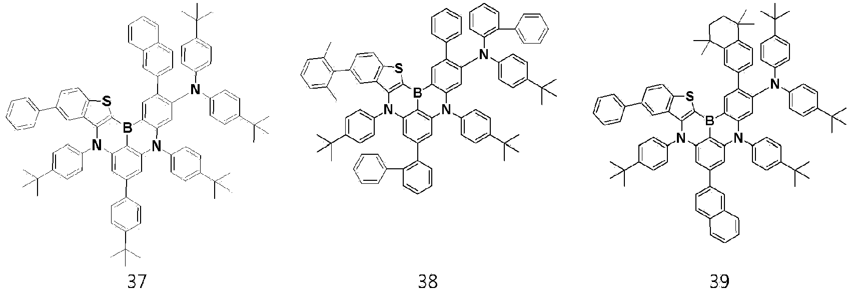

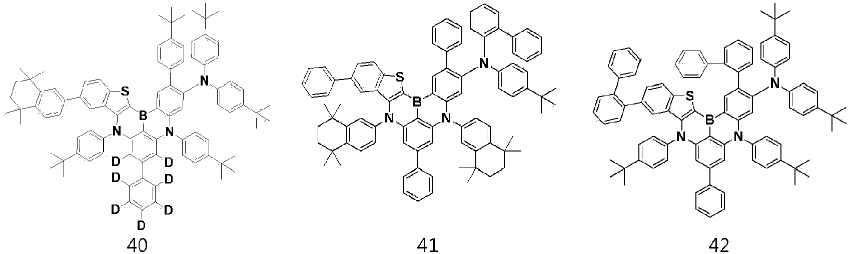

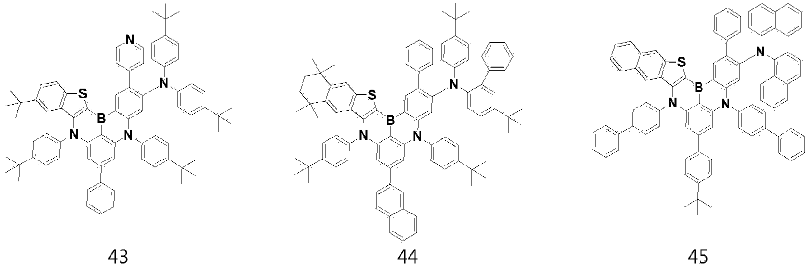

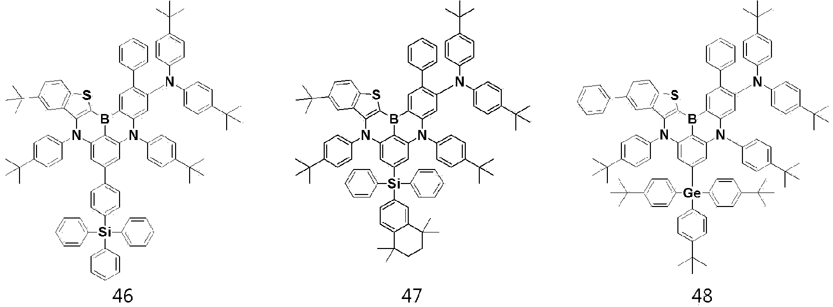

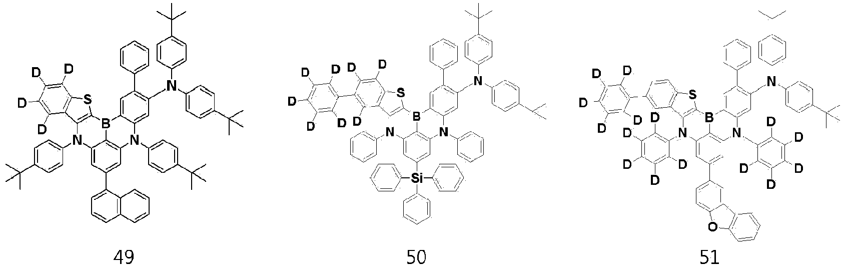

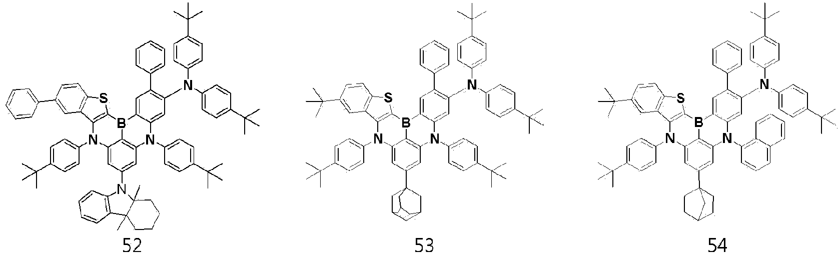

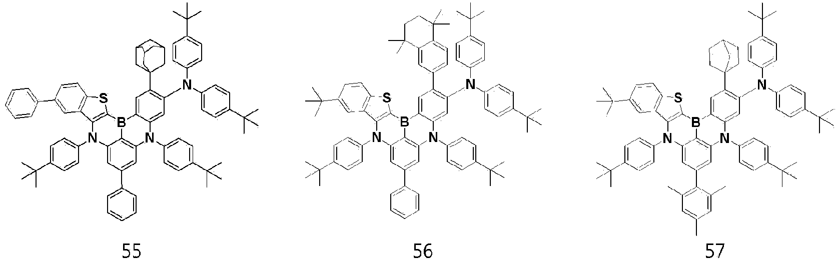

A further aspect of the present invention is directed to an organic light emitting device including a first electrode, a second electrode, and one or more organic layers interposed between the first and second electrodes wherein one of the organic layers, preferably a light emitting layer includes the compound of the present invention.

The light emitting layer may further include a host material. In this case, the content of the dopant in the light emitting layer is typically in the range of about 0.01 to about 20 parts by weight, based on about 100 parts by weight of the host but is not limited to this range.

The light emitting layer may further include one or more other dopants and one or more other host materials. In this case, the hosts and the dopant materials may be mixed or stacked in the light emitting layer.

According to one embodiment of the present invention, the host compound employed in the light emitting layer may be an anthracene compound represented by Formula 3: 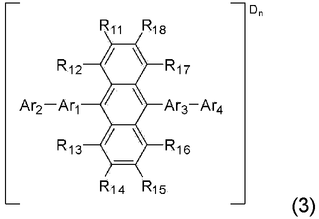 wherein R₁₁ to R₁₈ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, substituted or unsubstituted C₃-C₅₀ mixed aliphatic-aromatic cyclic groups, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, Ar₁ and Ar₃ are the same as or different from each other and are each independently a single bond or selected from substituted or unsubstituted C₆-C₃₀ arylene, substituted or unsubstituted C₅-C₃₀ heteroarylene, and divalent cyclic groups in which a substituted or unsubstituted C₃-C₃₀ aliphatic ring and a C₅-C₃₀ aromatic ring are fused together, Ar₂ and Ar₄ are the same as or different from each other and are each independently selected from substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, and substituted or unsubstituted C₃-C₅₀ mixed aliphatic-aromatic cyclic groups, Dₙ represents the number of deuterium atoms replacing hydrogen atoms, and n is an integer from 0 to 50.

According to one embodiment of the present invention, the anthracene compound represented by Formula 3 may be selected from the following compounds:

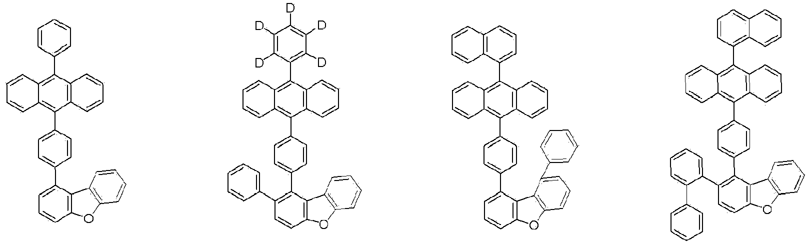

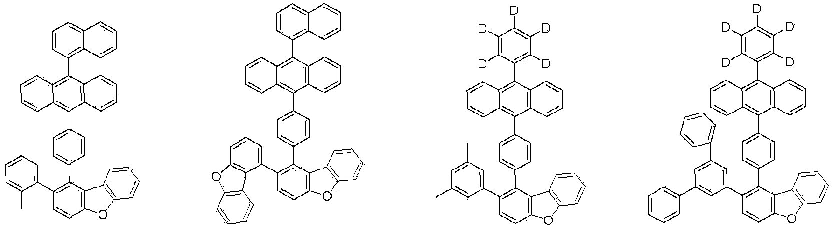

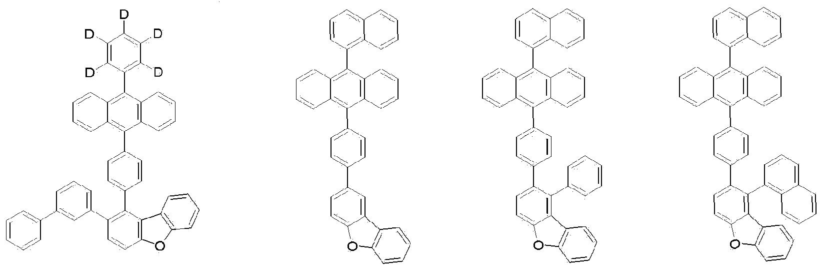

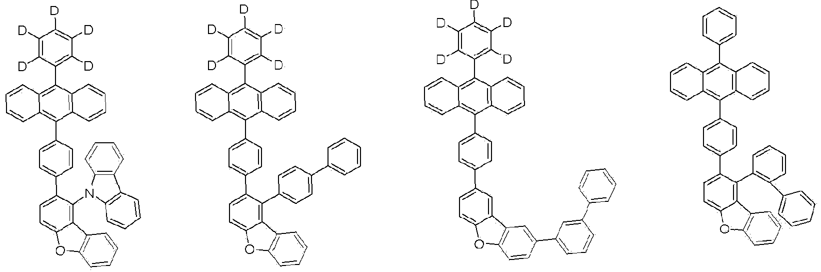

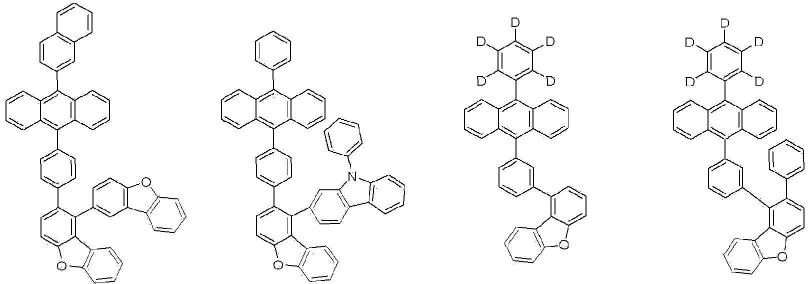

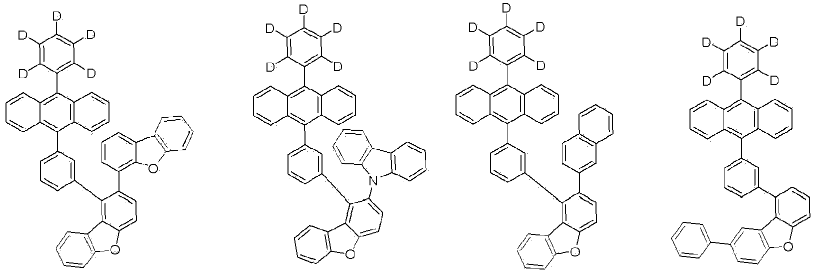

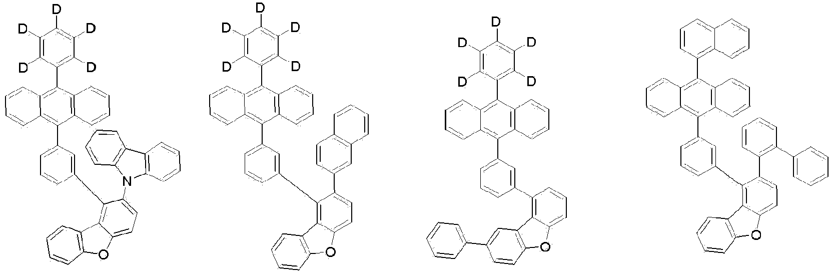

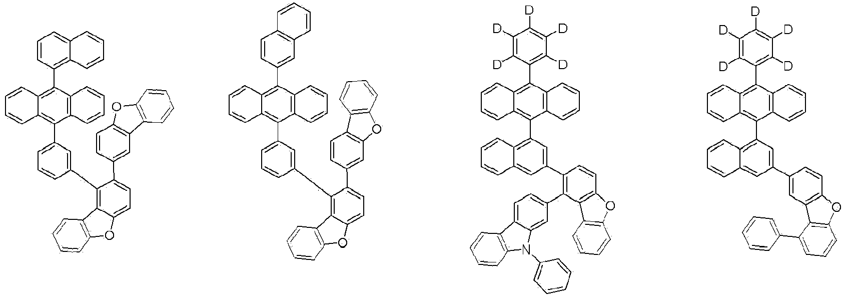

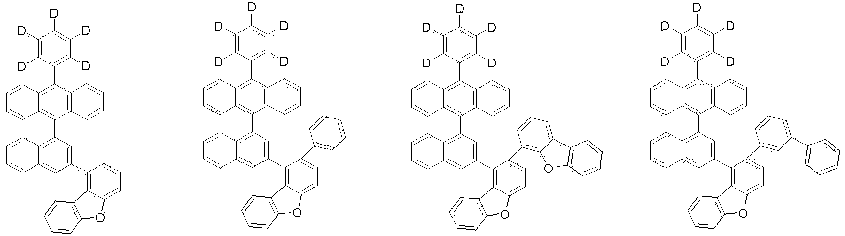

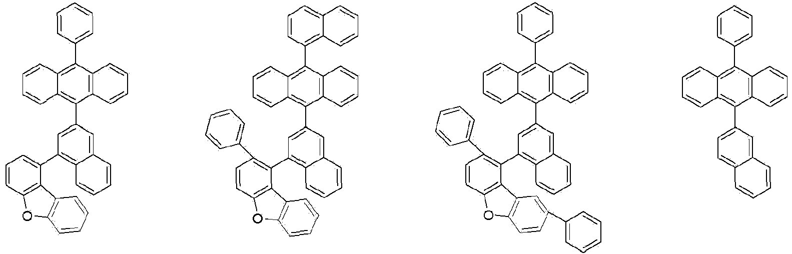

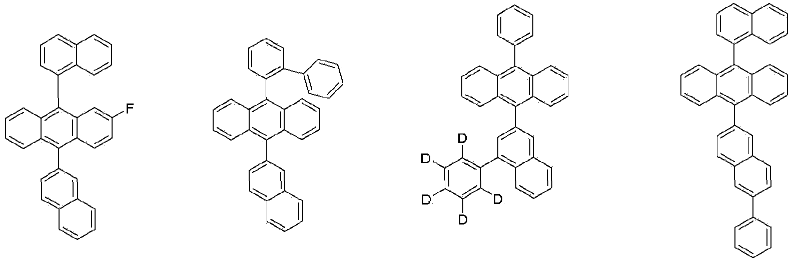

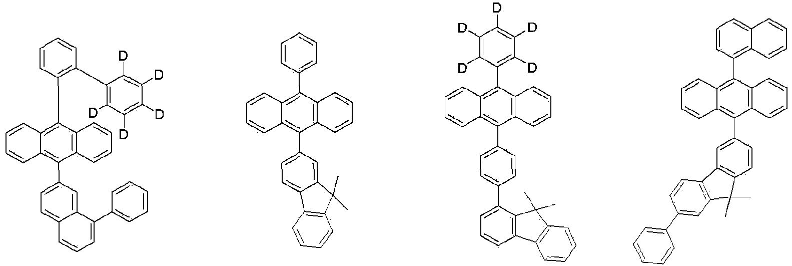

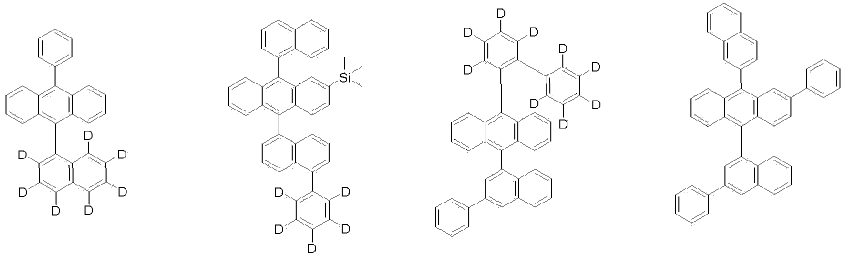

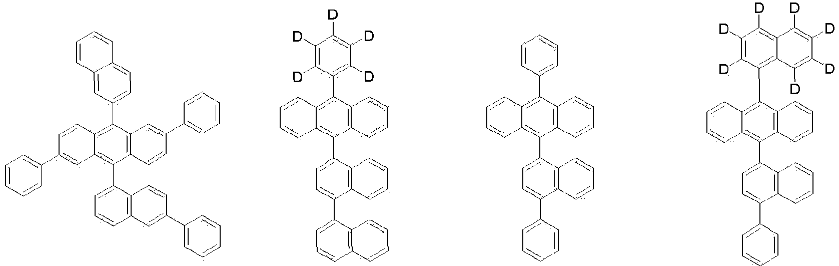

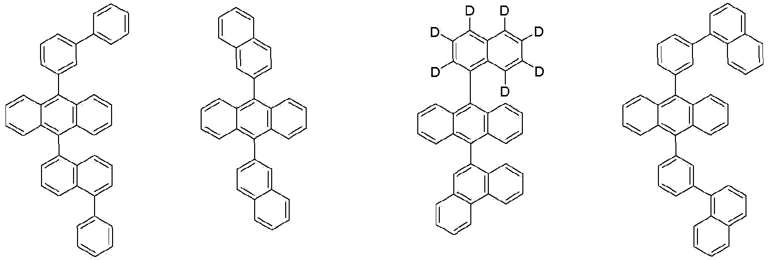

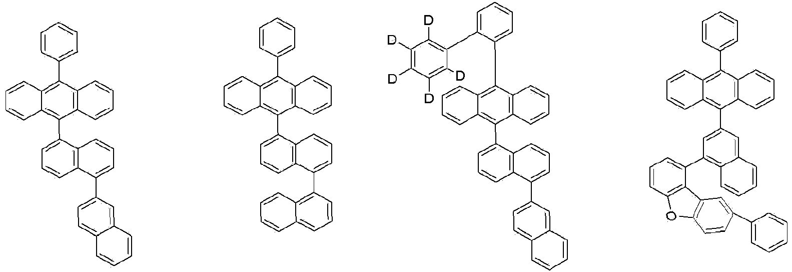

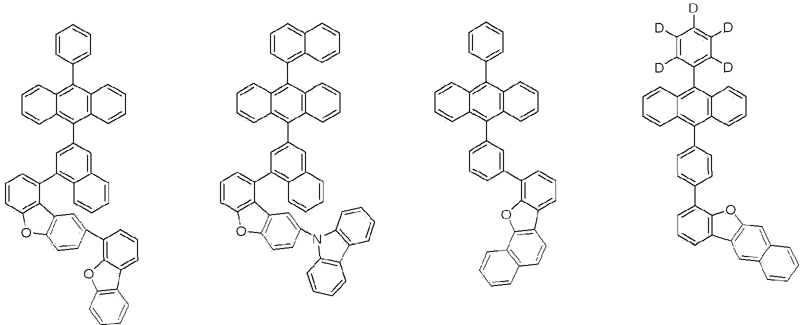

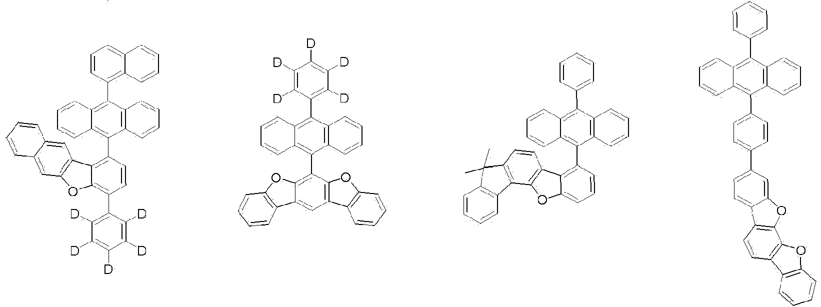

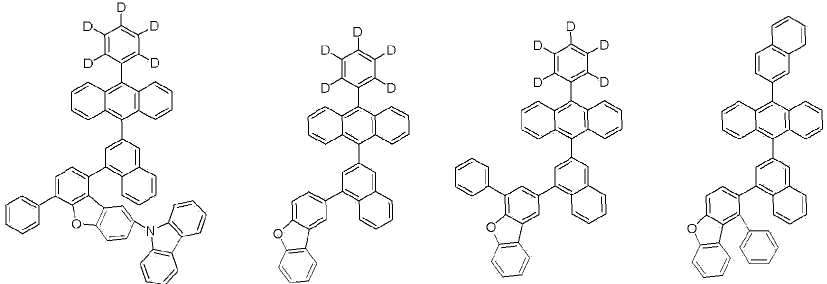

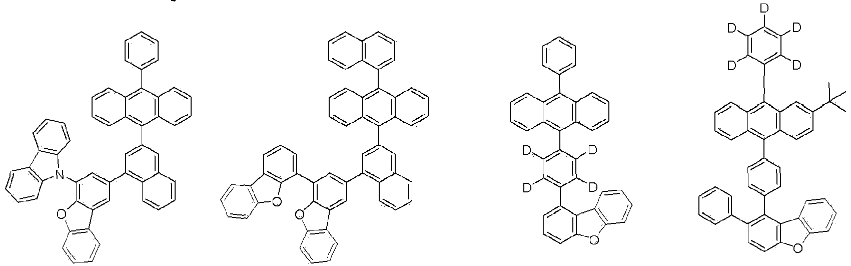

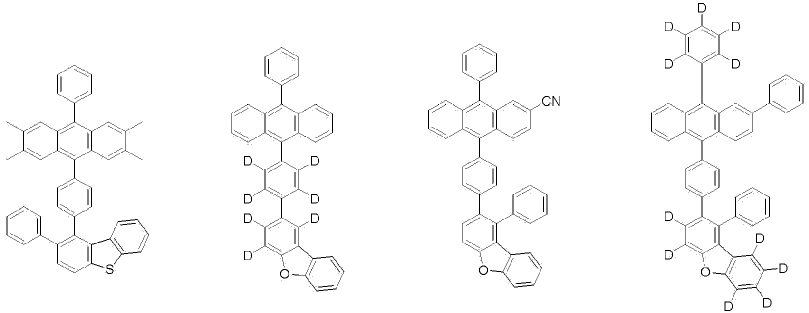

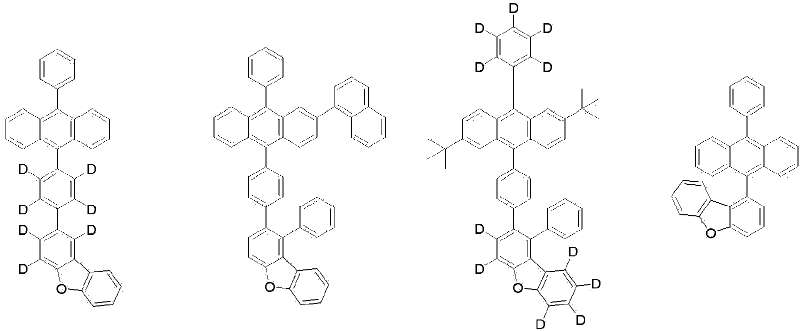

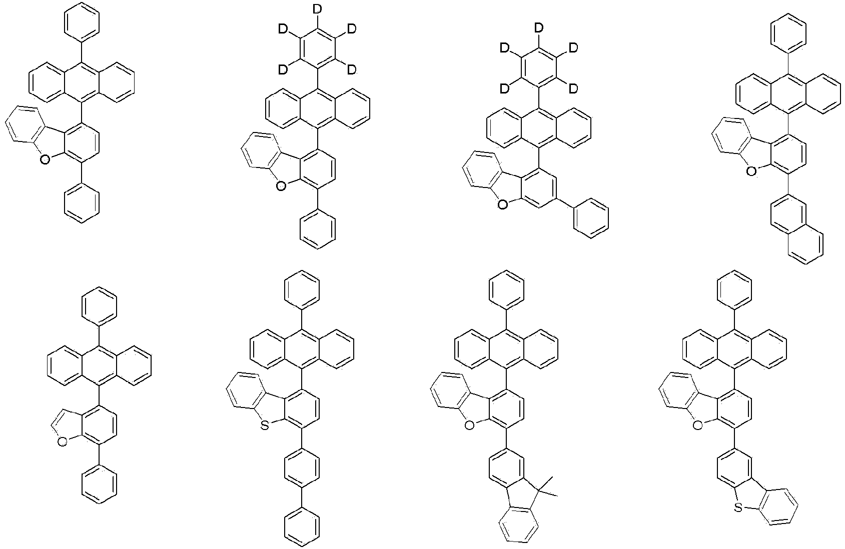

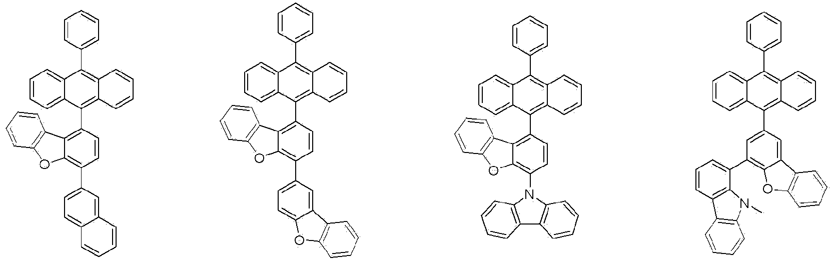

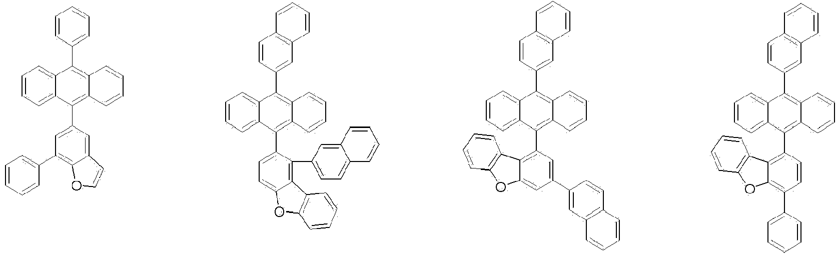

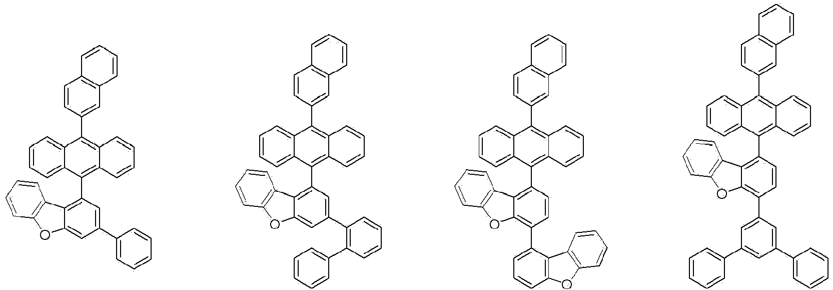

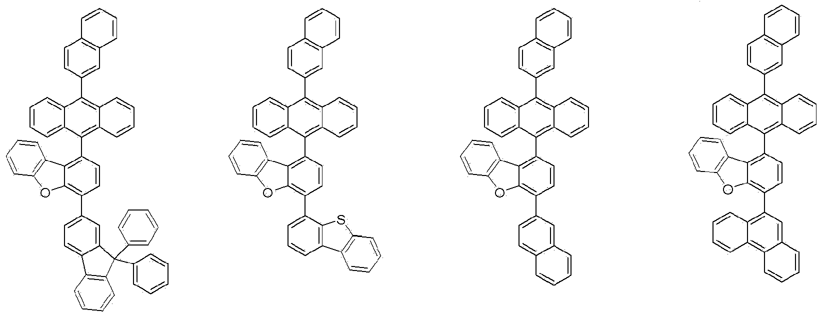

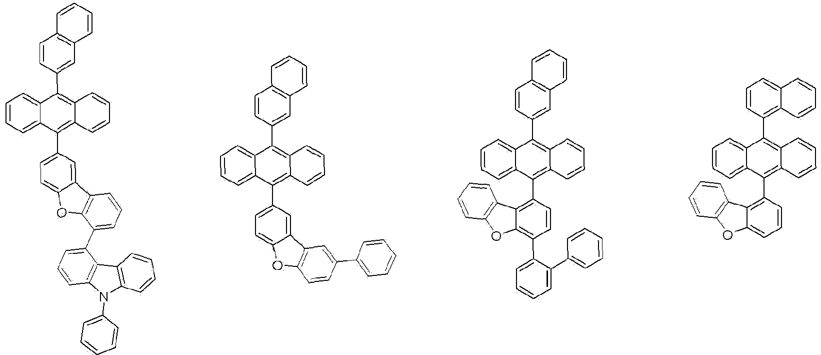

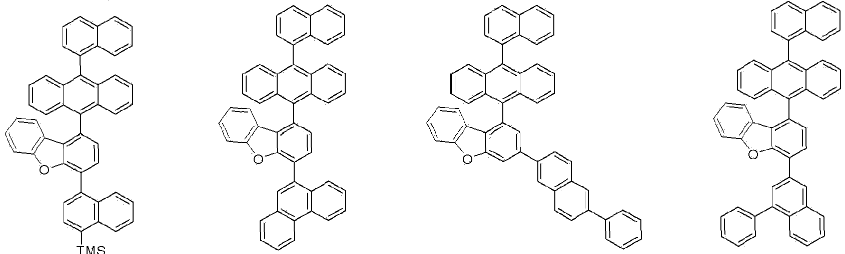

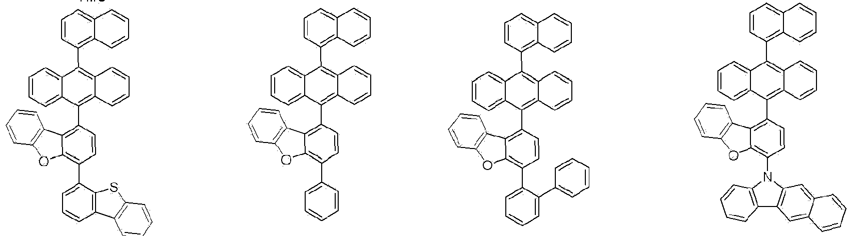

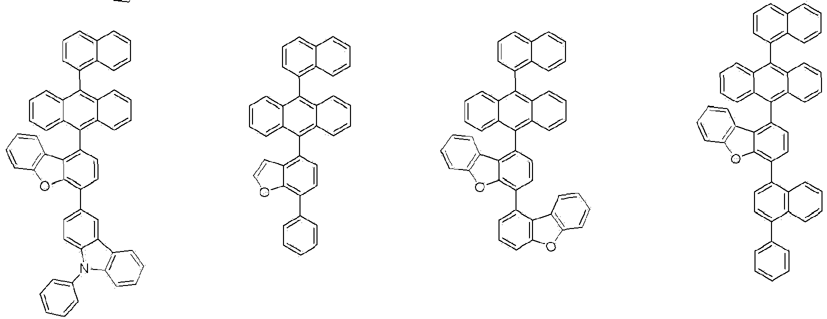

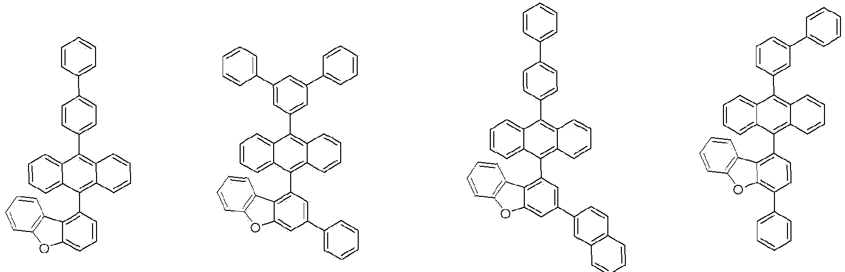

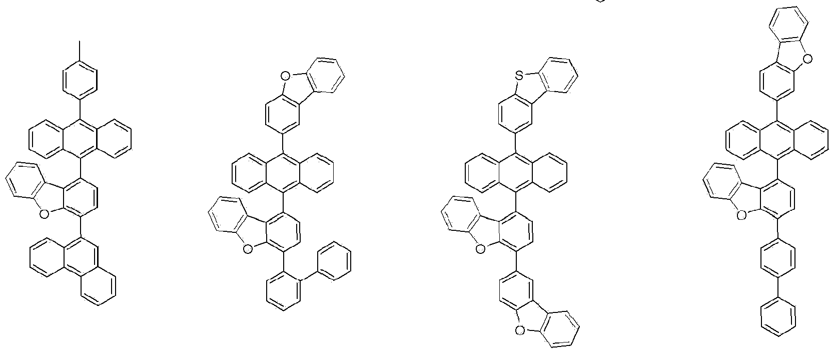

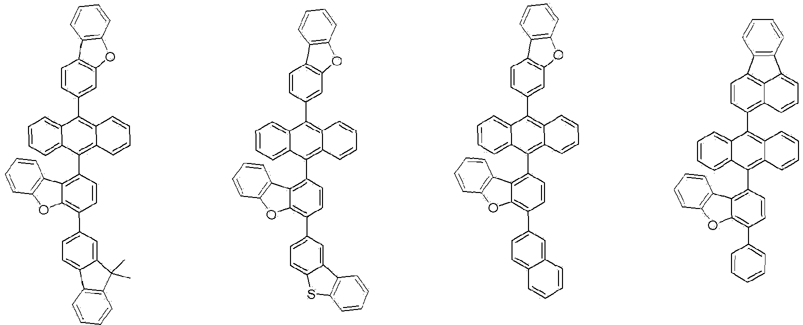

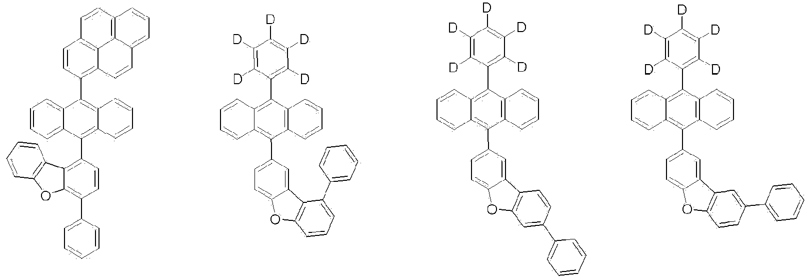

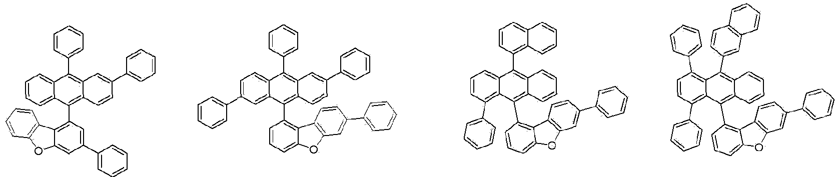

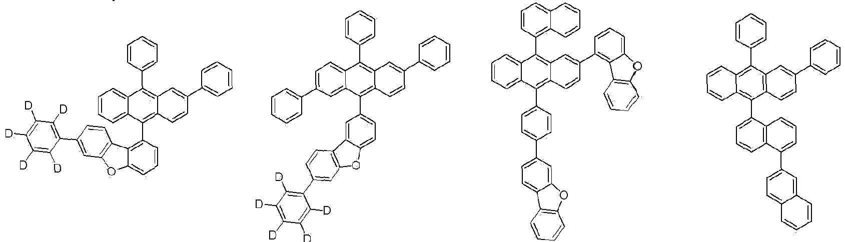

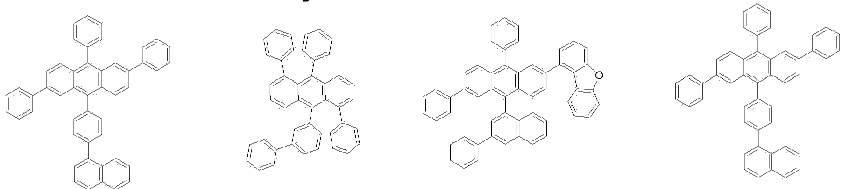

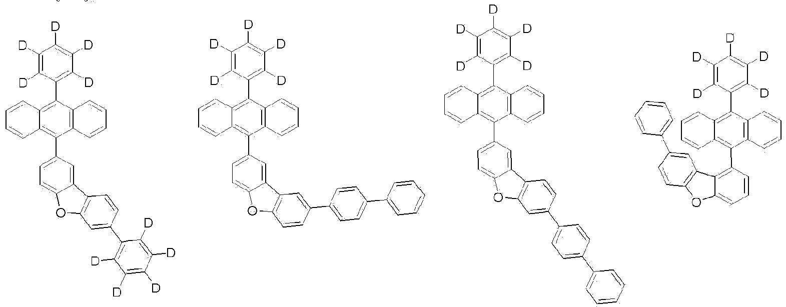

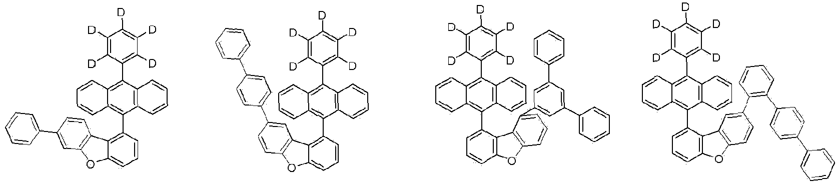

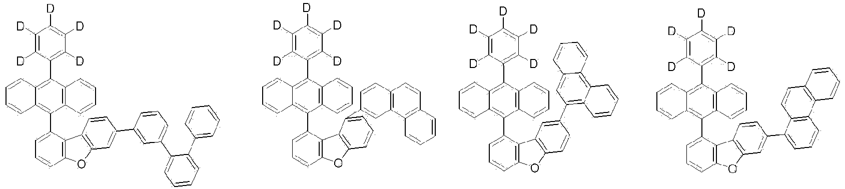

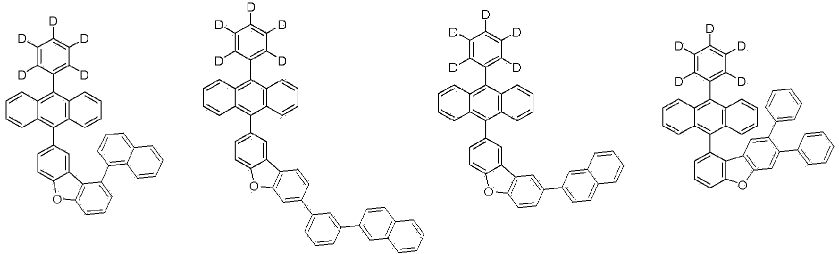

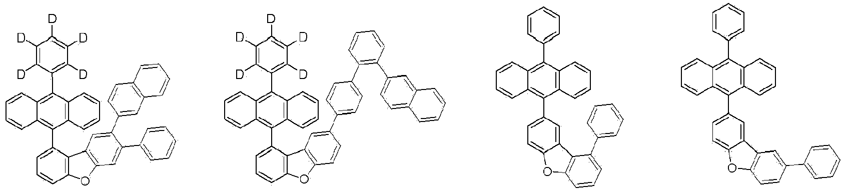

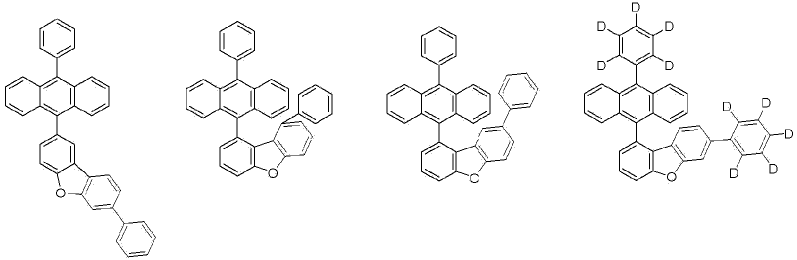

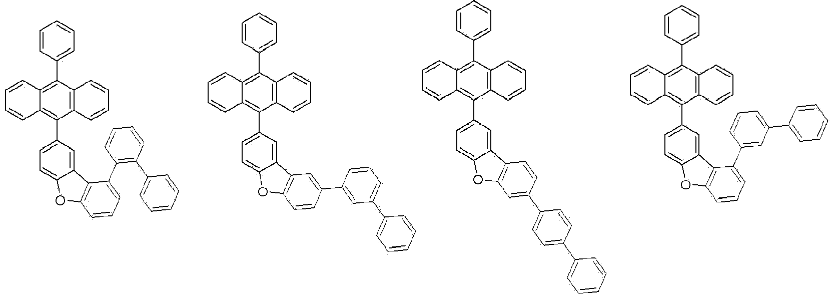

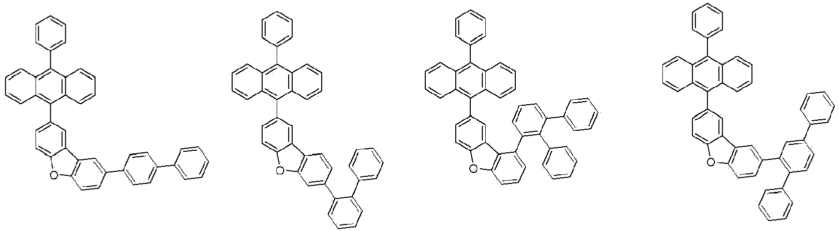

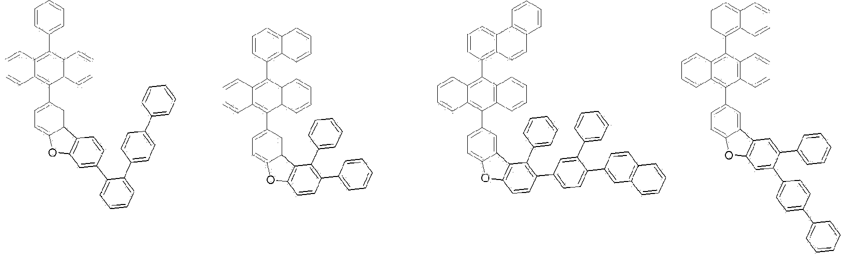

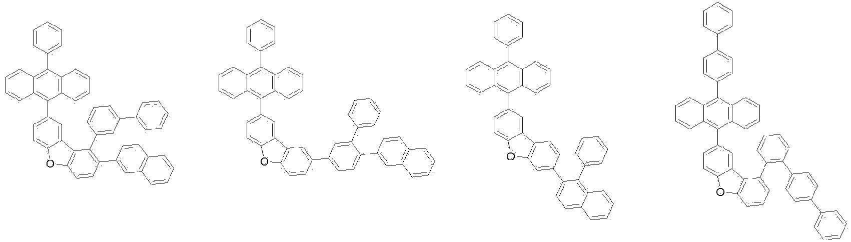

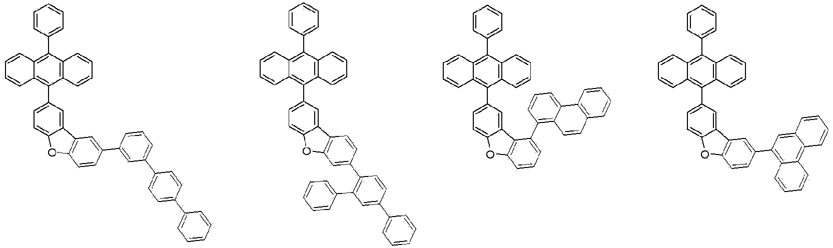

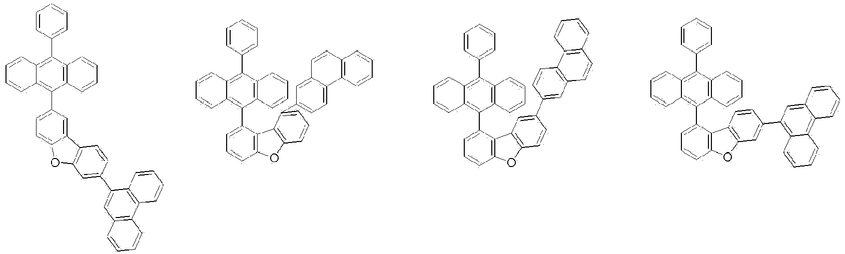

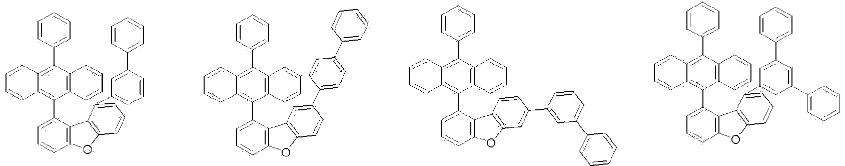

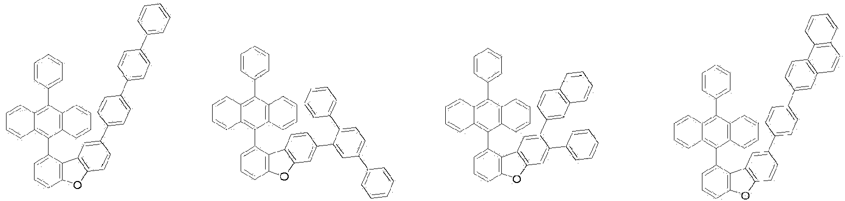

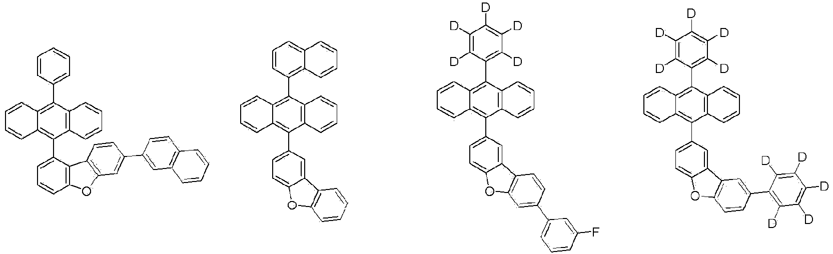

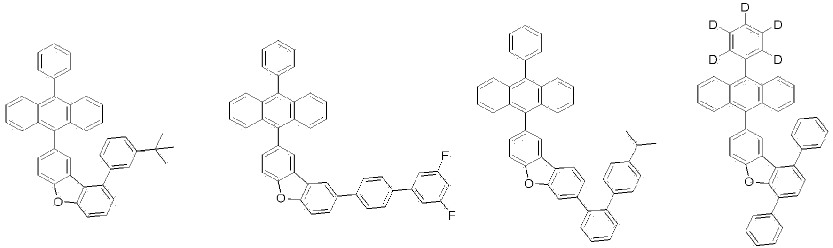

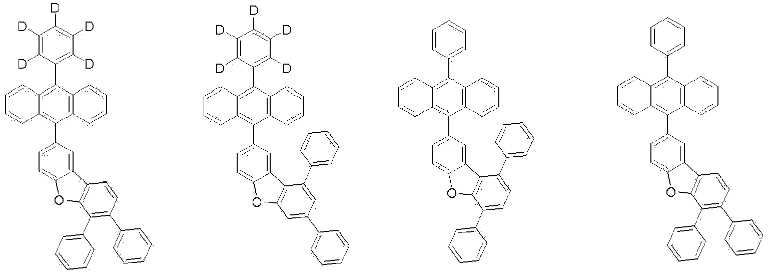

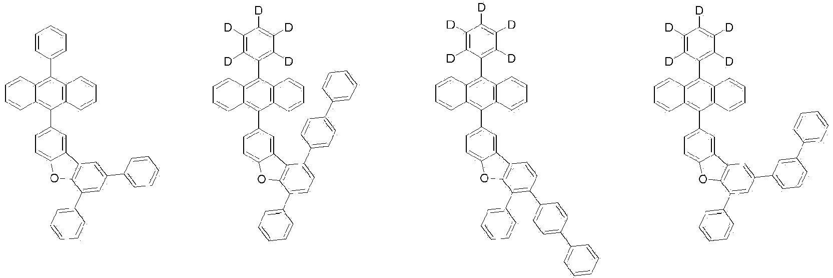

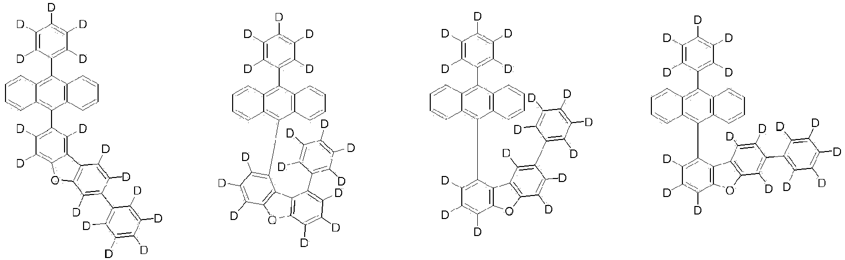

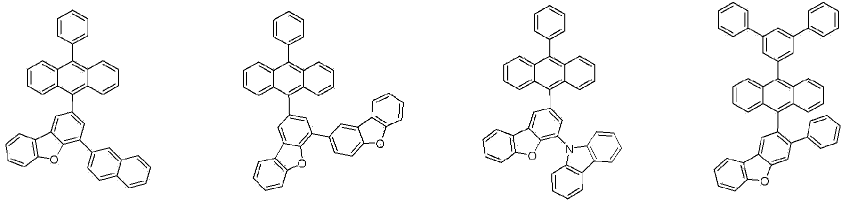

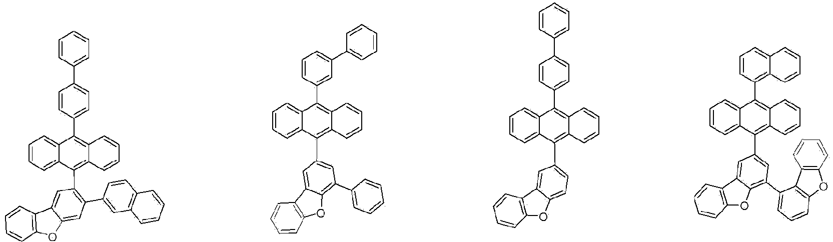

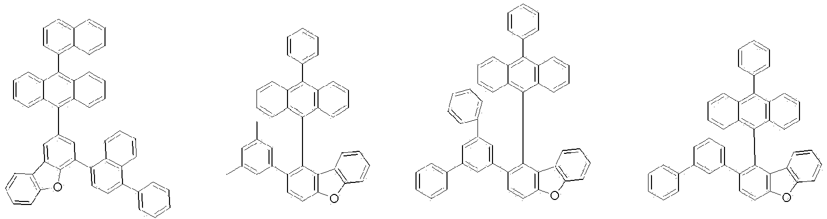

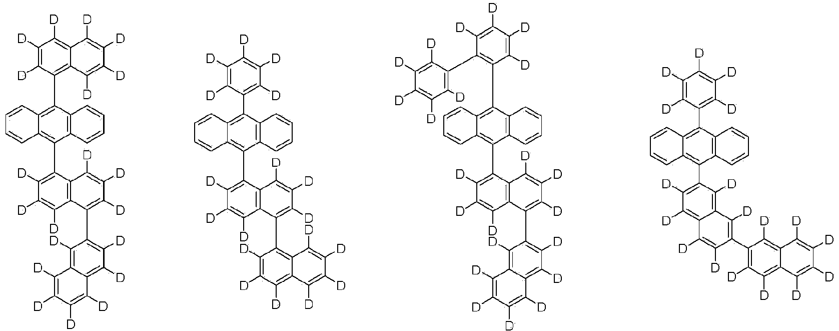

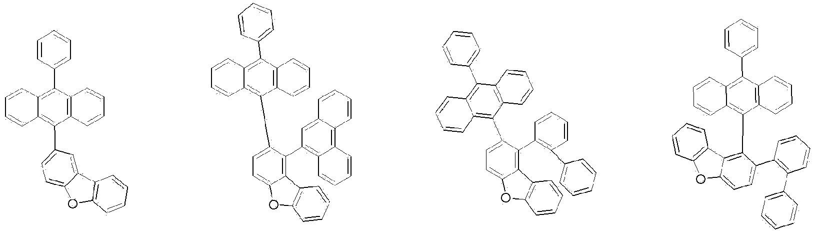

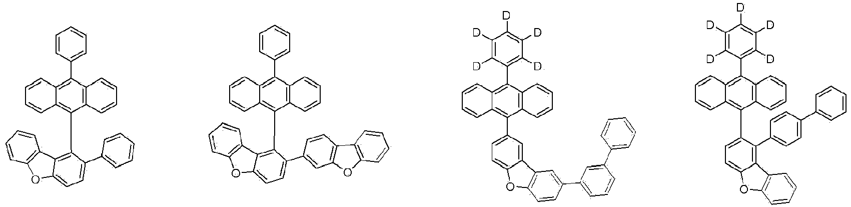

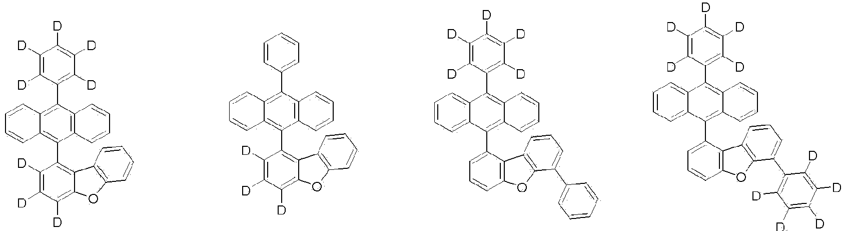

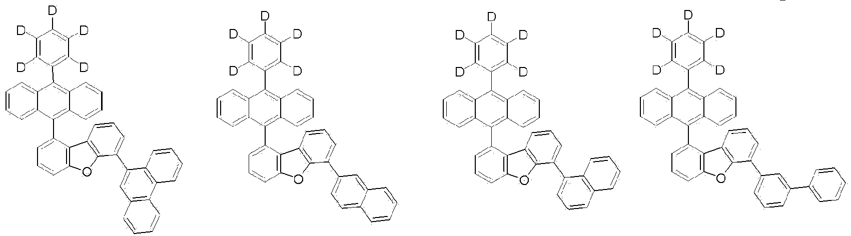

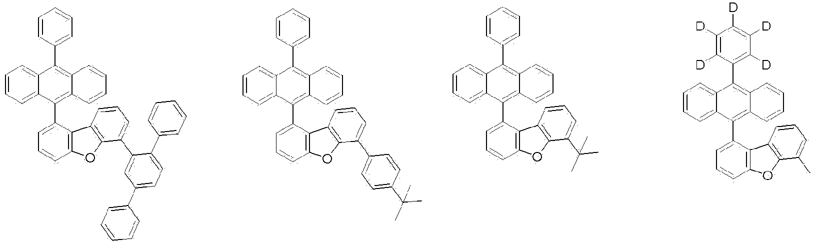

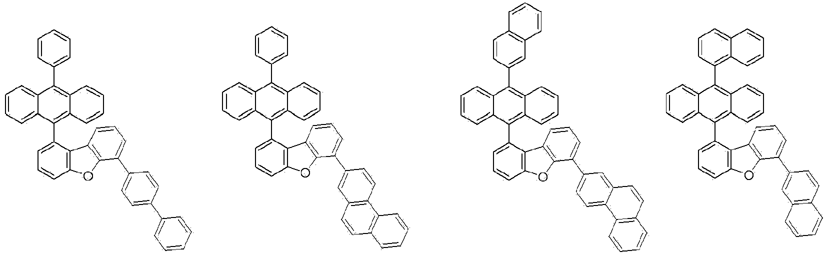

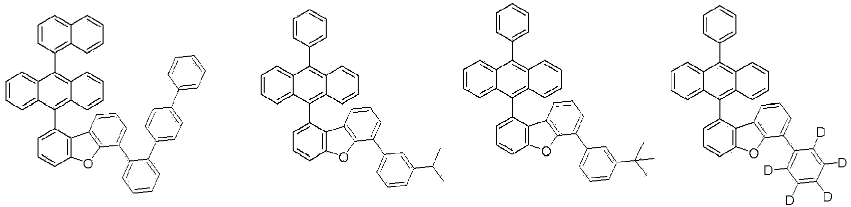

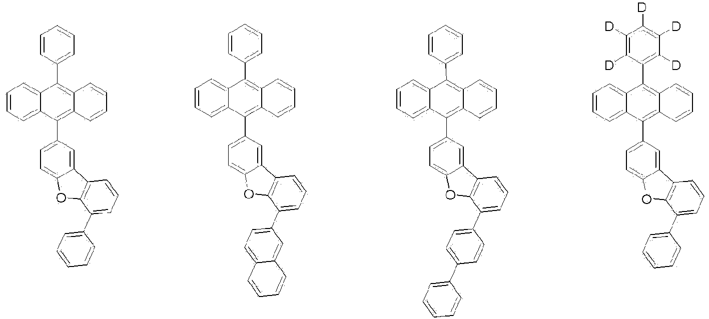

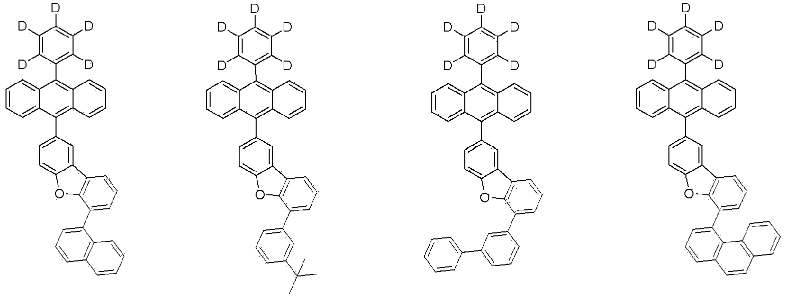

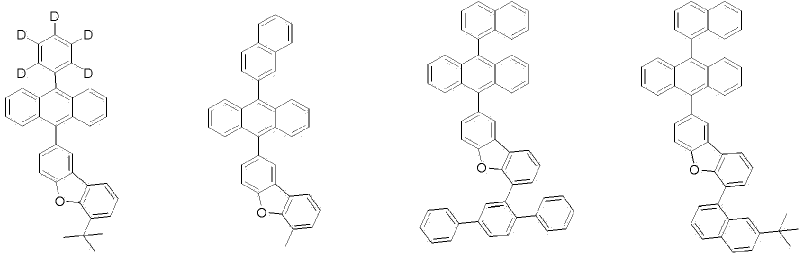

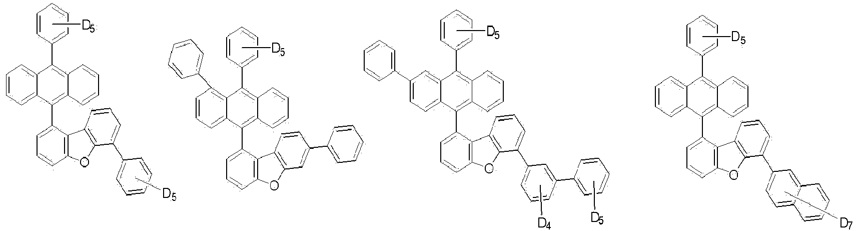

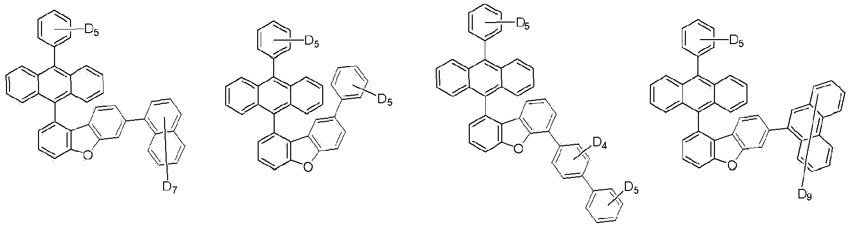

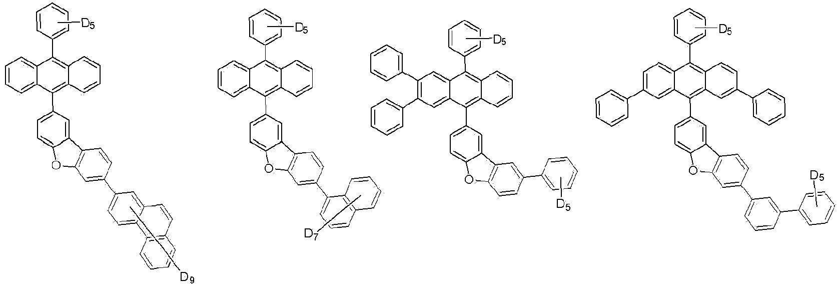

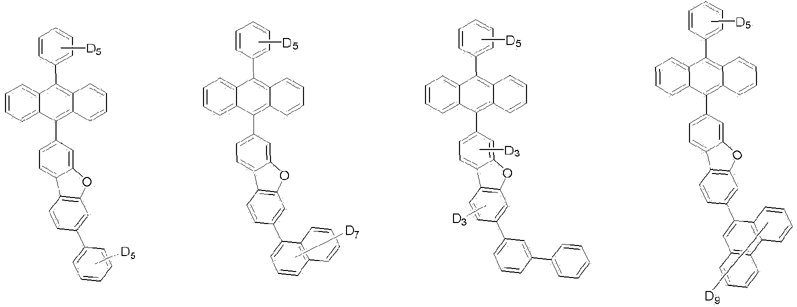

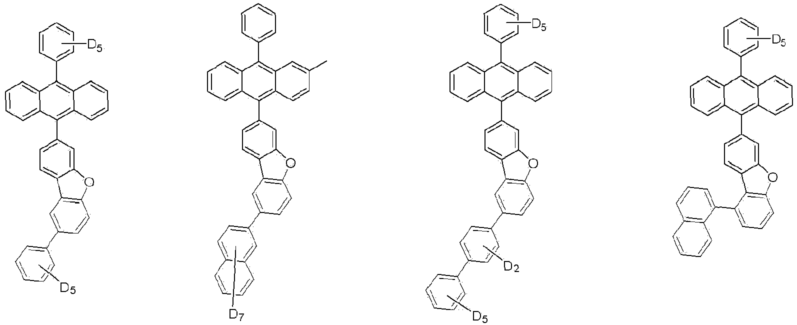

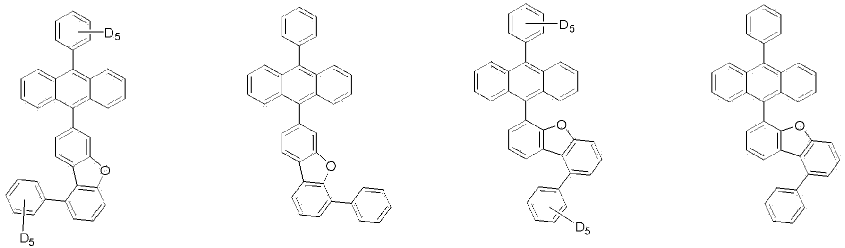

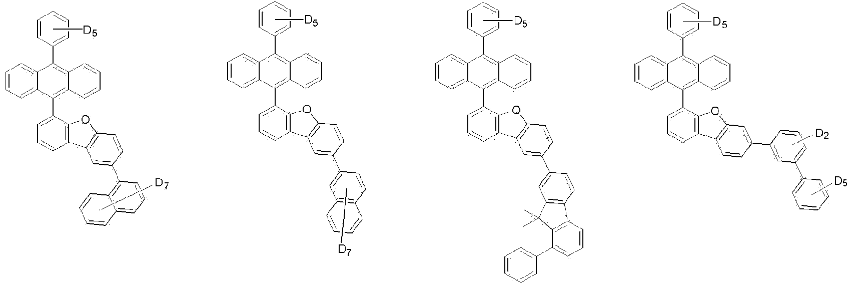

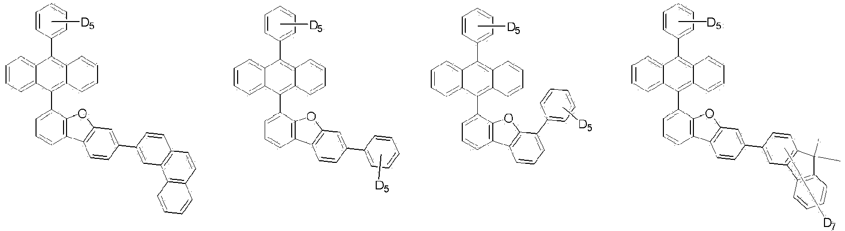

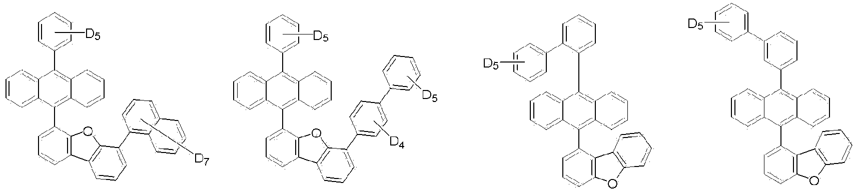

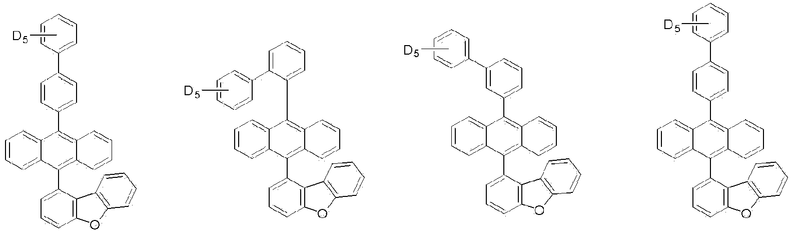

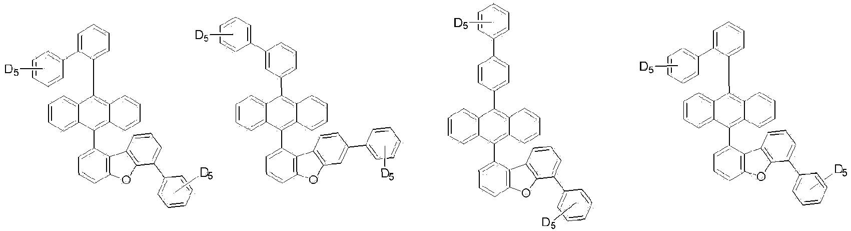

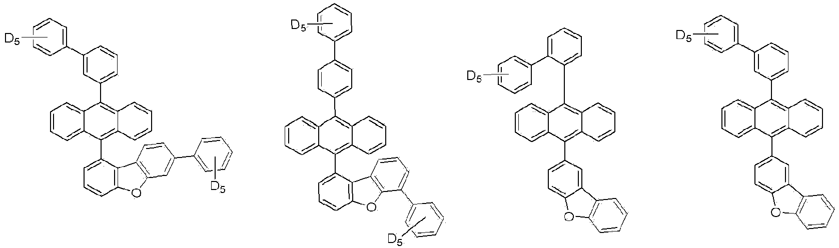

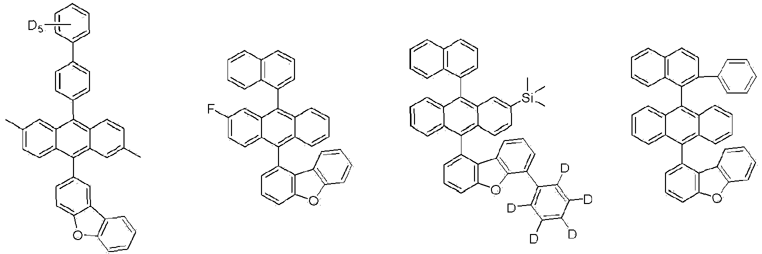

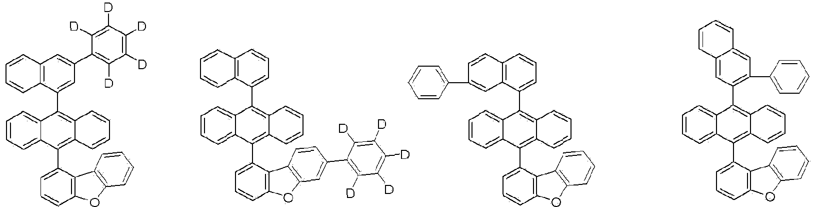

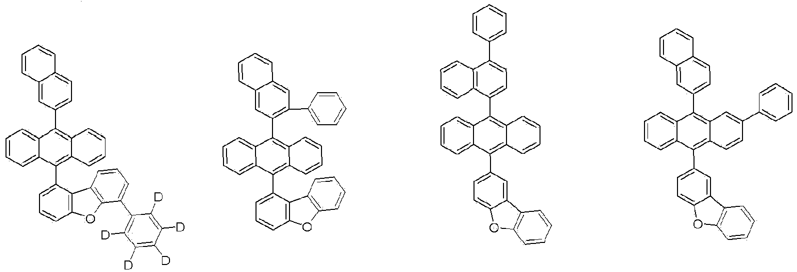

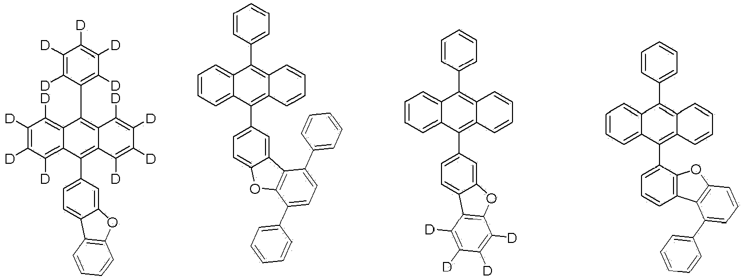

However, these compounds are not intended to limit the scope of Formula 3.

The organic layers of the organic light emitting device according to the present invention may form a monolayer structure. Alternatively, the organic layers may be stacked together to form a multilayer structure. For example, the organic layers may have a structure including a hole injecting layer, a hole transport layer, a hole blocking layer, a light emitting layer, an electron blocking layer, an electron transport layer, and an electron injecting layer but are not limited to this structure. The number of the organic layers is not limited and may be increased or decreased. Preferred structures of the organic layers of the organic light emitting device according to the present invention will be explained in more detail in the Examples section that follows.

A more detailed description will be given concerning exemplary embodiments of the organic light emitting device according to the present invention.

First, an anode material is coated on a substrate to form an anode. The substrate may be any of those used in general organic light emitting devices. The substrate is preferably an organic substrate or a transparent plastic substrate that is excellent in transparency, surface smoothness, ease of handling, and waterproofness. A highly transparent and conductive metal oxide such as indium tin oxide (ITO), indium zinc oxide (IZO), tin oxide (SnO₂) or zinc oxide (ZnO) is used as the anode material.

A hole injecting material is coated on the anode by vacuum thermal evaporation or spin coating to form a hole injecting layer. Then, a hole transport material is coated on the hole injecting layer by vacuum thermal evaporation or spin coating to form a hole transport layer.

The hole injecting material is not specially limited so long as it is usually used in the art. Specific examples of such materials include 4,4',4"-tris(2-naphthylphenyl-phenylamino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis(4-(phenyl-m-tolylamino)phenyl)biphenyl-4,4'-diamine (DNTPD).

The hole transport material is not specially limited so long as it is commonly used in the art. Examples of such materials include N,N'-bis(3-methylphenyl)-N,N'-diphenyl-(1,1-biphenyl)-4,4'-diamine (TPD) and N,N'-di(naphthalen-1-yl)-N,N'-diphenylbenzidine (α-NPD).

Subsequently, a hole auxiliary layer and a light emitting layer are sequentially laminated on the hole transport layer. A hole blocking layer may be optionally formed on the light emitting layer by vacuum thermal evaporation or spin coating. The hole blocking layer is formed as a thin film and blocks holes from entering a cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it can transport electrons and has a higher ionization potential than the light emitting compound. Representative examples of suitable hole blocking materials include BAlq, BCP, and TPBI.

Examples of materials for the hole blocking layer include, but are not limited to, BAlq, BCP, Bphen, TPBI, TAZ, BeBq₂, OXD-7, and Liq.

An electron transport layer is deposited on the hole blocking layer by vacuum thermal evaporation or spin coating, and an electron injecting layer is formed thereon. A cathode metal is deposited on the electron injecting layer by vacuum thermal evaporation to form a cathode, completing the fabrication of the organic light emitting device.

For example, lithium (Li), magnesium (Mg), aluminum (Al), aluminum-lithium (Al-Li), calcium (Ca), magnesium-indium (Mg-In) or magnesium-silver (Mg-Ag) may be used as the metal for the formation of the cathode. The organic light emitting device may be of top emission type. In this case, a transmissive material such as ITO or IZO may be used to form the cathode.

A material for the electron transport layer functions to stably transport electrons injected from the cathode. The electron transport material may be any of those known in the art and examples thereof include, but are not limited to, quinoline derivatives, particularly tris(8-quinolinolato)aluminum (Alq3), TAZ, BAIq, beryllium bis(benzoquinolin-10-olate) (Bebq2), and oxadiazole derivatives such as PBD, BMD, and BND.

Each of the organic layers can be formed by a monomolecular deposition or solution process. According to the monomolecular deposition process, the material for each layer is evaporated into a thin film under heat and vacuum or reduced pressure. According to the solution process, the material for each layer is mixed with a suitable solvent and the mixture is then formed into a thin film by a suitable method such as ink-jet printing, roll-to-roll coating, screen printing, spray coating, dip coating or spin coating.

The organic light emitting device of the present invention can be used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

The present invention will be more specifically explained with reference to the following synthesis examples and fabrication examples. However, these examples are provided to assist in understanding the invention and are not intended to limit the scope of the present invention which is defined by the claims.

### Synthesis Example 1: Preparation of BD-1

### Synthesis Example 1-1: Synthesis of A-1

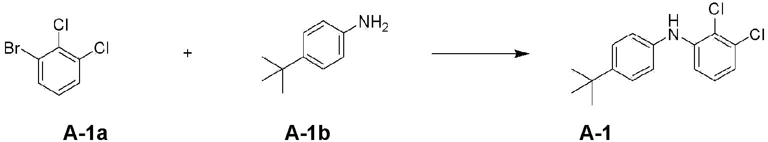

100 g of **A-1a,** 69.4 g of **A-1b,** 8.1 g of tris(dibenzylideneacetone)dipalladium(0), 85.1 g of sodium tert-butoxide, 5.5 g of bis(diphenylphosphino)-1,1'-binaphthyl, and 1200 mL of toluene were placed in a reactor. The mixture was stirred under reflux for 5 h. The reaction mixture was cooled to room temperature and ethyl acetate and water were added thereto. The organic layer was separated and purified by silica gel chromatography to afford **A-1** (104.6 g, 80.3%).

### Synthesis Example 1-2: Synthesis of A-2

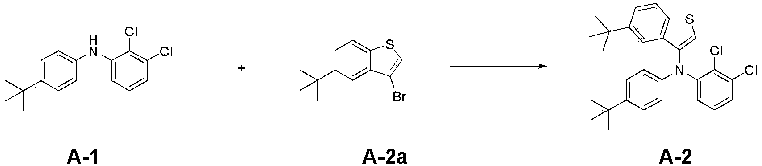

104.6 g of **A-1,** 95.7 g of **A-2a,** 3.6 g of bis(tri-tert-butylphosphine)palladium(0), 68.3 g of sodium tert-butoxide, and 1,050 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **A-2** (109.5 g, 63.8%).

### Synthesis Example 1-3: Synthesis of A-3

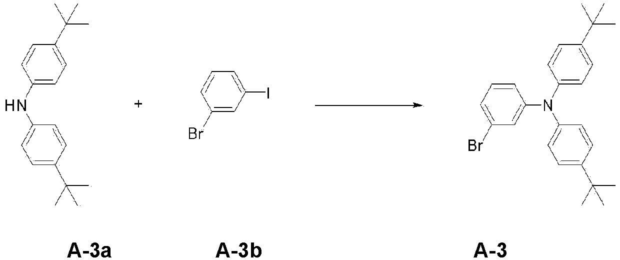

90 g of **A-3a**, 95 g of **A-3b**, 0.7 g of palladium(II) acetate, 1.9 g of Xantphos, 46.1 g of sodium tert-butoxide, and 900 mL of toluene were placed in a reactor. The mixture was stirred refluxed for 16 h. The reaction mixture was cooled to room temperature and ethyl acetate and water were added thereto. The organic layer was separated and purified by silica gel chromatography to afford **A-3** (82.8 g, 59.3%).

### Synthesis Example 1-4: Synthesis of A-4

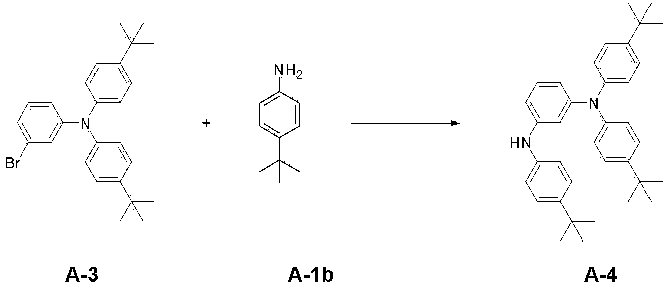

82.8 g of **A-3,** 29.7 g of **A-1b,** 3.5 g of tris(dibenzylideneacetone)dipalladium(0), 2.4 g of bis(diphenylphosphino)-1,1'-binaphthyl, 36.5 g of sodium tert-butoxide, and 830 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **A-4** (63.7g, 66.5%).

### Synthesis Example 1-5: Synthesis of A-5

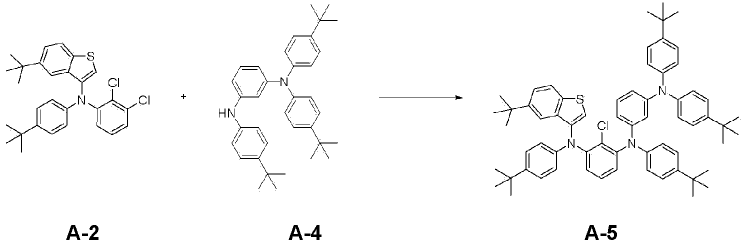

25 g of **A-2**, 26.2 g of **A-4**, 0.5 g of bis(tri-tert-butylphosphine)palladium(0), 9.7 g of sodium tert-butoxide, and 250 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **A-5** (33.2 g, 67.4%).

### Synthesis Example 1-6: Synthesis of BD-1

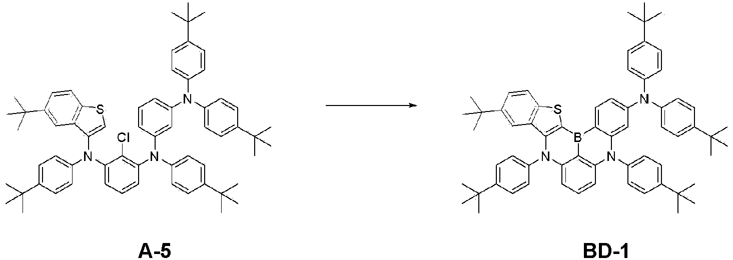

33.2 g of **A-5** and 400 mL of tert-butylbenzene were placed in a reactor and then 62 mL of a 2 M tert-butyllithium pentane solution was added dropwise thereto at -78 °C. The temperature was raised to 60 °C, followed by stirring for 2 h. Thereafter, nitrogen was blown into the mixture at 60 °C to completely remove pentane. After cooling to -78 °C, 7 mL of boron tribromide was added dropwise. The temperature was allowed to rise to room temperature, followed by stirring for 2 h. Then, the resulting mixture was cooled to 0 °C and 12 mL of N,N-diisopropylethylamine was added dropwise thereto. The temperature was raised to 120 °C, followed by stirring for 16 h. The reaction mixture was cooled to room temperature and a 10% aqueous sodium acetate solution and ethyl acetate were added thereto. The organic layer was separated and concentrated under reduced pressure. Purification by silica gel chromatography afforded **BD-1** (3.1 g, 9.6%).
MS (MALDI-TOF): m/z 923.54 [M⁺]

### Synthesis Example 2: Preparation of BD-2

### Synthesis Example 2-1: Synthesis of B-1

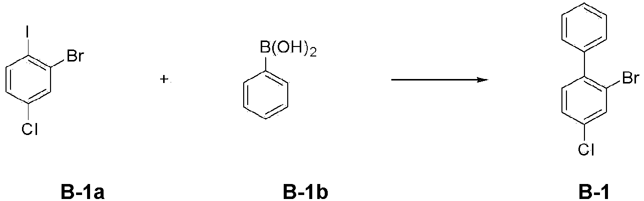

100 g of **B-1a,** 38.4 g of **B-1b,** 10.9 g of tetrakispalladium(0), 87.1 g of potassium carbonate, 500 mL of toluene, 300 mL of ethanol, and 200 mL of water were placed in a reactor. The mixture was stirred under reflux for 8 h. The reaction mixture was cooled to room temperature and ethyl acetate and water were added thereto. The organic layer was separated and purified by silica gel chromatography to afford **B-1** (62.7 g, 74.4%).

### Synthesis Example 2-2: Synthesis of B-2

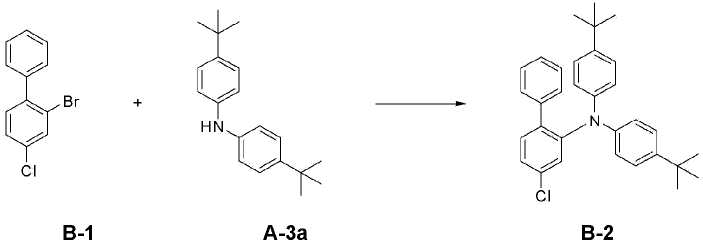

62.7 g of **B-1,** 66 g of **A-3a,** 2.4 g of bis(tri-tert-butylphosphine)palladium(0), 45.1 g of sodium tert-butoxide, and 630 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **B-2** (71.1 g, 64.8%).

### Synthesis Example 2-3: Synthesis of B-3

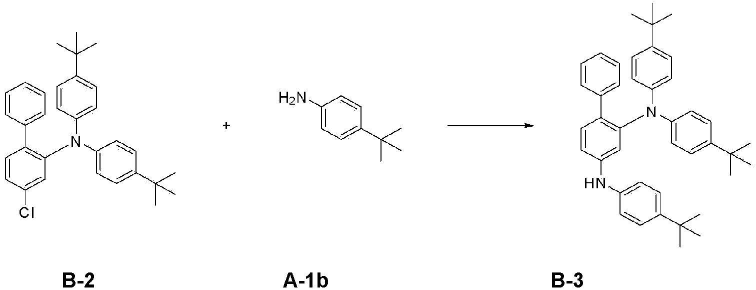

71.1 g of **B-2,** 22.7 g of **A-1b,** 2.8 g of tris(dibenzylideneacetone)dipalladium(0), 29.2 g of sodium tert-butoxide, 1.2 g of tri-tert-butylphosphine, and 860 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **B-3** (61.4 g, 69.6%).

### Synthesis Example 2-4: Synthesis of B-4

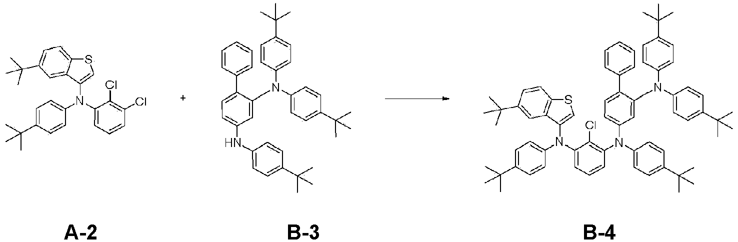

23 g of **A-2,** 27.7 g of **B-3,** 0.5 g of bis(tri-tert-butylphosphine)palladium(0), 9.2 g of sodium tert-butoxide, and 230 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **B-4** (34.3 g, 70.1%).

### Synthesis Example 2-5: Synthesis of BD-2

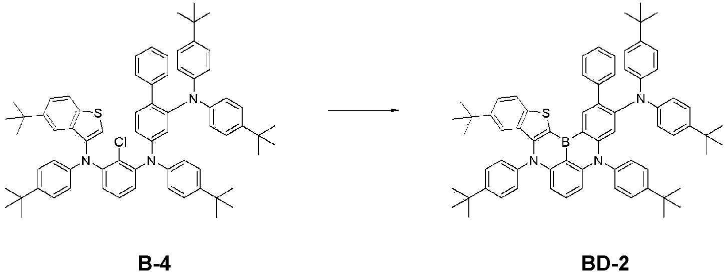

34.3 g of **B-4** and 410 mL of tert-butylbenzene were placed in a reactor and then 59 mL of a 2 M tert-butyllithium pentane solution was added dropwise thereto at -78 °C. The temperature was raised to 60 °C, followed by stirring for 2 h. Thereafter, nitrogen was blown into the mixture at 60 °C to completely remove pentane. After cooling to -78 °C, 7 mL of boron tribromide was added dropwise. The temperature was allowed to rise to room temperature, followed by stirring for 2 h. Then, the resulting mixture was cooled to 0 °C and 12 mL of N,N-diisopropylethylamine was added dropwise thereto. The temperature was raised to 120 °C, followed by stirring for 16 h. The reaction mixture was cooled to room temperature and a 10% aqueous sodium acetate solution and ethyl acetate were added thereto. The organic layer was separated and concentrated under reduced pressure. Purification by silica gel chromatography afforded **BD-2** (3.4 g, 10.2%).
MS (MALDI-TOF): m/z 999.57 [M⁺]

### Synthesis Example 3: Preparation of BD-3

### Synthesis Example 3-1: Synthesis of C-1

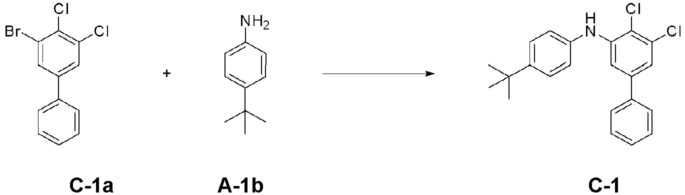

70 g of **C-1a,** 34.6 g of **A-1b,** 4.3 g of tris(dibenzylideneacetone)dipalladium(0), 33.4 g of sodium tert-butoxide, 2.9 g of bis(diphenylphosphino)-1,1'-binaphthyl, and 840 mL of toluene were placed in a reactor. The mixture was stirred under reflux for 5 h. The reaction mixture was cooled to room temperature and ethyl acetate and water were added thereto. The organic layer was separated and purified by silica gel chromatography to afford **C-1** (63.2 g, 73.6%).

### Synthesis Example 3-2: Synthesis of C-2

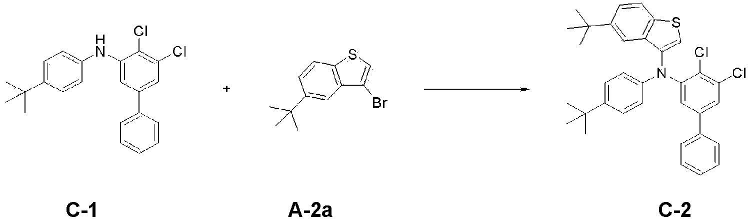

63.2 g of **C-1,** 45.9 g of **A-2a,** 3.1 g of bis(tri-tert-butylphosphine)palladium(0), 32.8 g of sodium tert-butoxide, and 640 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **C-2** (68.4 g, 71.8%).

### Synthesis Example 3-3: Synthesis of C-3

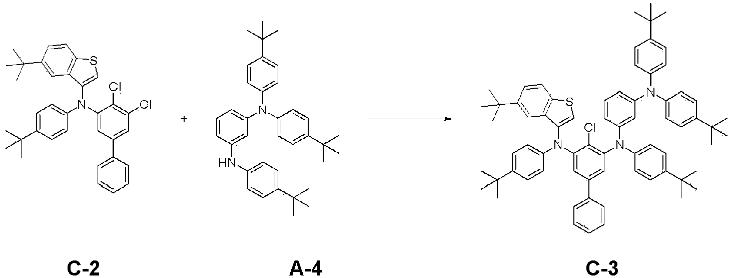

25 g of **C-2,** 22.6 g of **A-4,** 0.5 g of bis(tri-tert-butylphosphine)palladium(0), 8.6 g of sodium tert-butoxide, and 250 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **C-3** (32.9 g, 71.6%).

### Synthesis Example 3-4: Synthesis of BD-3

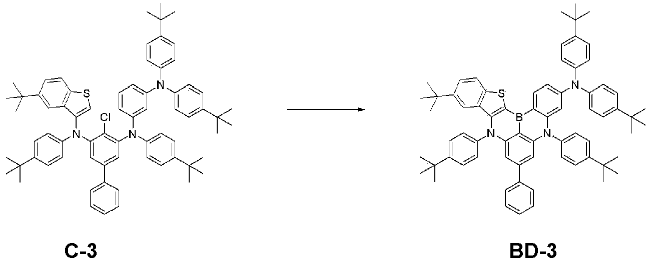

32.9 g of **C-3** and 400 mL of tert-butylbenzene were placed in a reactor and then 57 mL of a 2 M tert-butyllithium pentane solution was added dropwise thereto at -78 °C. The temperature was raised to 60 °C, followed by stirring for 2 h. Thereafter, nitrogen was blown into the mixture at 60 °C to completely remove pentane. After cooling to -78 °C, 6 mL of boron tribromide was added dropwise. The temperature was allowed to rise to room temperature, followed by stirring for 2 h. Then, the resulting mixture was cooled to 0 °C and 11 mL of N,N-diisopropylethylamine was added dropwise thereto. The temperature was raised to 120 °C, followed by stirring for 16 h. The reaction mixture was cooled to room temperature and a 10% aqueous sodium acetate solution and ethyl acetate were added thereto. The organic layer was separated and concentrated under reduced pressure. Purification by silica gel chromatography afforded **BD-3** (3.3 g, 10.1%).
MS (MALDI-TOF): m/z 999.57 [M⁺]

### Synthesis Example 4: Preparation of 1

### Synthesis Example 4-1: Synthesis of D-1

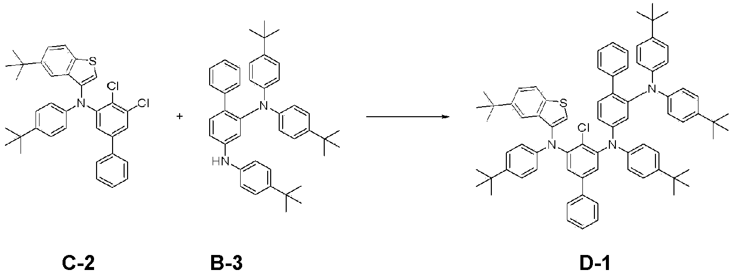

25 g of **C-2,** 26 g of **B-3,** 0.5 g of bis(tri-tert-butylphosphine)palladium(0), 8.6 g of sodium tert-butoxide, and 250 mL of toluene were placed in a reactor. The mixture was stirred under reflux for 16 h. The reaction mixture was cooled to room temperature and ethyl acetate and water were added thereto. The organic layer was separated and purified by silica gel chromatography to afford **D-1** (35.6 g, 72.1%).

### Synthesis Example 4-2: Synthesis of 1

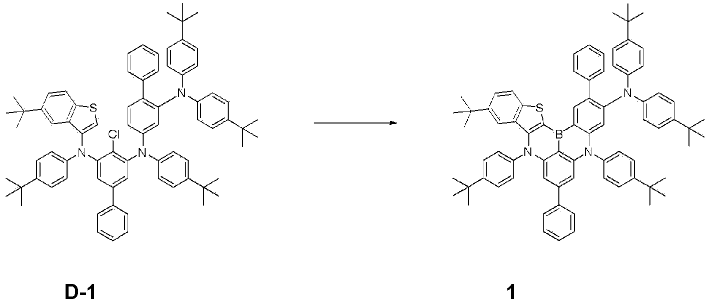

35.6 g of **D-1** and 430 mL of tert-butylbenzene were placed in a reactor and then 57 mL of a 2 M tert-butyllithium pentane solution was added dropwise thereto at -78°C. The temperature was raised to 60 °C, followed by stirring for 2 h. Thereafter, nitrogen was blown into the mixture at 60 °C to completely remove pentane. After cooling to -78 °C, 6 mL of boron tribromide was added dropwise. The temperature was allowed to rise to room temperature, followed by stirring for 2 h. Then, the resulting mixture was cooled to 0 °C and 11 mL of N,N-diisopropylethylamine was added dropwise thereto. The temperature was raised to 120 °C, followed by stirring for 16 h. The reaction mixture was cooled to room temperature and a 10% aqueous sodium acetate solution and ethyl acetate were added thereto. The organic layer was separated and concentrated under reduced pressure. Purification by silica gel chromatography afforded 1 (3.92 g, 11.3%).
MS (MALDI-TOF): m/z 1075.60 [M⁺]

### Synthesis Example 5: Preparation of 2

### Synthesis Example 5-1: Synthesis of E-1

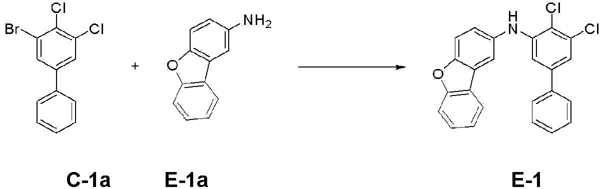

**E-1** (yield 63.6%) was synthesized in the same manner as in Synthesis Example 3-1, except that **E-1a** was used instead of **A-1b.**

### Synthesis Example 5-2: Synthesis of E-2

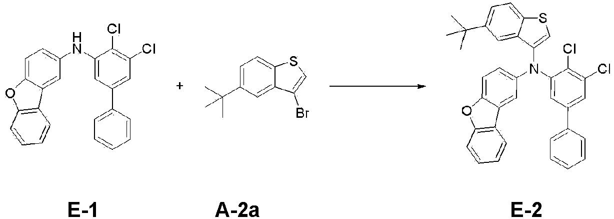

**E-2** (yield 63%) was synthesized in the same manner as in Synthesis Example 1-2, except that **E-1** was used instead of **A-1.**

### Synthesis Example 5-3: Synthesis of E-3

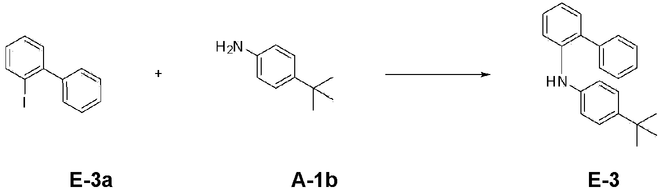

**E-3** (yield 77.9%) was synthesized in the same manner as in Synthesis Example 1-1, except that **E-3a** was used instead of **A-1a.**

### Synthesis Example 5-4: Synthesis of E-4

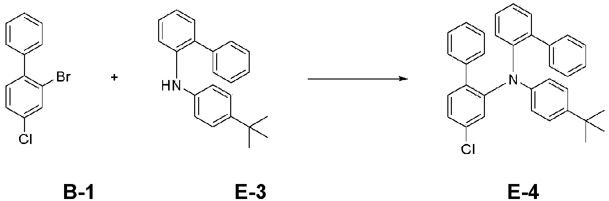

**E-4** (yield 64.8%) was synthesized in the same manner as in Synthesis Example 2-2, except that **E-3** was used instead of **A-3a.**

### Synthesis Example 5-5: Synthesis of E-5

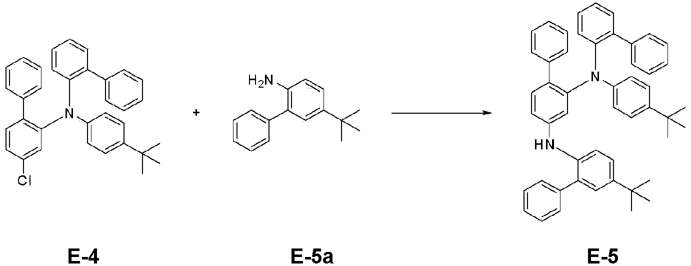

**E-5** (yield 59.1%) was synthesized in the same manner as in Synthesis Example 2-3, except that **E-4** and **E-5a** were used instead of **B-2** and **A-1b,** respectively.

### Synthesis Example 5-6: Synthesis of E-6

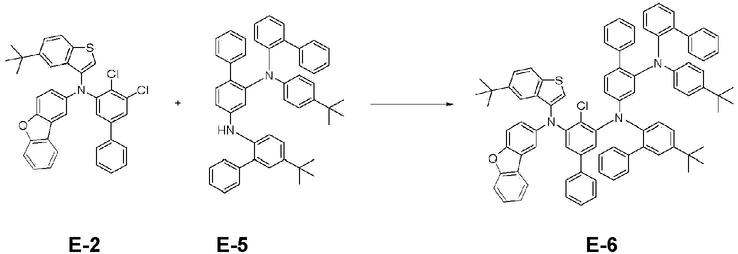

**E-6** (yield 70.7%) was synthesized in the same manner as in Synthesis Example 1-5, except that **E-2** and **E-5** were used instead of **A-2** and **A-4,** respectively.

### Synthesis Example 5-7: Synthesis of 2

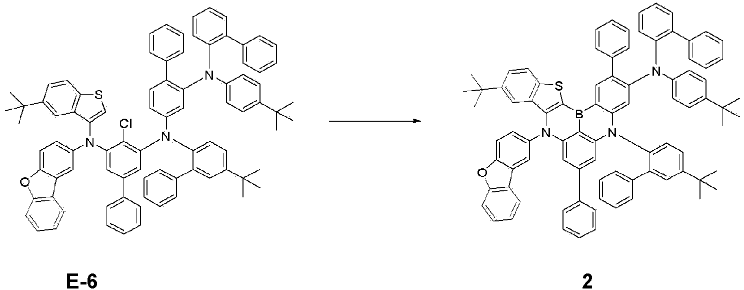

2 (yield 5.1%) was synthesized in the same manner as in Synthesis Example 1-6, except that **E-6** was used instead of **A-5.**
MS (MALDI-TOF): m/z 1205.55 [M⁺]

### Synthesis Example 6: Preparation of 3

### Synthesis Example 6-1: Synthesis of F-1

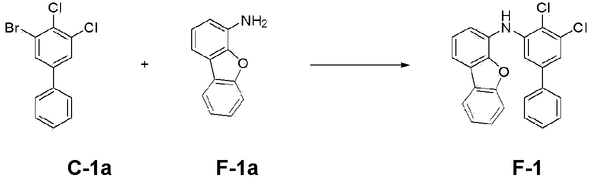

**F-1** (yield 85.9%) was synthesized in the same manner as in Synthesis Example 3-1, except that **F-1a** was used instead of **A-1b.**

### Synthesis Example 6-2: Synthesis of F-2

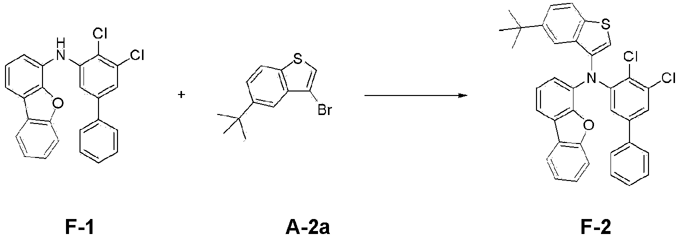

**F-2** (yield 59.7%) was synthesized in the same manner as in Synthesis Example 1-2, except that **F-1** was used instead of **A-1.**

### Synthesis Example 6-3: Synthesis of F-3

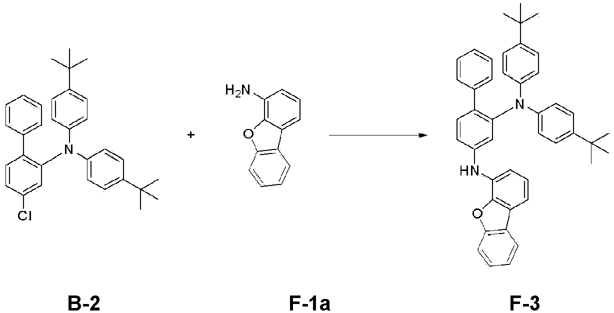

**F-3** (yield 70%) was synthesized in the same manner as in Synthesis Example 2-3, except that **F-1a** was used instead of **A-1b.**

### Synthesis Example 6-4: Synthesis of F-4

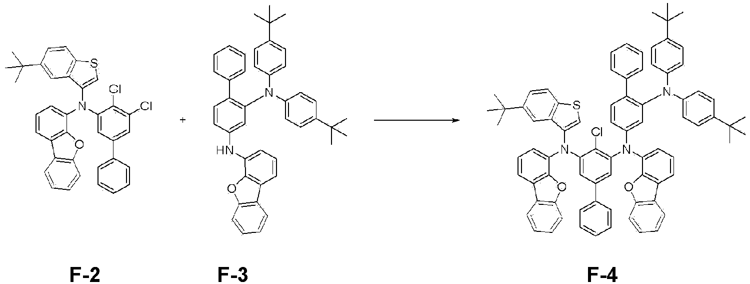

**F-4** (yield 68.9%) was synthesized in the same manner as in Synthesis Example 1-5, except that **F-2** and **F-3** were used instead of **A-2** and **A-4,** respectively.

### Synthesis Example 6-5: Synthesis of 3

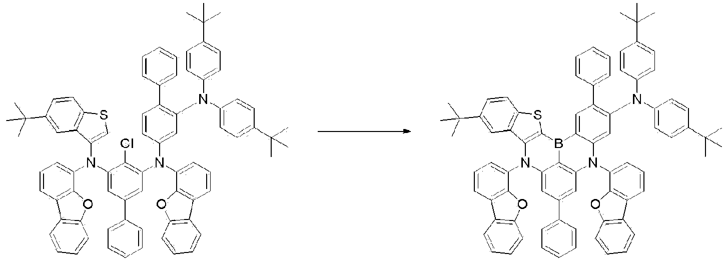

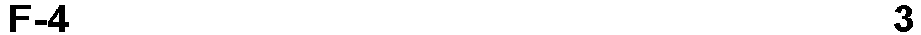

3 (yield 5.5%) was synthesized in the same manner as in Synthesis Example 1-6, except that **F-4** was used instead of A-5.
MS (MALDI-TOF): m/z 1143.50 [M⁺]

### Synthesis Example 7: Preparation of 7

### Synthesis Example 7-1: Synthesis of G-1

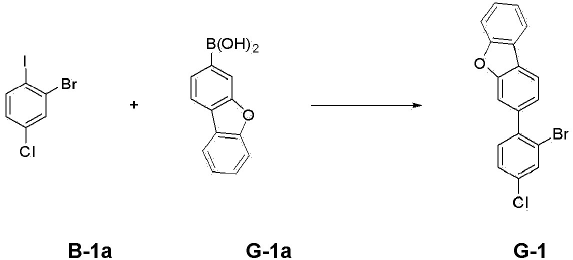

**G-1** (yield 70.9%) was synthesized in the same manner as in Synthesis Example 2-1, except that **G-1a** was used instead of **B-1b.**

### Synthesis Example 7-2: Synthesis of G-2

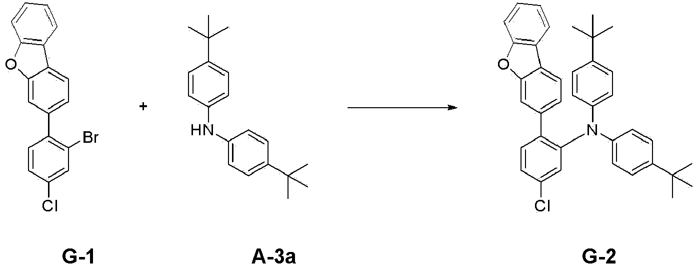

**G-2** (yield 56.1%) was synthesized in the same manner as in Synthesis Example 2-2, except that **G-1** was used instead of **B-1.**

### Synthesis Example 7-3: Synthesis of G-3

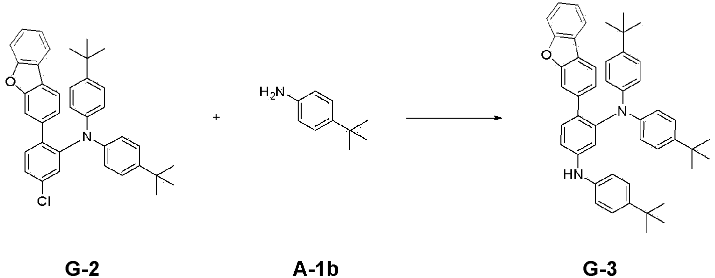

**G-3** (yield 57.7%) was synthesized in the same manner as in Synthesis Example 2-3, except that **G-2** was used instead of **B-2.**

### Synthesis Example 7-4: Synthesis of G-4

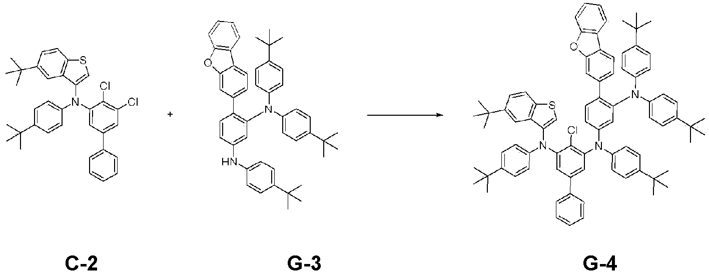

**G-4** (yield 58.3%) was synthesized in the same manner as in Synthesis Example 3-3, except that **G-3** was used instead of **A-4.**

### Synthesis Example 7-5: Synthesis of 7

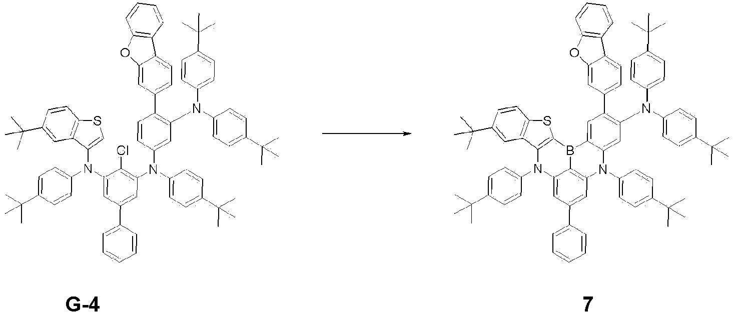

7 (yield 4.2%) was synthesized in the same manner as in Synthesis Example 1-6, except that G-4 was used instead of **A-5.**
MS (MALDI-TOF): m/z 1165.61 [M⁺]

### Synthesis Example 8: Preparation of 9

### Synthesis Example 8-1: Synthesis of H-1

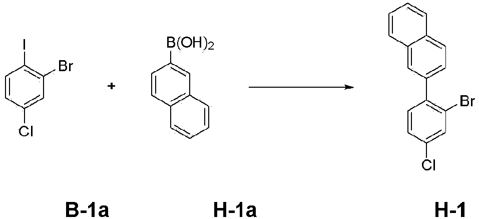

**H-1** (yield 64.1%) was synthesized in the same manner as in Synthesis Example 2-1, except that **H-1a** was used instead of **B-1b.**

### Synthesis Example 8-2: Synthesis of H-2

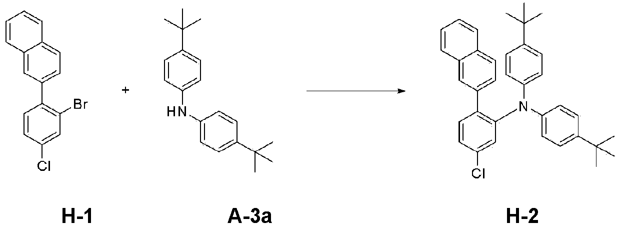

**H-2** (yield 59.5%) was synthesized in the same manner as in Synthesis Example 2-2, except that **H-1** was used instead of **B-1.**

### Synthesis Example 8-3: Synthesis of H-3

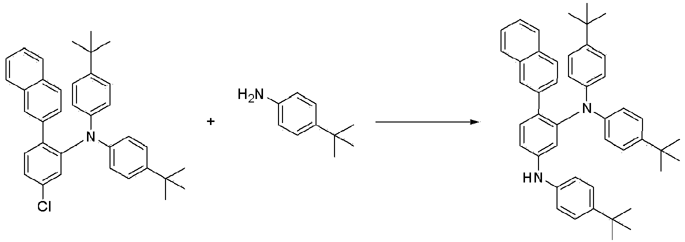

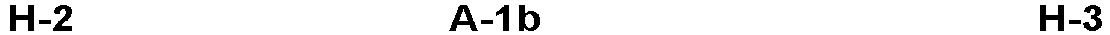

**H-3** (yield 55.1%) was synthesized in the same manner as in Synthesis Example 2-3, except that **H-2** was used instead of **B-2**.

### Synthesis Example 8-4: Synthesis of H-4

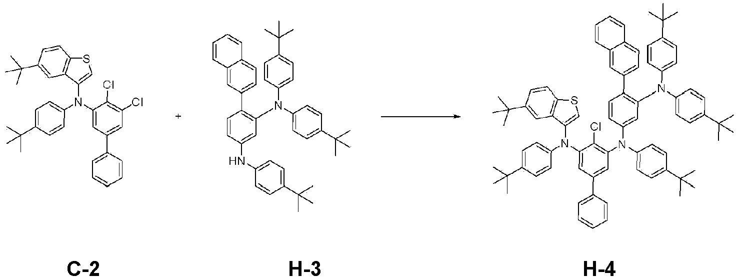

**H-4** (yield 59%) was synthesized in the same manner as in Synthesis Example 3-3, except that **H-3** was used instead of **A-4.**

### Synthesis Example 8-5: Synthesis of 9

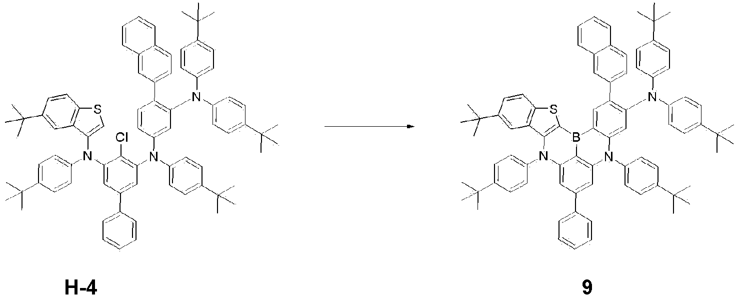

9 (yield 4.9%) was synthesized in the same manner as in Synthesis Example 1-6, except that **H-4** was used instead of **A-5.**
MS (MALDI-TOF): m/z 1125.62 [M⁺]

### Synthesis Example 9: Preparation of 18

### Synthesis Example 9-1: Synthesis of I-1

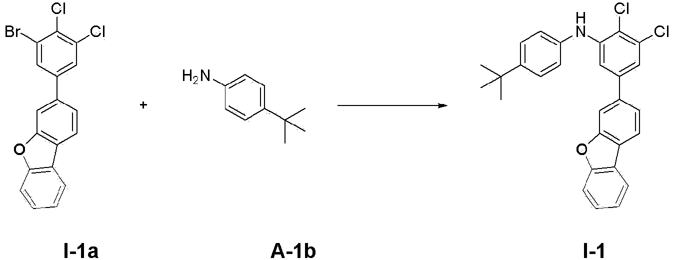

**I-1** (yield 59.6%) was synthesized in the same manner as in Synthesis Example 1-1, except that **I-1a** was used instead of **A-1a.**

### Synthesis Example 9-2: Synthesis of 1-2

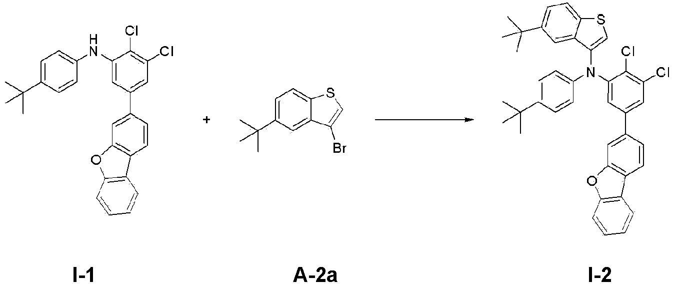

**I-2** (yield 68.4%) was synthesized in the same manner as in Synthesis Example 1-2, except that **I-1** was used instead of **A-1.**

### Synthesis Example 9-3: Synthesis of 1-3

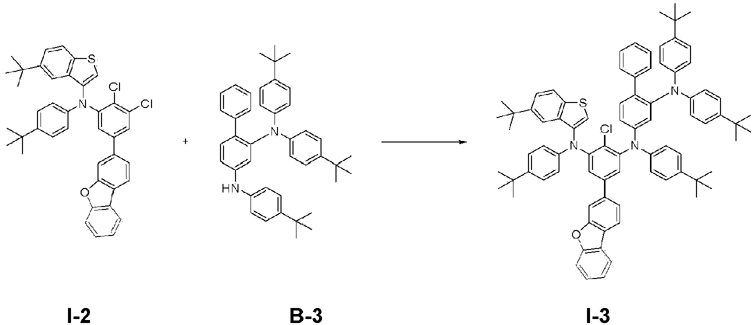

**I-3** (yield 64.8%) was synthesized in the same manner as in Synthesis Example 2-4, except that **I-2** was used instead of **A-2.**

### Synthesis Example 9-4: Synthesis of 18

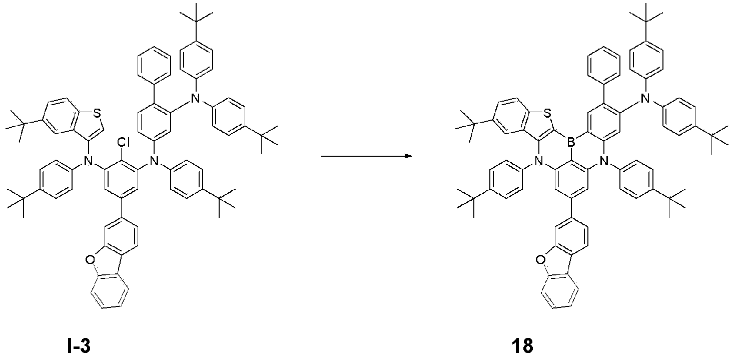

**18** (yield 5.7%) was synthesized in the same manner as in Synthesis Example 1-6, except that **I-3** was used instead of **A-5.**
MS (MALDI-TOF): m/z 1165.61 [M⁺]

### Synthesis Example 10: Preparation of 36

### Synthesis Example 10-1: Synthesis of J-1

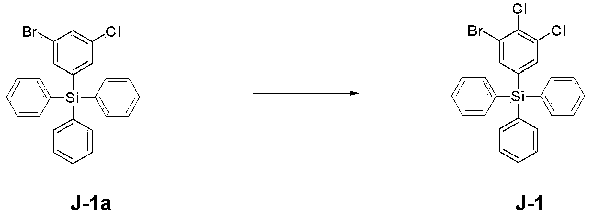

50 g of **J-1a** and 50 mL of tetrahydrofuran were placed in a reactor and then 140 mL of a 2 M lithium diisopropylamide solution was added dropwise thereto at -78 °C. After the mixture was stirred at -78 °C for 3 h, hexachloroethane was slowly added thereto. The temperature was raised to room temperature, followed by stirring for 16 h. To the reaction mixture were added ethyl acetate and water. The organic layer was separated and purified by silica gel chromatography to afford **J-1** (42.5 g, 78.9%).

### Synthesis Example 10-2: Synthesis of J-2

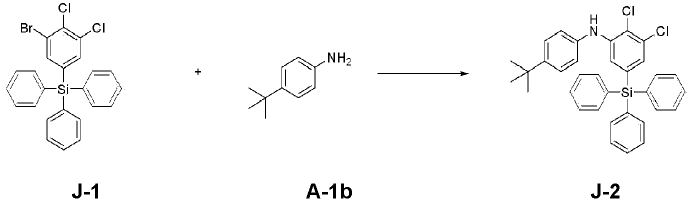

**J-2** (yield 58%) was synthesized in the same manner as in Synthesis Example 1-1, except that **J-1** was used instead of **A-1a.**

### Synthesis Example 10-3: Synthesis of J-3

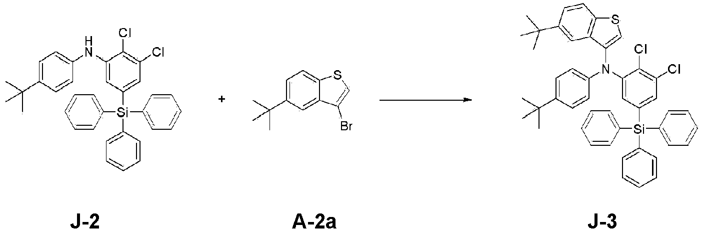

**J-3** (yield 96.2%) was synthesized in the same manner as in Synthesis Example 1-2, except that **J-2** was used instead of **A-1.**

### Synthesis Example 10-4: Synthesis of J-4

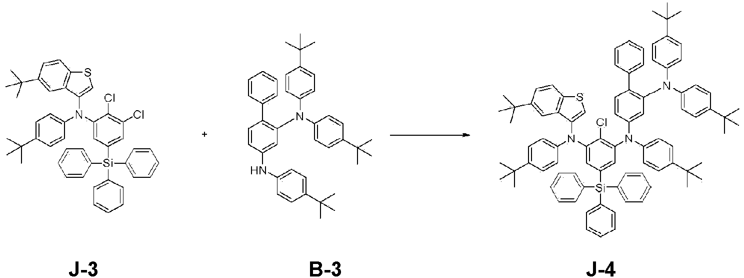

**J-4** (yield 62.7%) was synthesized in the same manner as in Synthesis Example 2-4, except that **J-3** was used instead of **A-2**.

### Synthesis Example 10-5: Synthesis of 36

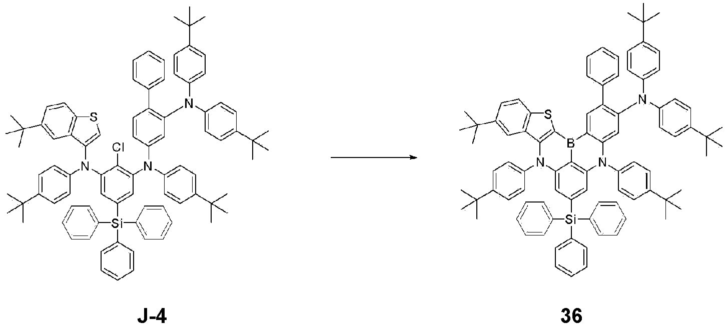

36 (yield 8.4%) was synthesized in the same manner as in Synthesis Example 1-6, except that **J-4** was used instead of **A-5**.
MS (MALDI-TOF): m/z 1257.66 [M⁺]

### Examples 1 to 7: Fabrication of organic light emitting devices

ITO glass was patterned to have a light emitting area of 2 mm × 2 mm, followed by cleaning. After the cleaned ITO glass was mounted in a vacuum chamber, the base pressure was adjusted to 133 x 10⁻⁷ Pa (1 × 10⁻⁷ torr). The compound represented by Acceptor-1 as an electron acceptor and the compound represented by Formula F were deposited in a ratio of 2:98 on the ITO to form a 100 Å thick hole injecting layer. The compound represented by Formula F was used to form a 550 Å thick hole transport layer. Subsequently, the compound represented by Formula G was used to form a 50 Å thick electron blocking layer. A mixture of the host represented by BH-1 and the inventive compound (2 wt%) shown in Table 1 was used to form a 200 Å thick light emitting layer. Thereafter, the compound represented by Formula H was used to form a 50 Å hole blocking layer on the light emitting layer. A mixture of the compound represented by Formula E-1 and the compound represented by Formula E-2 in a ratio of 1:1 was used to form a 250 Å thick electron transport layer on the hole blocking layer. The compound represented by Formula E-2 was used to form a 10 Å thick electron injecting layer on the electron transport layer. Al was used to form a 1000 Å thick Al electrode on the electron injecting layer, completing the fabrication of an organic light emitting device. The luminescent properties of the organic light emitting device were measured at 0.4 mA.

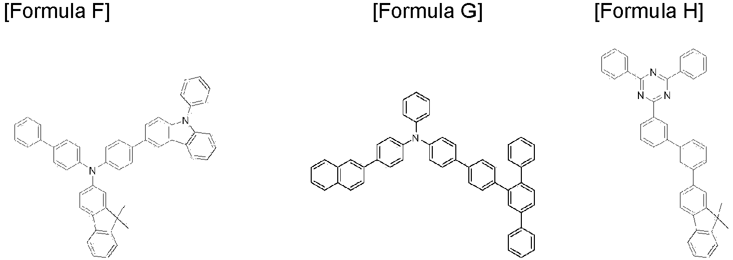

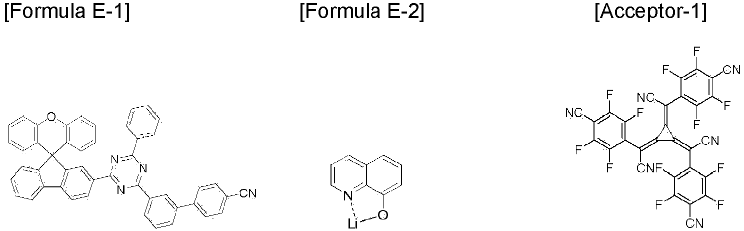

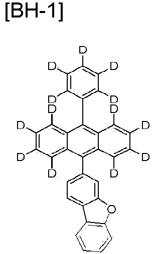

### Comparative Examples 1 to 8

Organic light emitting devices were fabricated in the same manner as in Examples 1-7, except that one of BD-1 to BD-8 was used instead of the inventive compound. The luminescent properties of the organic light emitting devices were measured at 0.4 mA. The structures of BD-1 to BD-8 are as follow:

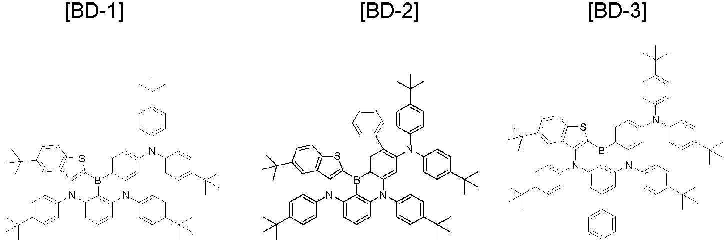

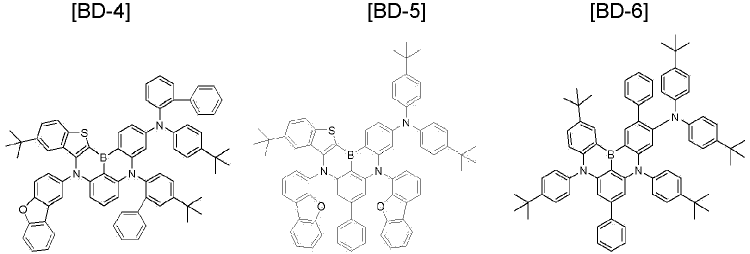

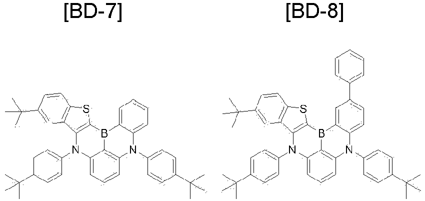

The organic light emitting devices of Examples 1-7 and Comparative Examples 1-8 were measured for external quantum efficiency and lifetime. The results are shown in Table 1.

**Table 1**

| Example No. | Dopant | Efficiency (EQE, %) | Lifetime (T97, hr) |
|---|---|---|---|
| Example 1 | **1** | 12.1 | 300 |
| Example 2 | **2** | 11.9 | 320 |
| Example 3 | **3** | 11.8 | 307 |
| Example 4 | **7** | 12.0 | 296 |
| Example 5 | **9** | 11.9 | 312 |
| Example 6 | **18** | 12.1 | 301 |
| Example 7 | **36** | 12.4 | 320 |
| Comparative Example 1 | **BD-1** | 9.5 | 244 |
| Comparative Example 2 | **BD-2** | 9.8 | 262 |
| Comparative Example 3 | **BD-3** | 10.4 | 268 |
| Comparative Example 4 | **BD-4** | 10.3 | 261 |
| Comparative Example 5 | **BD-5** | 10.5 | 265 |
| Comparative Example 6 | **BD-6** | 9.9 | 258 |
| Comparative Example 7 | **BD-7** | 8.4 | 185 |
| Comparative Example 8 | **BD-8** | 9.0 | 197 |

As can be seen from the results in Table 1, the organic light emitting devices of Examples 1-7, each of which employed the inventive dopant compound for the light emitting layer, had high quantum efficiencies and improved life characteristics compared to the organic light emitting devices of Comparative Examples 1-8, each of which employed the compound whose specific structure is contrasted with those of the inventive compounds. These results concluded that the use of the inventive compounds makes the organic light emitting devices highly efficient and long lasting.

## Claims

1. A polycyclic compound selected from the following compounds 1 to 57:

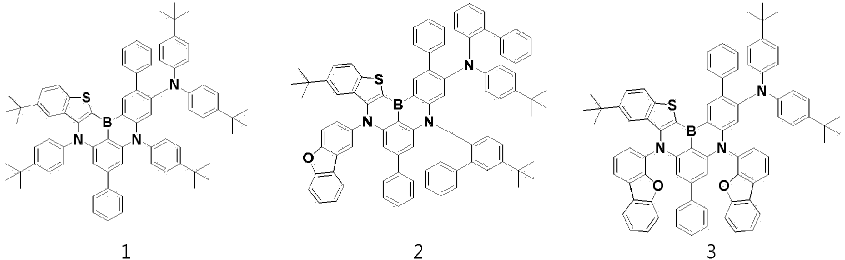

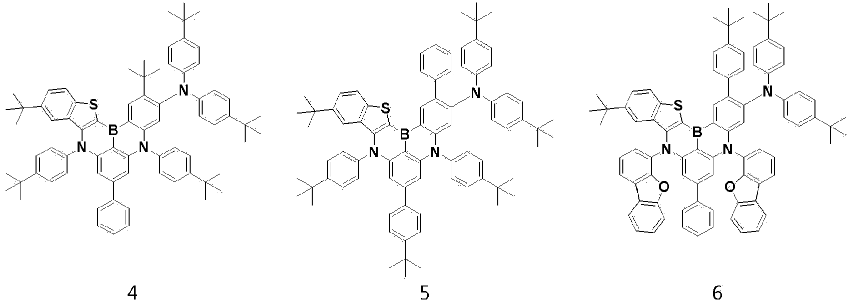

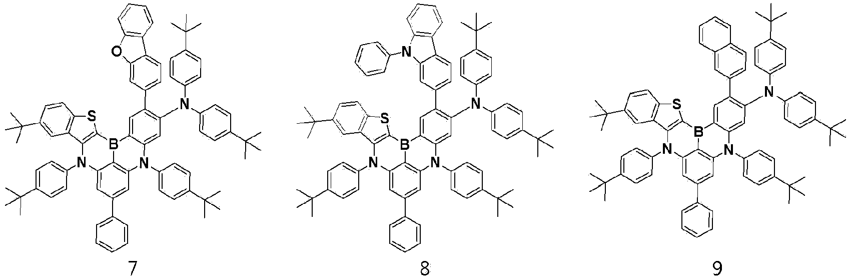

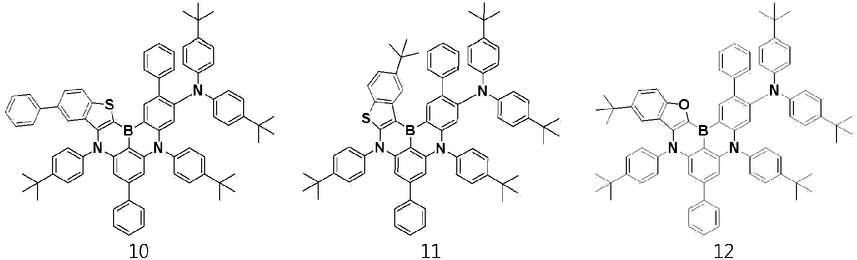

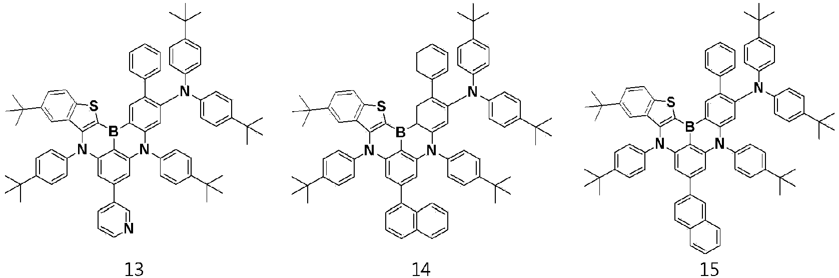

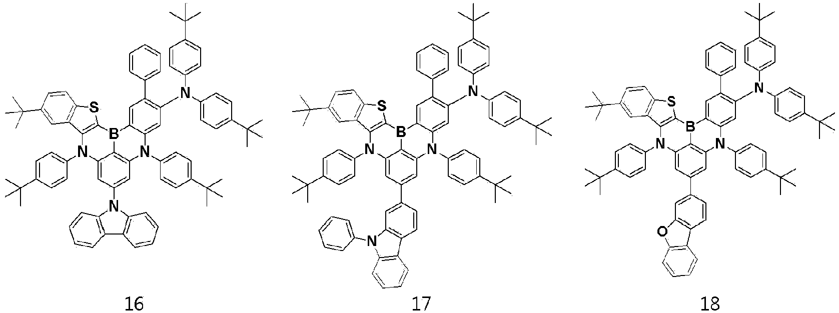

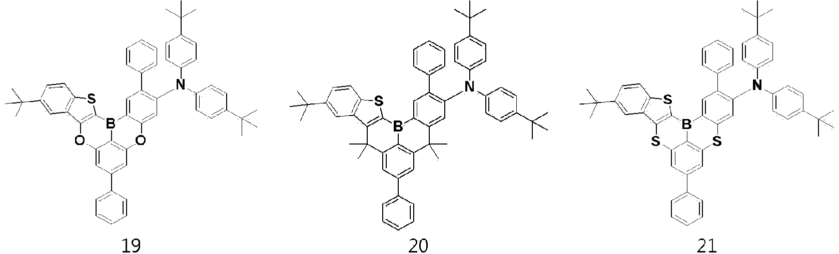

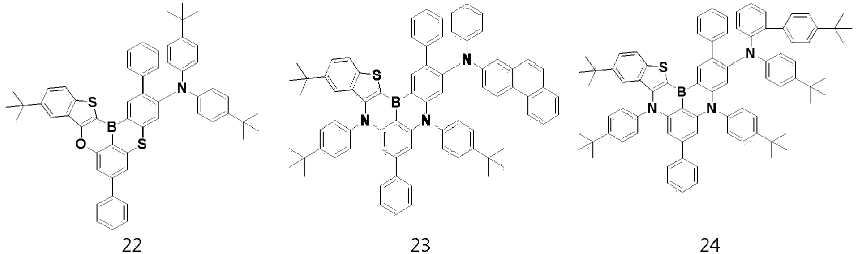

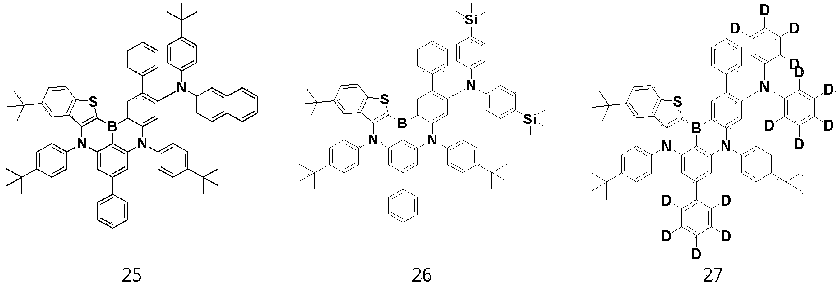

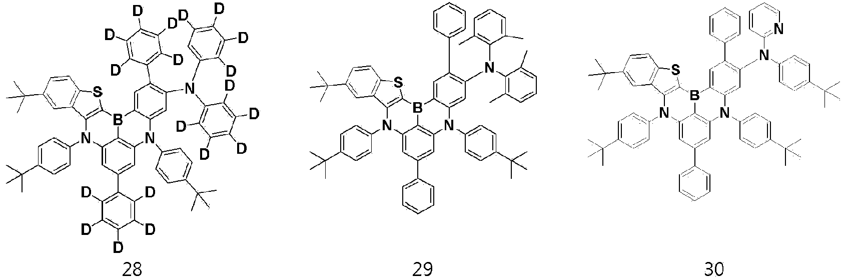

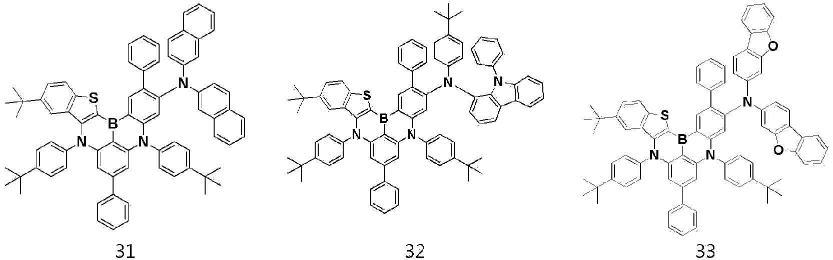

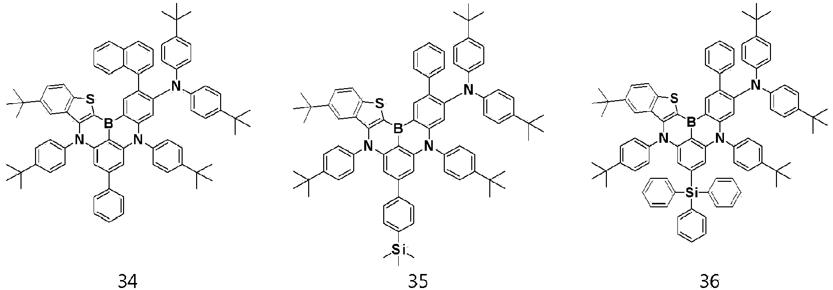

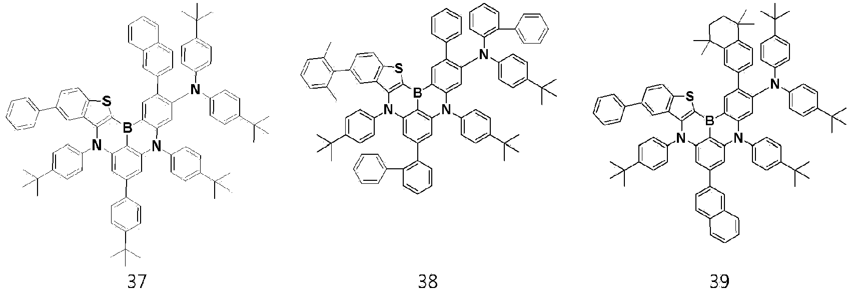

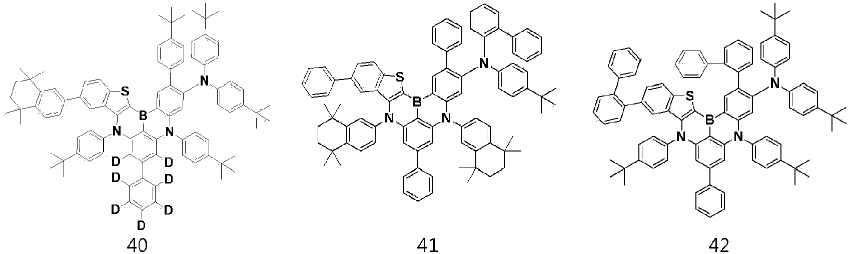

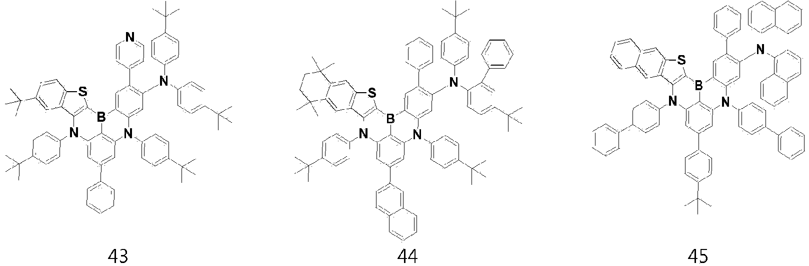

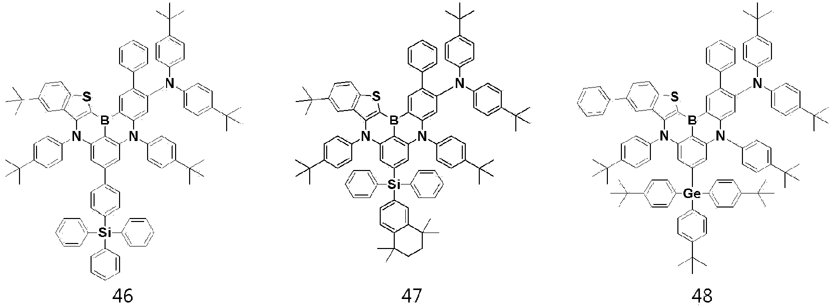

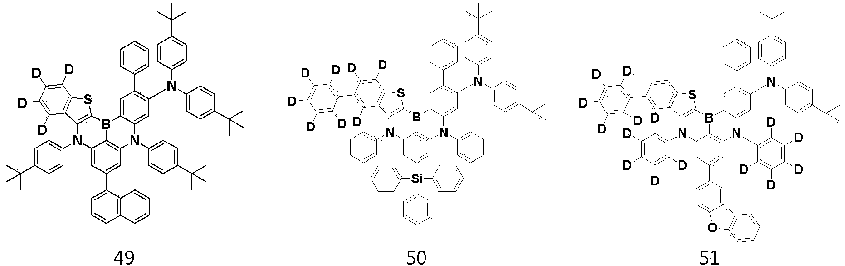

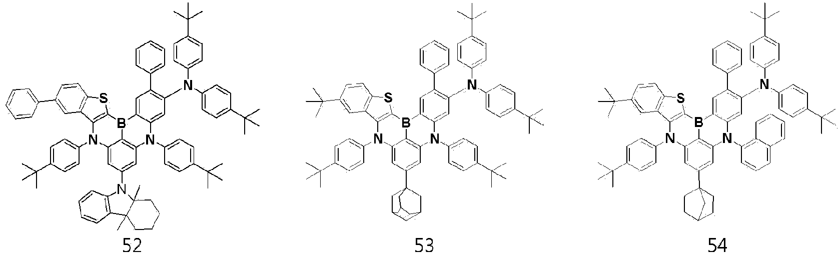

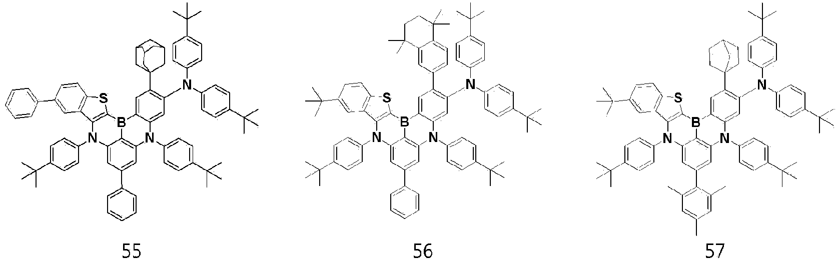

2. An organic light emitting device comprising a first electrode, a second electrode opposite to the first electrode, and one or more organic layers interposed between the first and second electrodes wherein one of the organic layers comprises the polycyclic compound according to claim 1.

3. The organic light emitting device according to claim 2, wherein the organic layers comprise a hole injecting layer, a hole transport layer, an electron blocking layer, a functional layer having functions of both hole injection and hole transport, a light emitting layer, an electron transport layer, an electron injecting layer, a hole blocking layer, and/or a functional layer having functions of both electron injection and electron transport.

4. The organic light emitting device according to claim 3, wherein the light emitting layer is composed of a host and a dopant and the polycyclic compound according to claim 1 is used as the dopant.

5. The organic light emitting device according to claim 4, wherein one or more dopant compounds other than the polycyclic compound according to claim 1 are mixed or stacked in the light emitting layer.

6. The organic light emitting device according to claim 4, wherein the host is an anthracene compound represented by Formula 3: 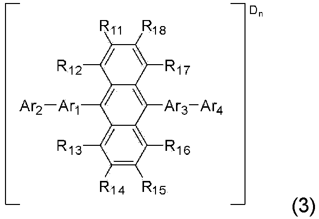 wherein R₁₁ to R₁₈ are the same as or different from each other and are each independently selected from hydrogen, deuterium, substituted or unsubstituted C₁-C₃₀ alkyl, substituted or unsubstituted C₂-C₃₀ alkynyl, substituted or unsubstituted C₂-C₃₀ alkenyl, substituted or unsubstituted C₆-C₅₀ aryl, substituted or unsubstituted C₃-C₅₀ cycloalkyl, substituted or unsubstituted C₂-C₅₀ heterocycloalkyl, substituted or unsubstituted C₂-C₅₀ heteroaryl, cyclic groups in which a substituted or unsubstituted C₃-C₃₀ aliphatic ring and a C₅-C₃₀ aromatic ring are fused together, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted amine, substituted or unsubstituted silyl, substituted or unsubstituted germanium, nitro, cyano, and halogen, Ar₁ and Ar₃ are the same as or different from each other and are each independently a single bond or selected from substituted or unsubstituted C₆-C₃₀ arylene, substituted or unsubstituted C₅-C₃₀ heteroarylene, and divalent cyclic groups in which a substituted or unsubstituted C₃-C₃₀ aliphatic ring and a C₅-C₃₀ aromatic ring are fused together, Ar₂ and Ar₄ are the same as or different from each other and are each independently selected from substituted or unsubstituted C₆-C₅₀ aryl, substituted or unsubstituted C₃-C₃₀ cycloalkyl, substituted or unsubstituted C₃-C₃₀ heterocycloalkyl, substituted or unsubstituted C₂-C₅₀ heteroaryl, and cyclic groups in which a substituted or unsubstituted C₃-C₃₀ aliphatic ring and a C₅-C₃₀ aromatic ring are fused together, Dₙ represents the number of deuterium atoms replacing hydrogen atoms, and n is an integer from 0 to 60.

7. The organic light emitting device according to claim 6, wherein the compound represented by Formula 3 is selected from the following compounds:

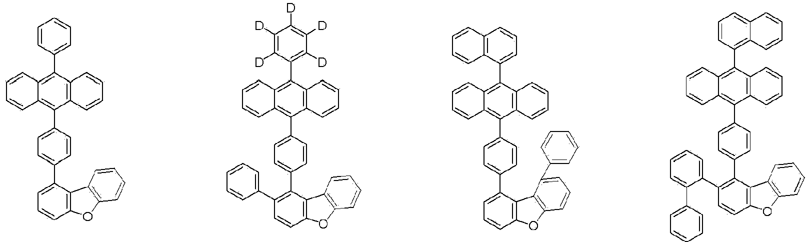

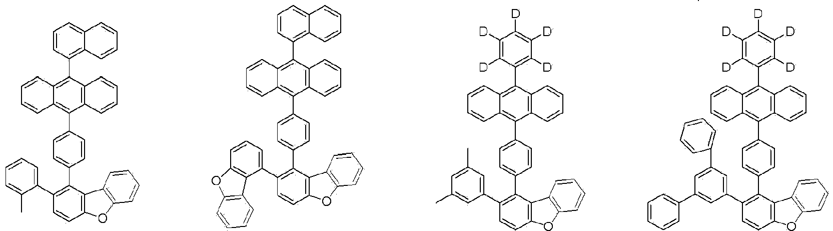

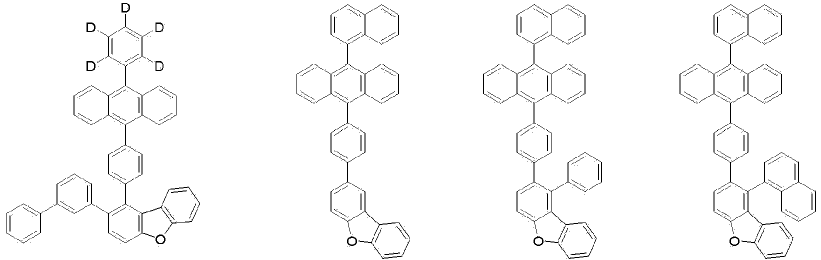

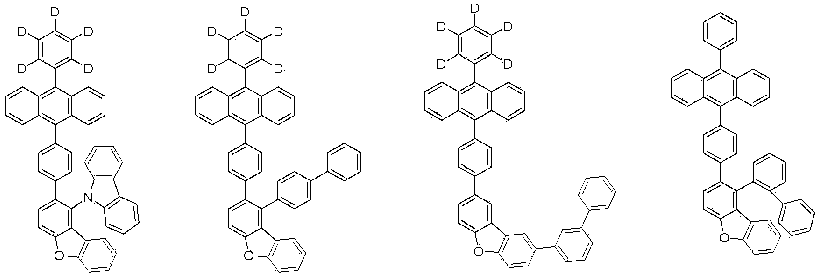

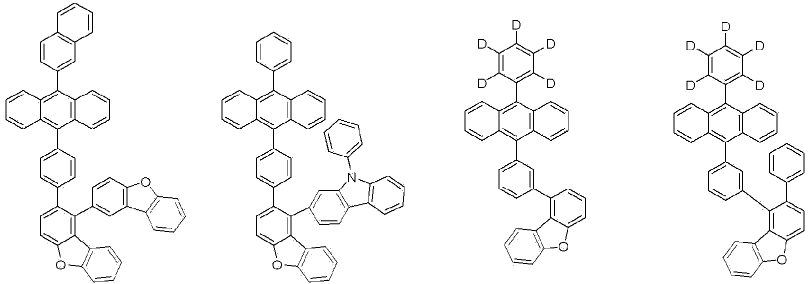

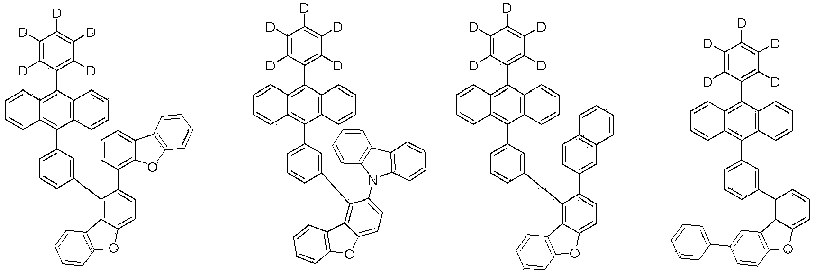

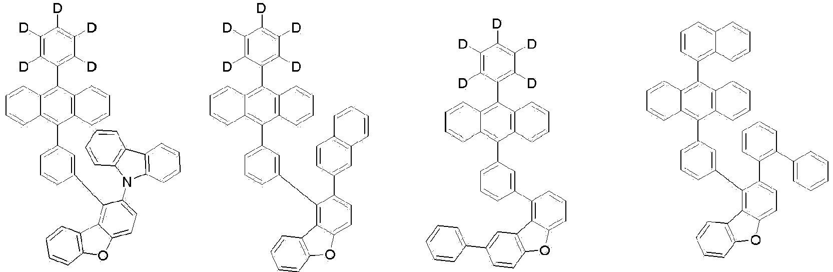

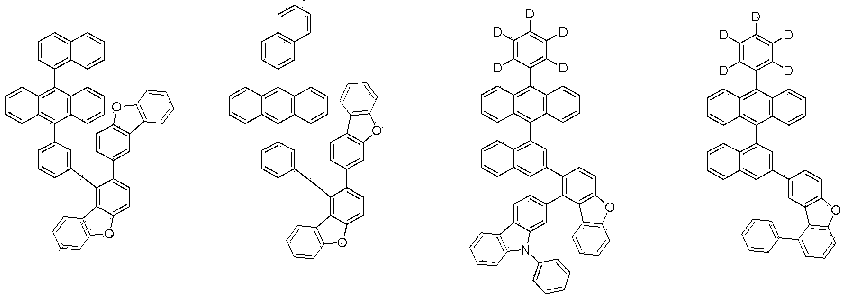

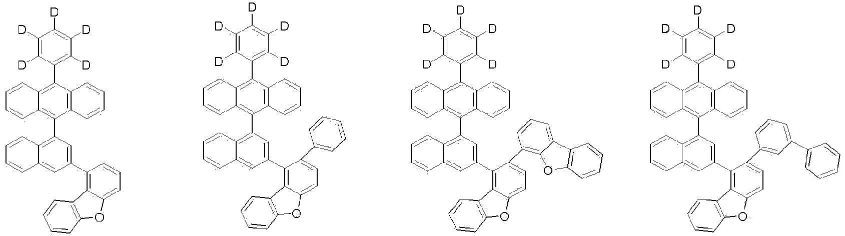

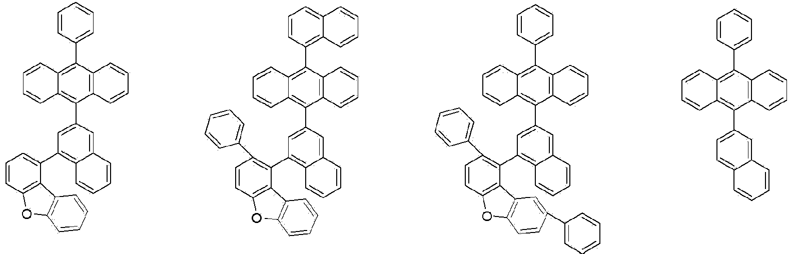

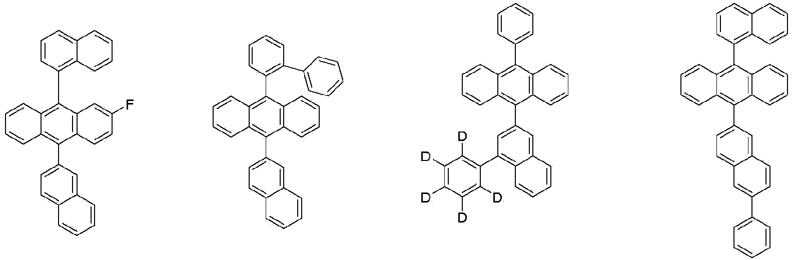

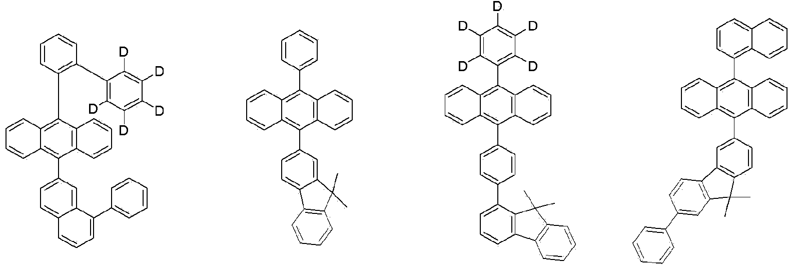

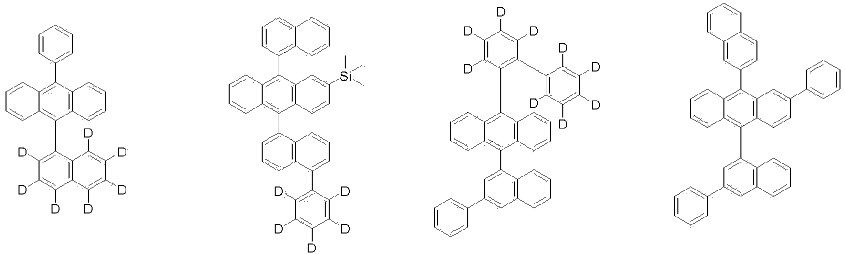

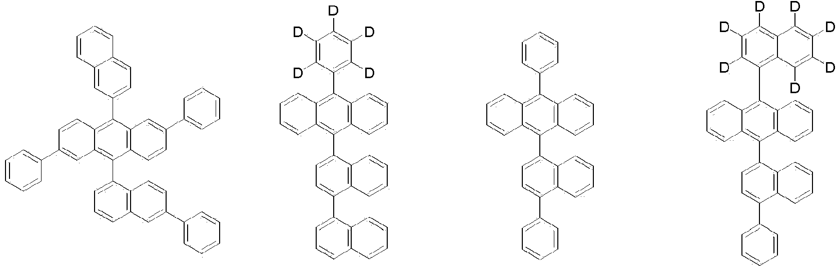

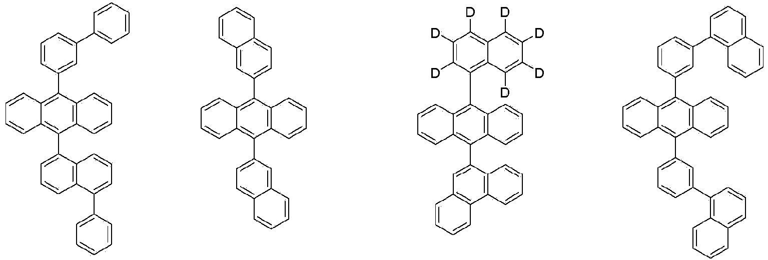

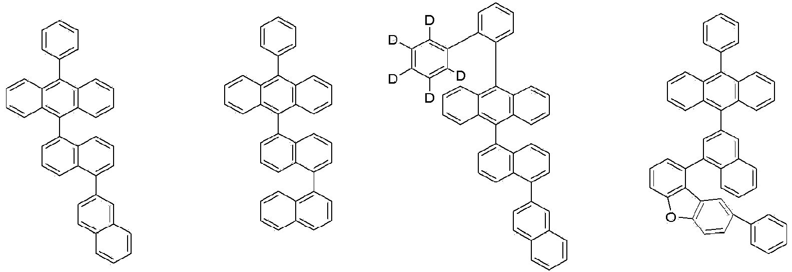

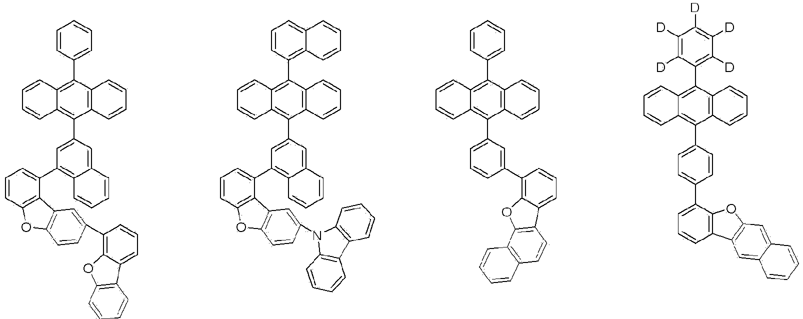

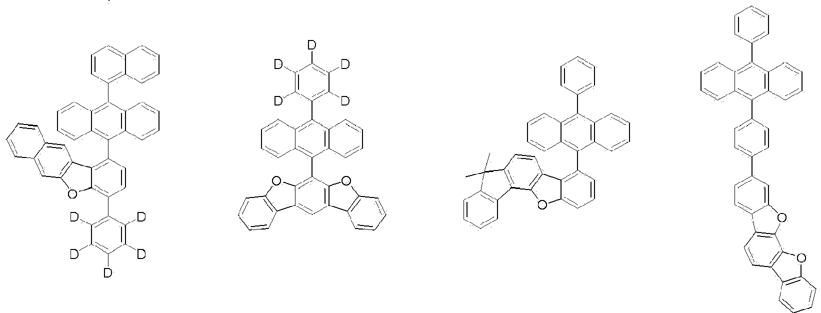

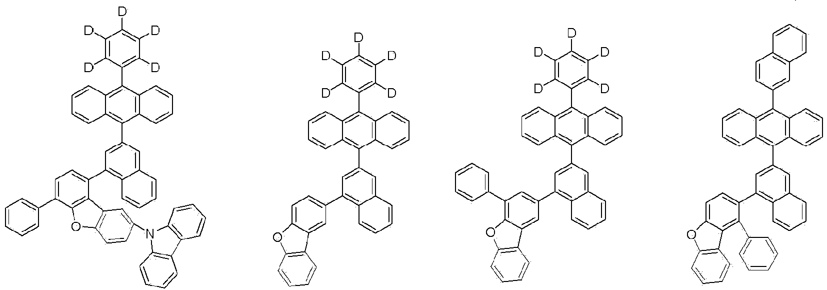

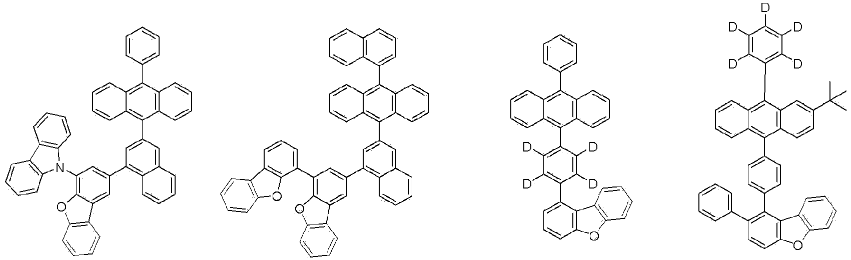

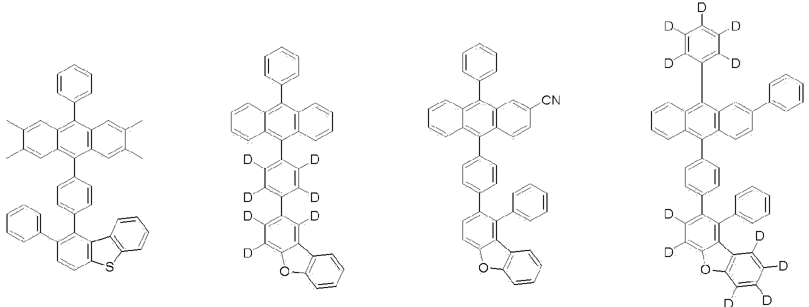

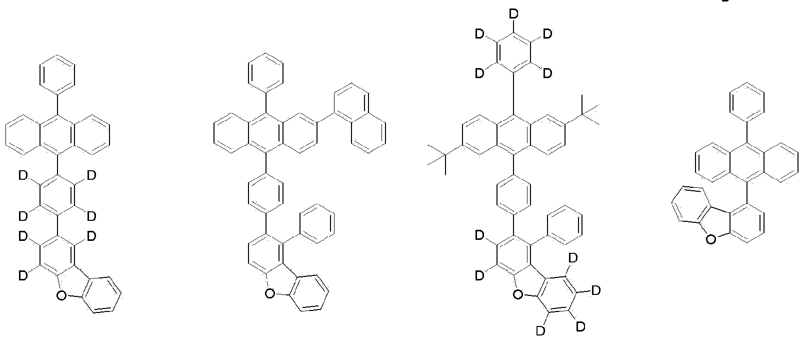

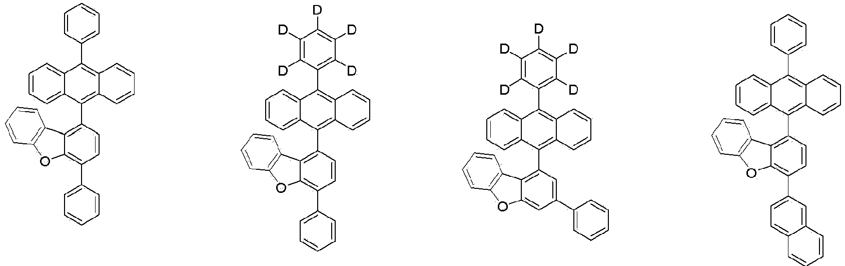

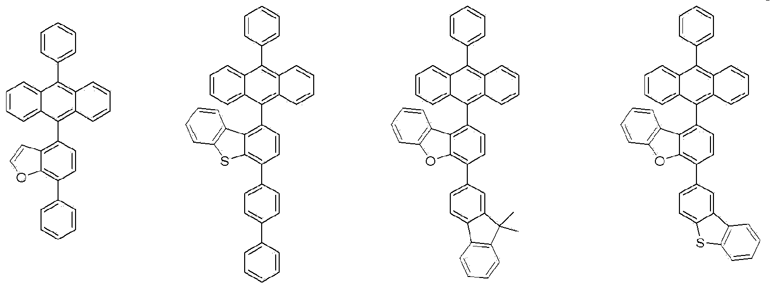

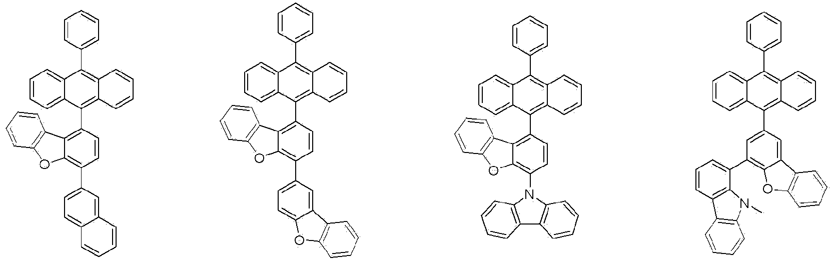

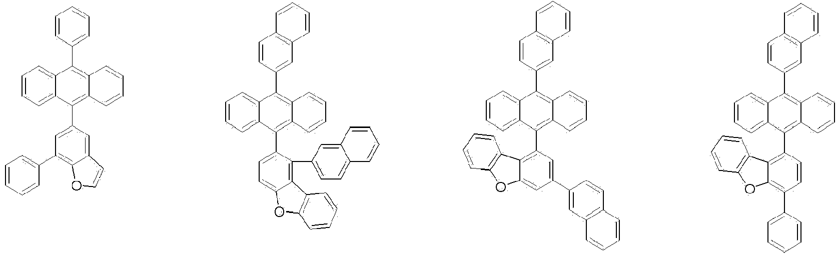

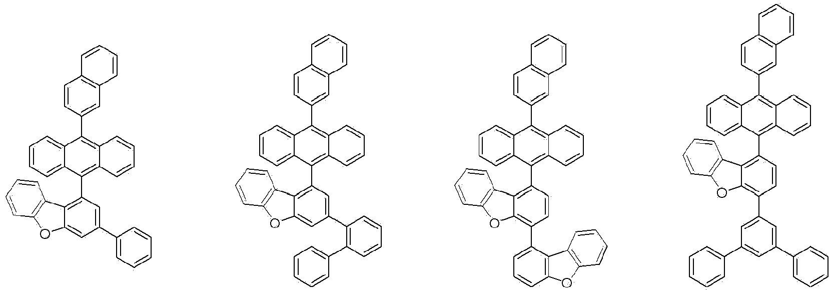

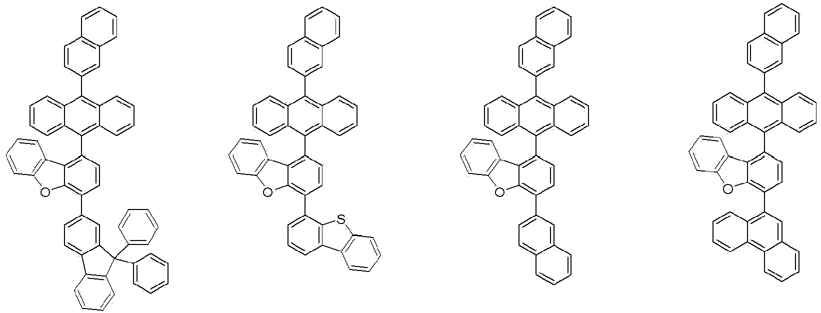

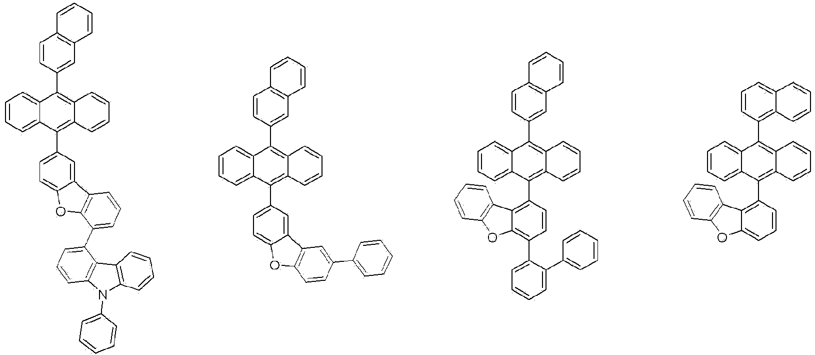

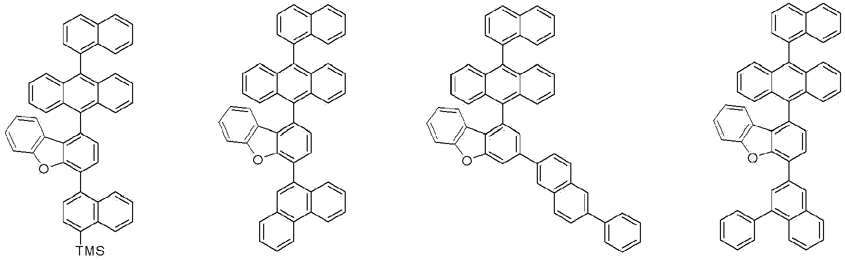

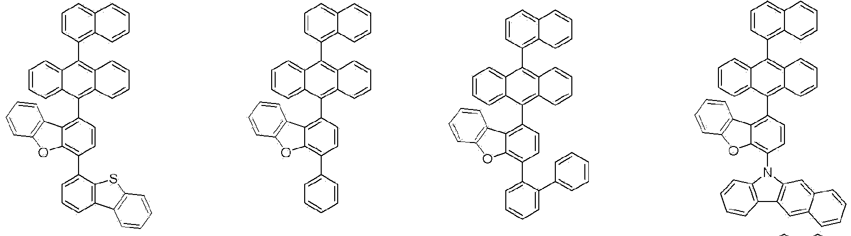

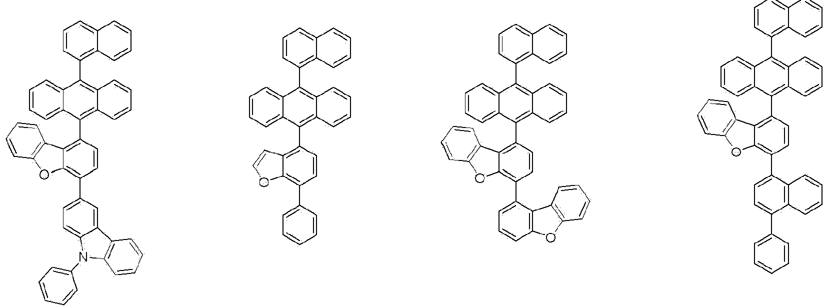

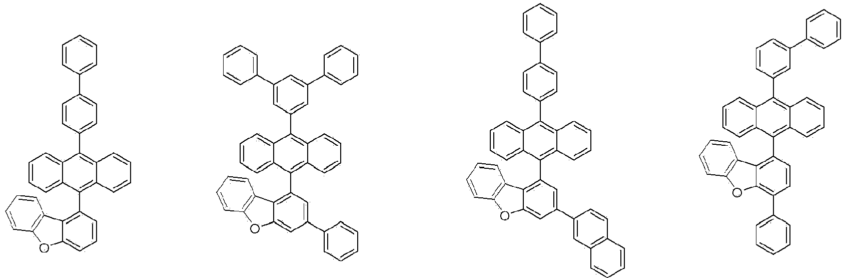

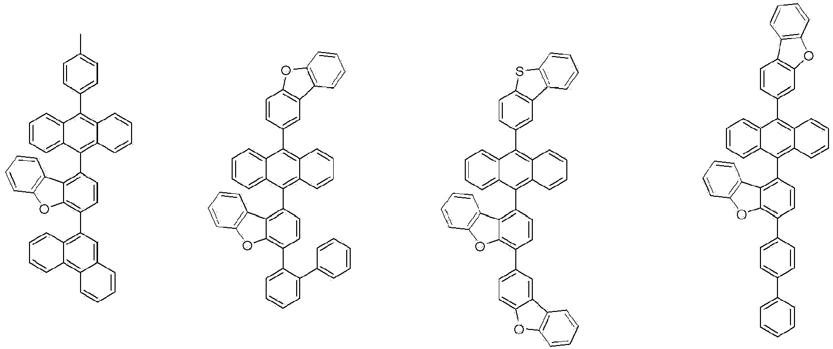

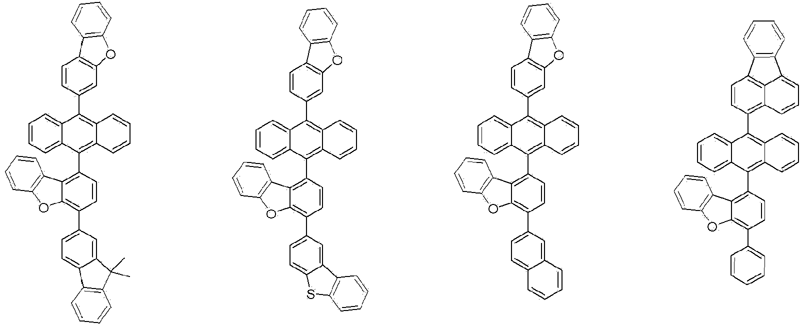

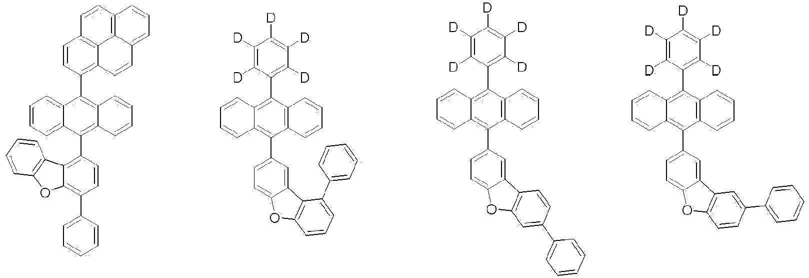

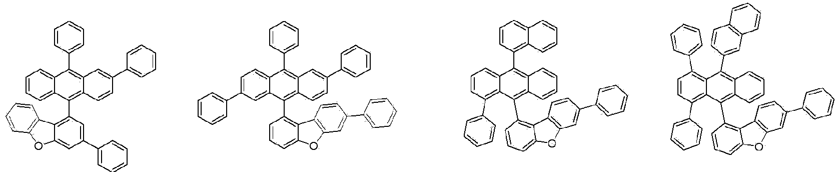

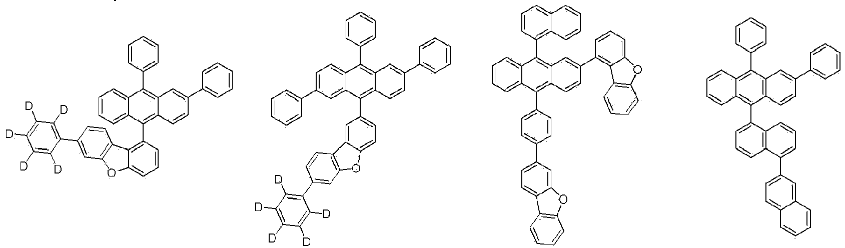

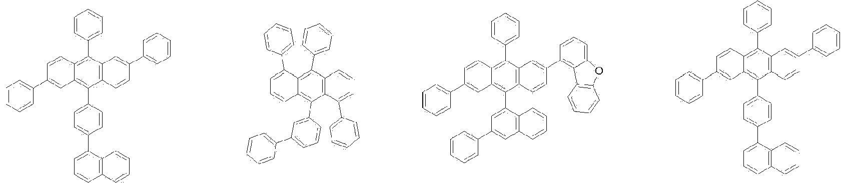

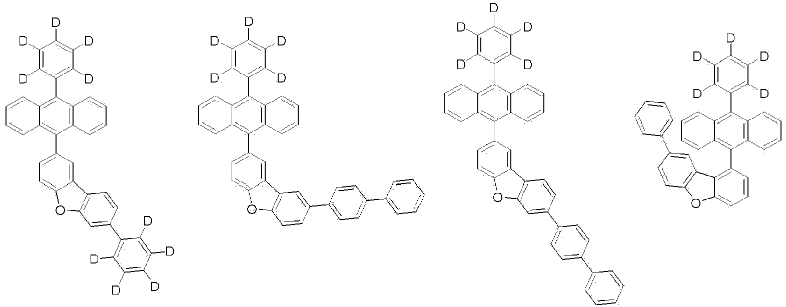

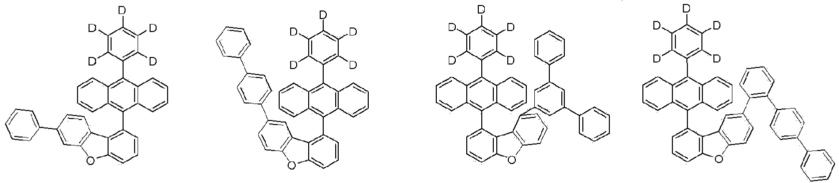

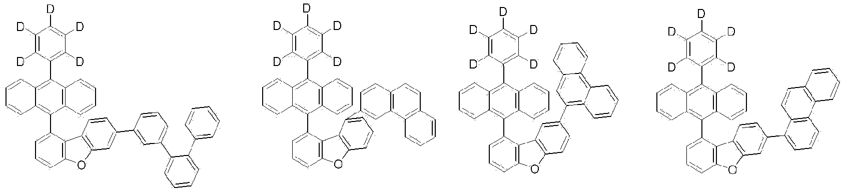

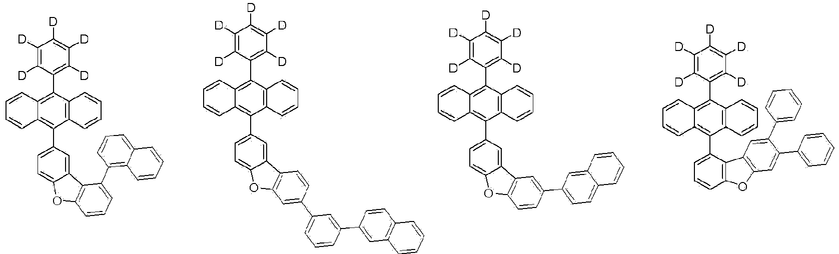

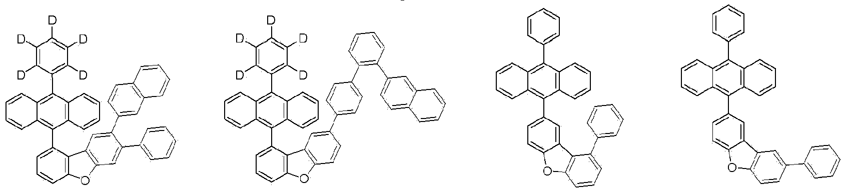

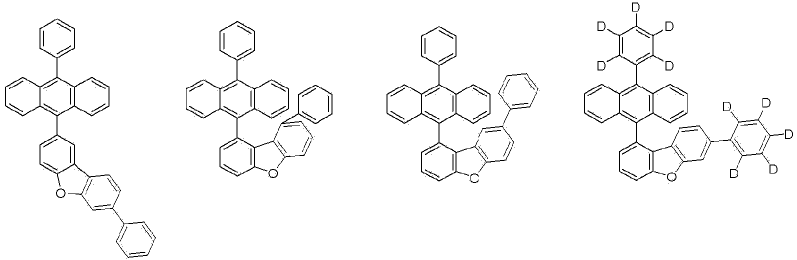

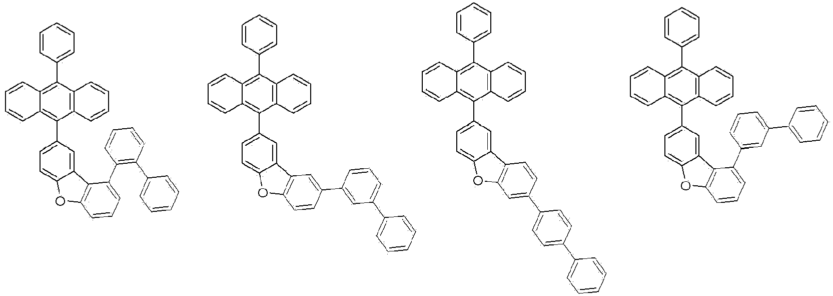

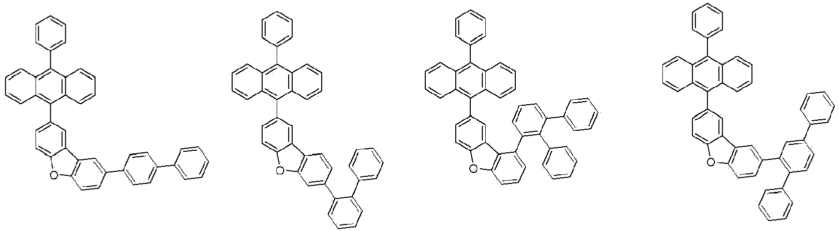

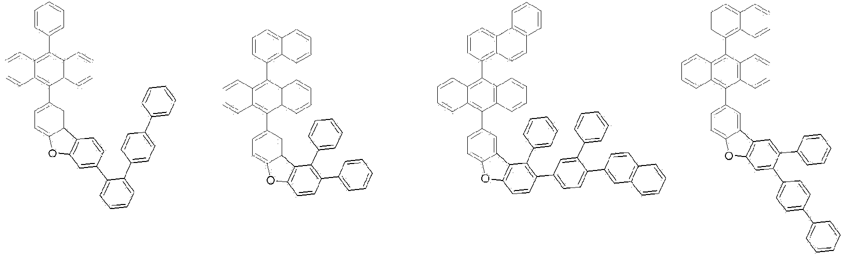

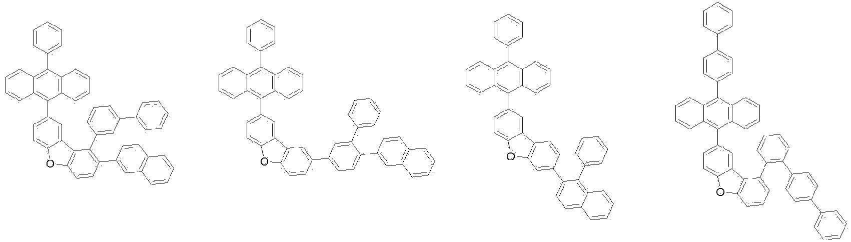

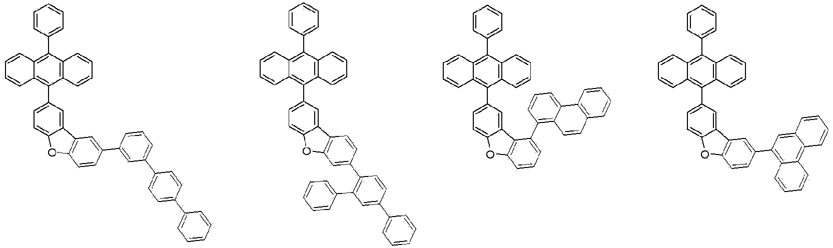

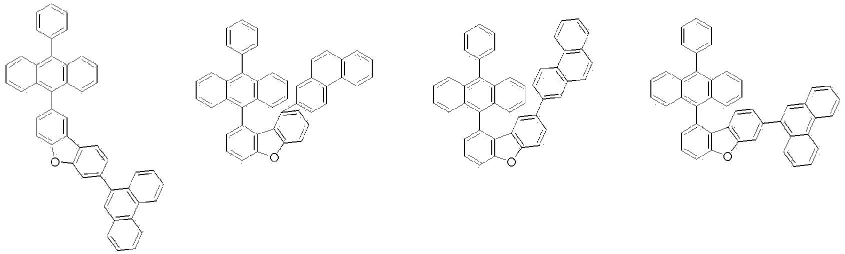

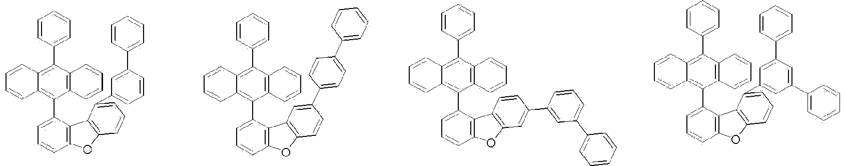

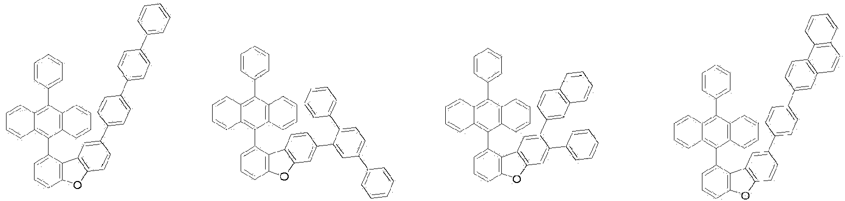

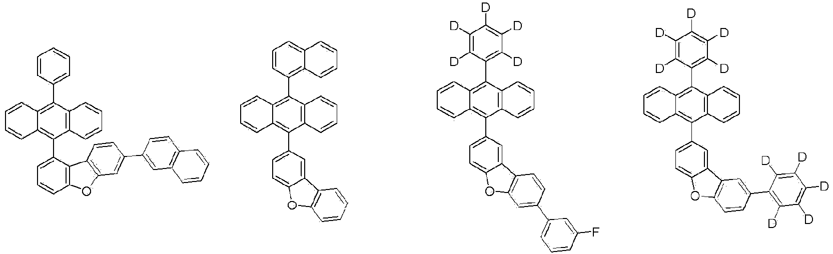

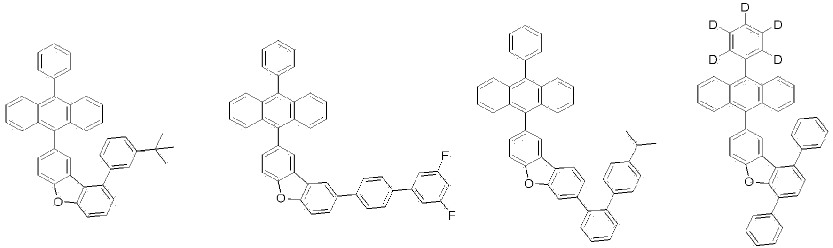

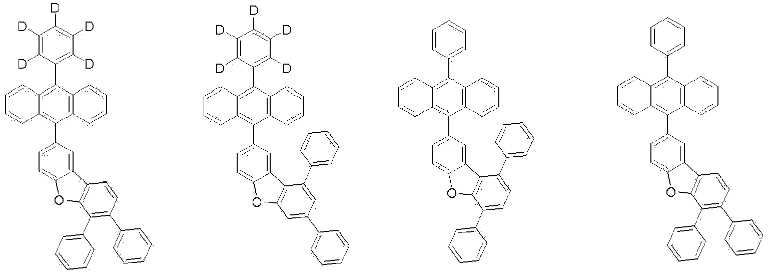

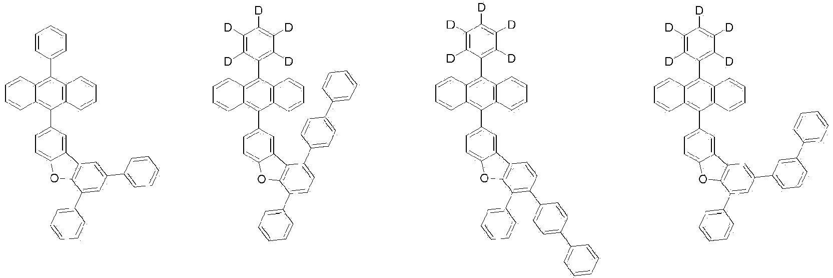

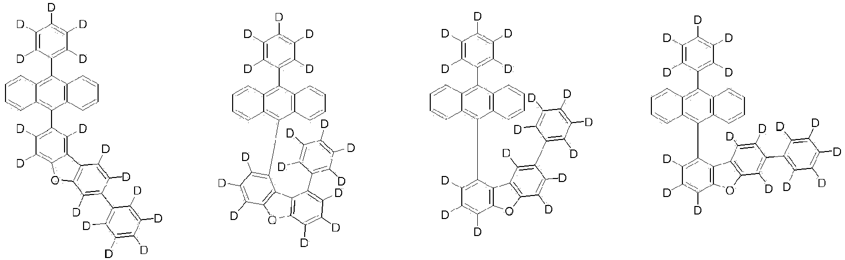

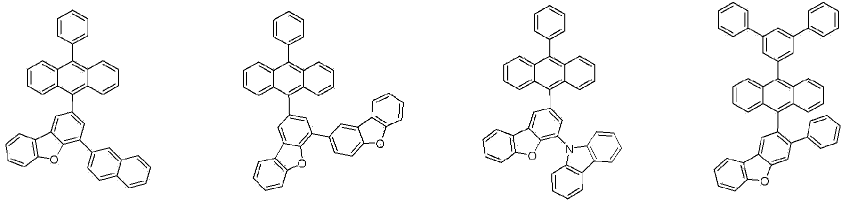

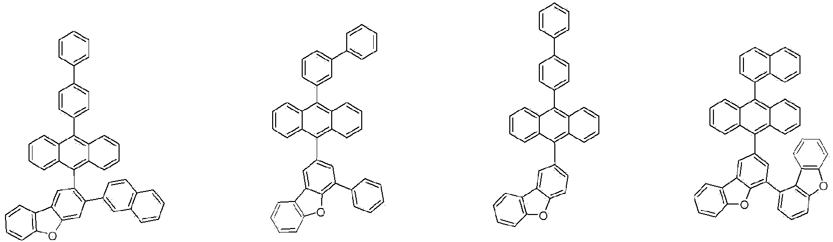

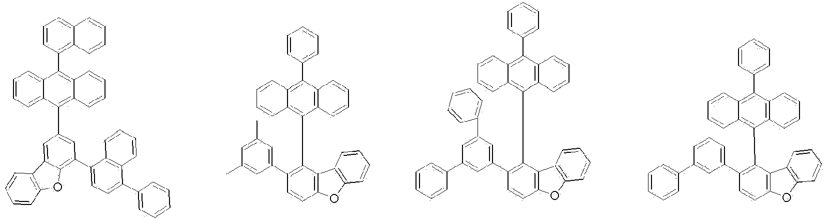

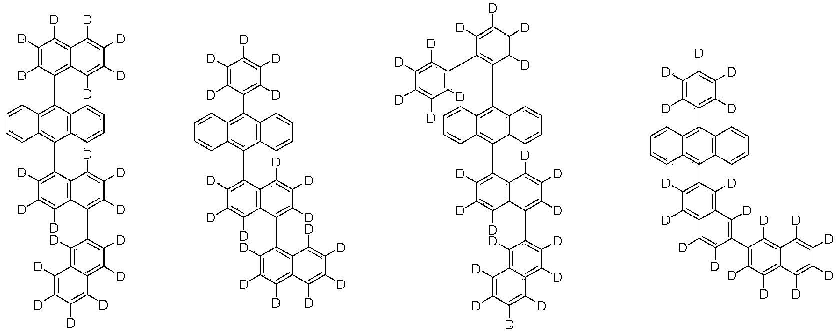

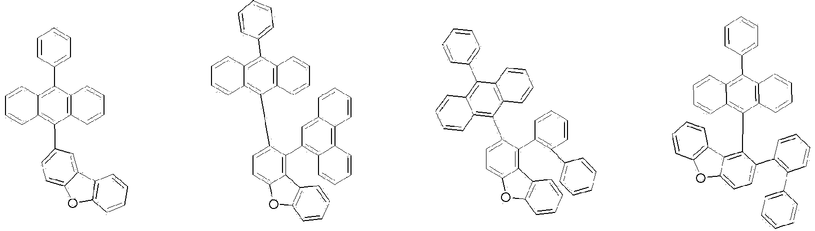

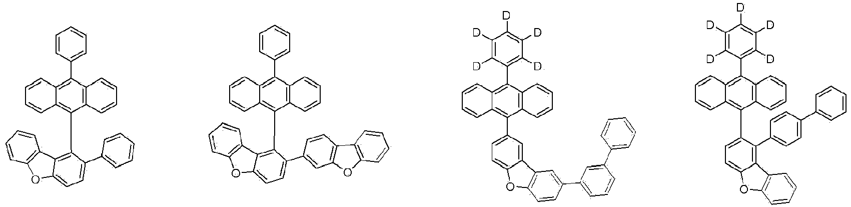

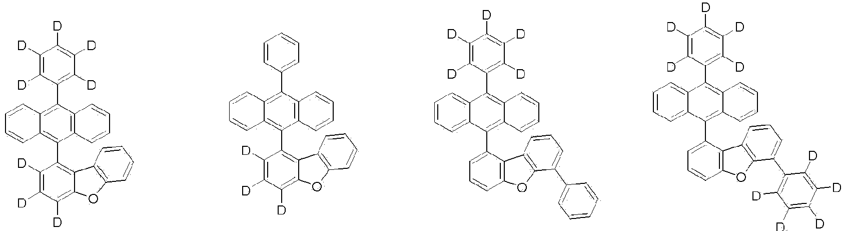

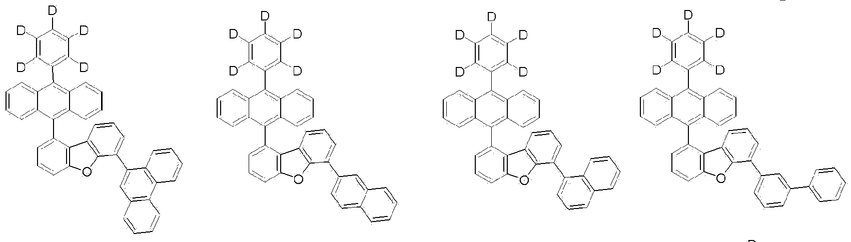

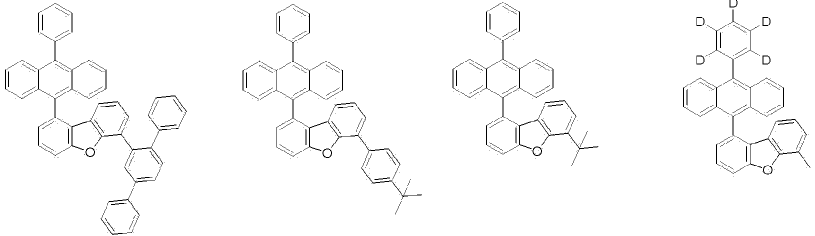

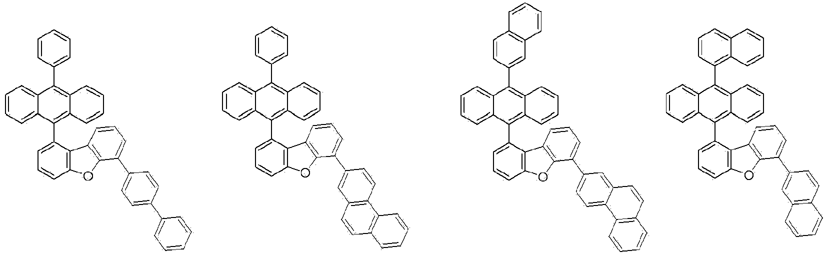

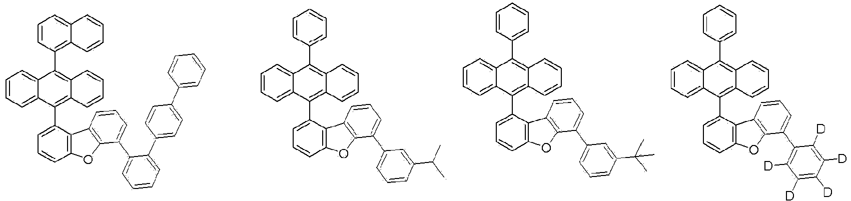

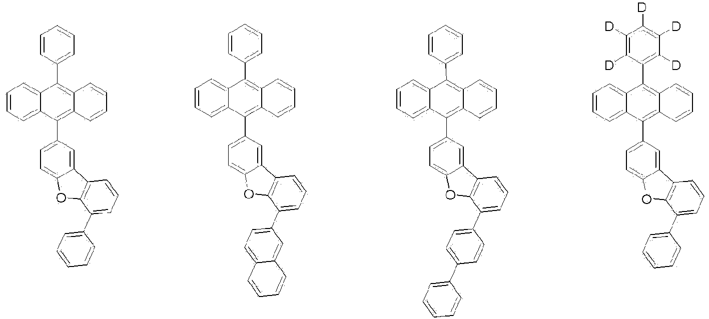

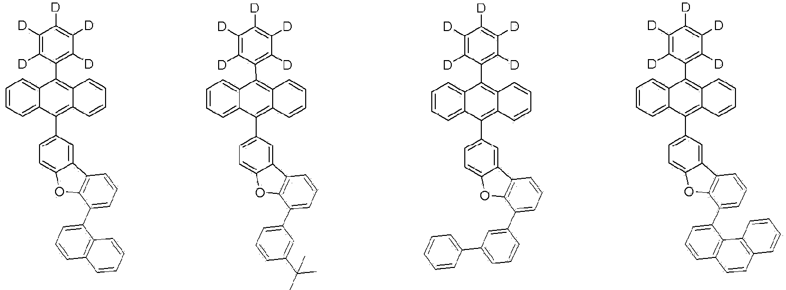

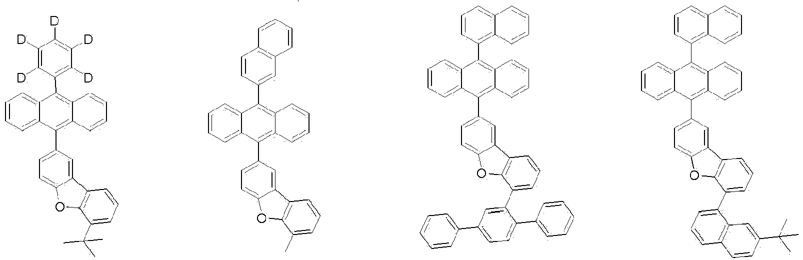

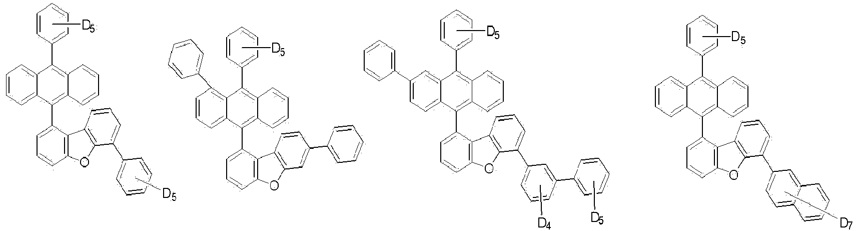

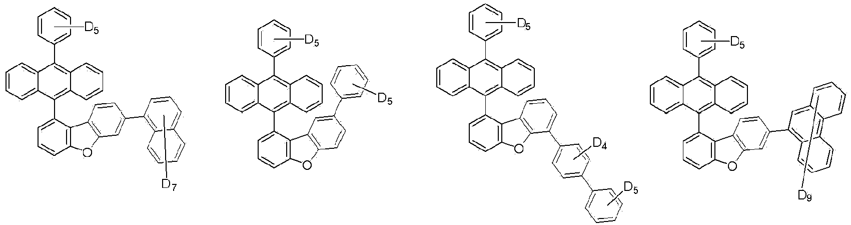

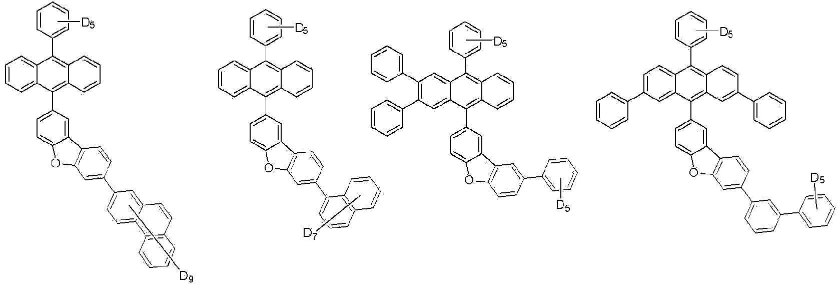

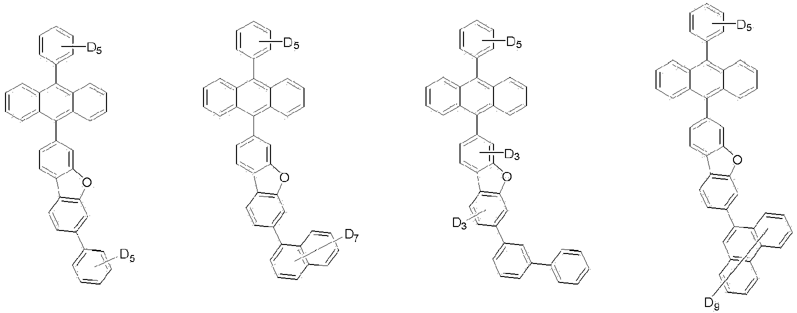

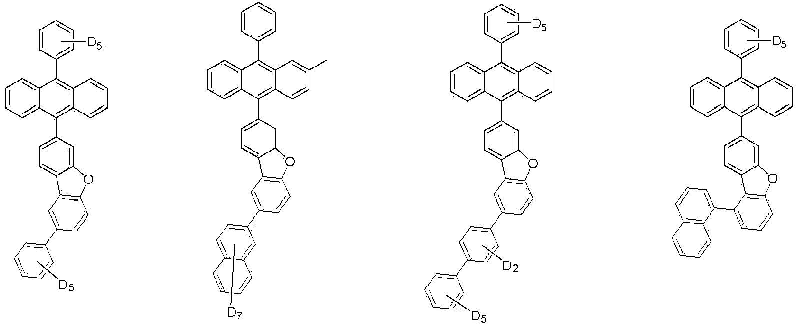

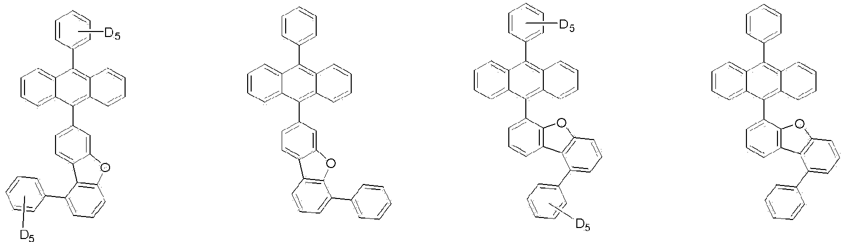

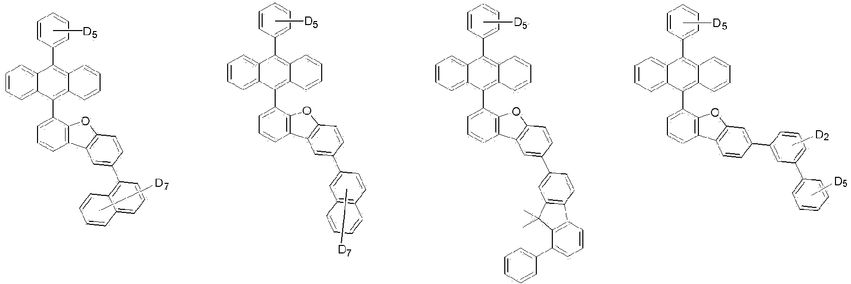

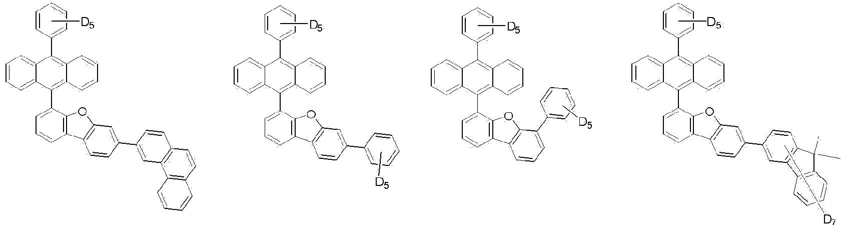

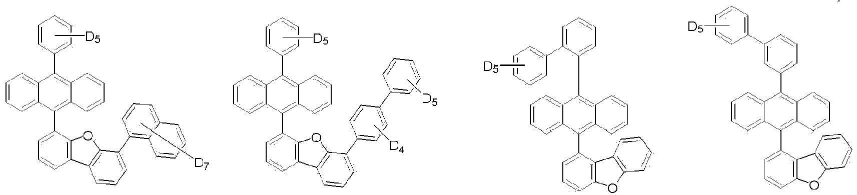

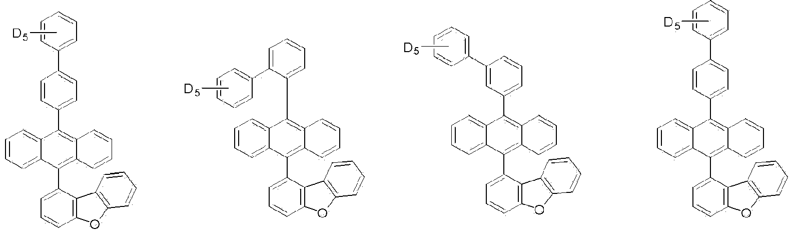

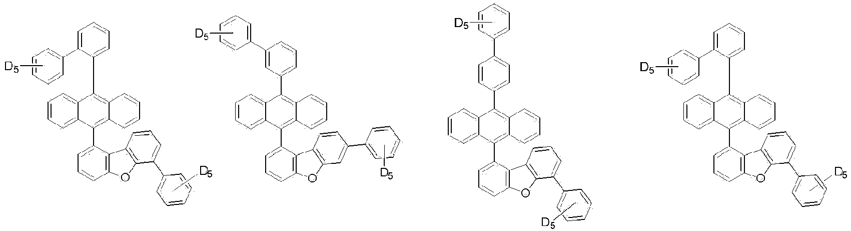

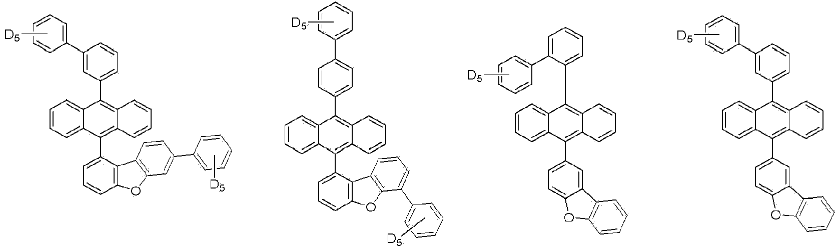

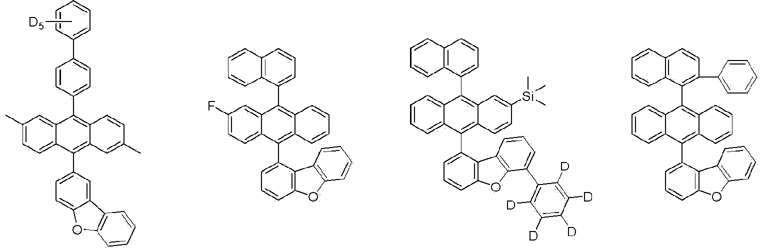

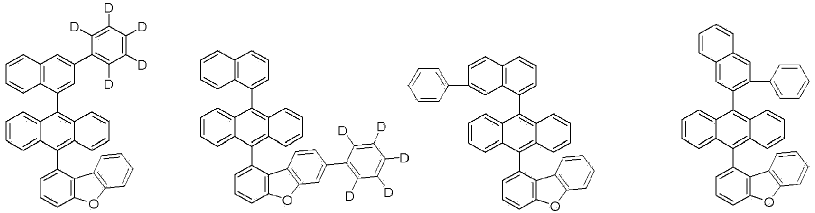

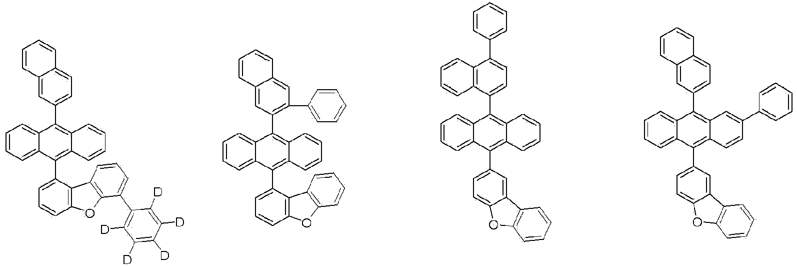

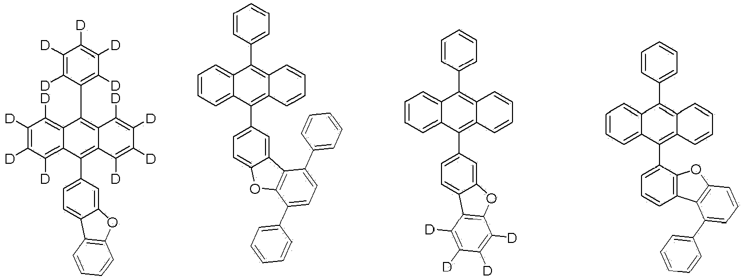

8. The organic light emitting device according to claim 6, wherein one or more host compounds other than the anthracene compound represented by Formula 3 are mixed or stacked in the light emitting layer.

9. The organic light emitting device according to claim 2, wherein the organic light emitting device is used in a display or lighting system selected from flat panel displays, flexible displays, monochromatic flat panel lighting systems, white flat panel lighting systems, flexible monochromatic lighting systems, flexible white lighting systems, displays for automotive applications, displays for virtual reality, and displays for augmented reality.

## Patentansprüche

1. Eine polyzyklische Verbindung, ausgewählt aus den folgenden Verbindungen 1 bis 57:

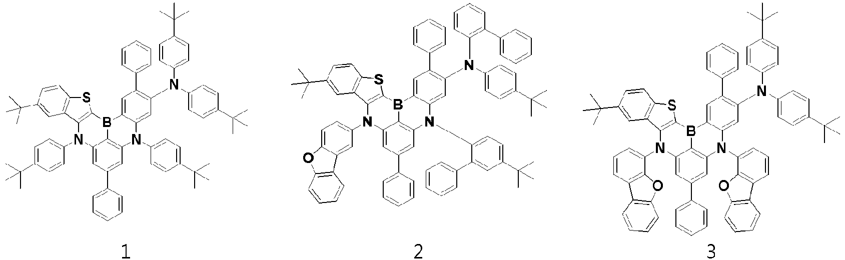

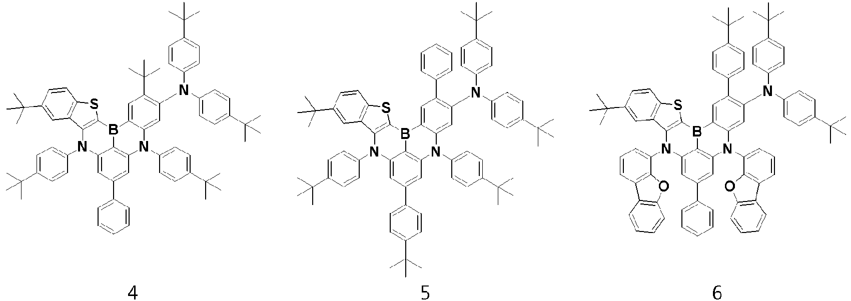

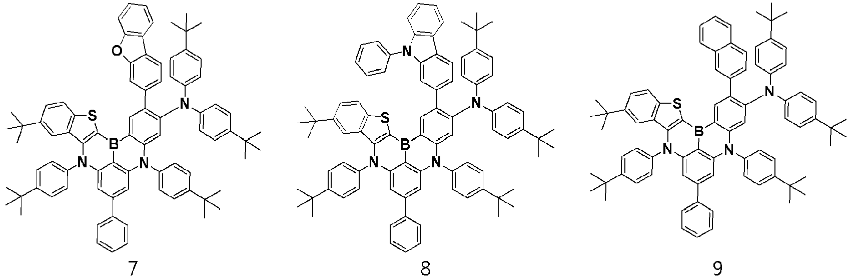

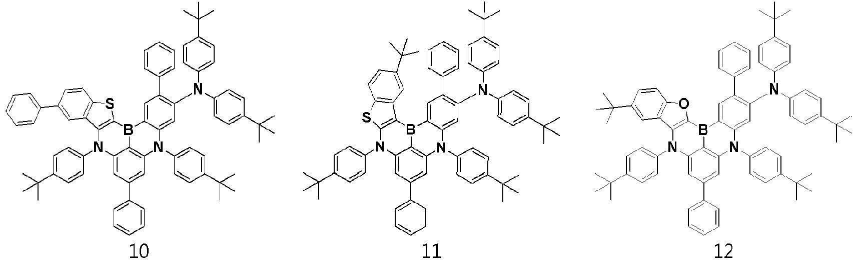

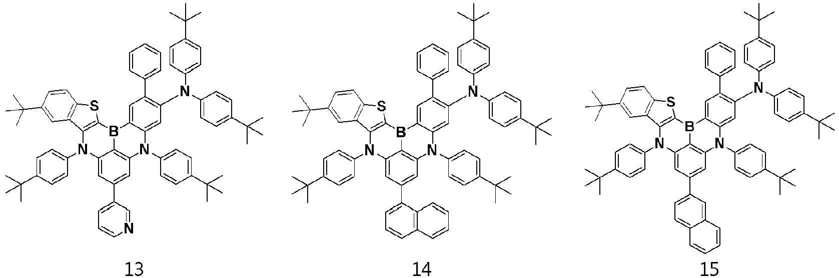

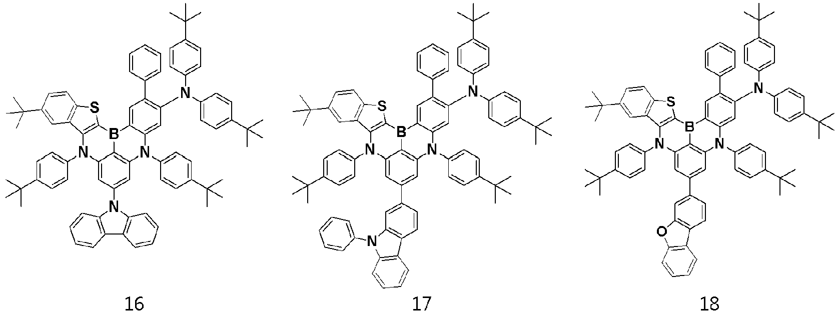

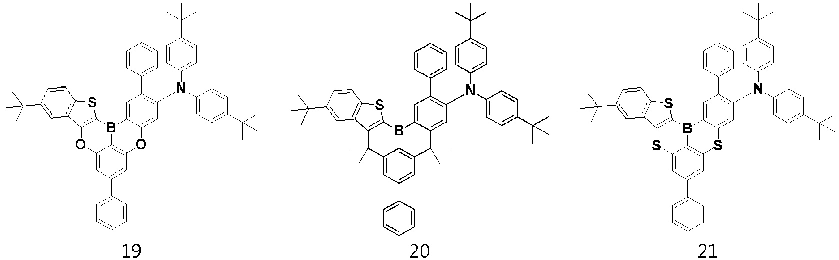

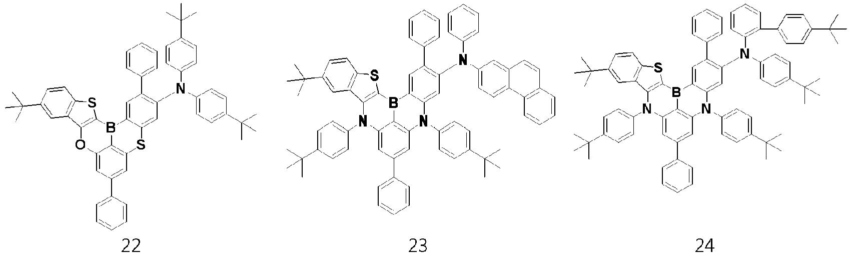

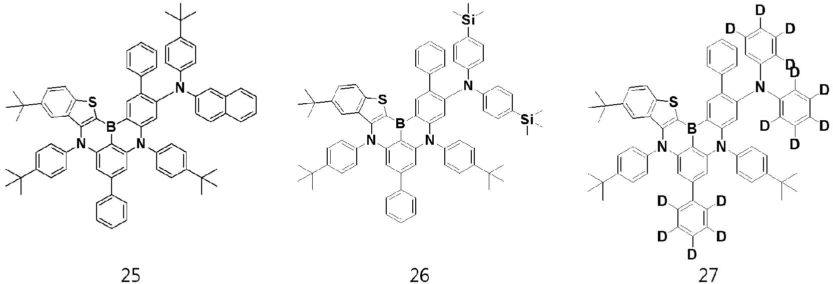

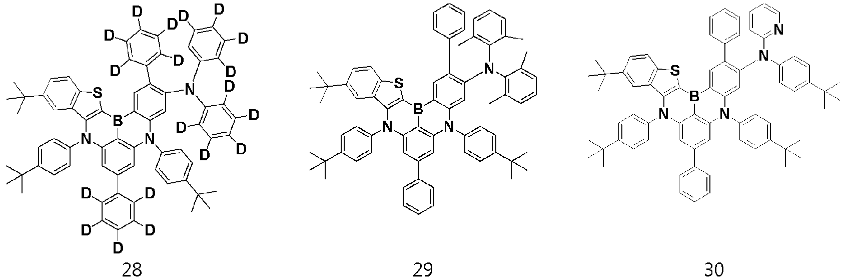

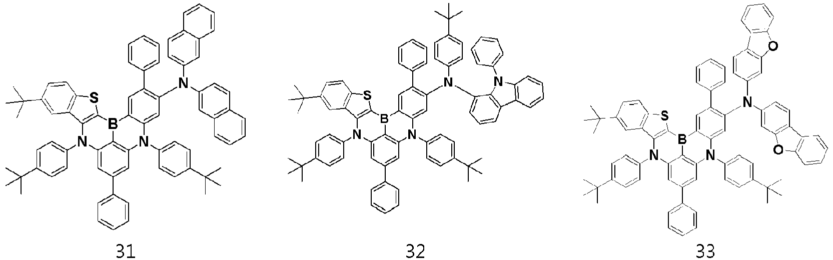

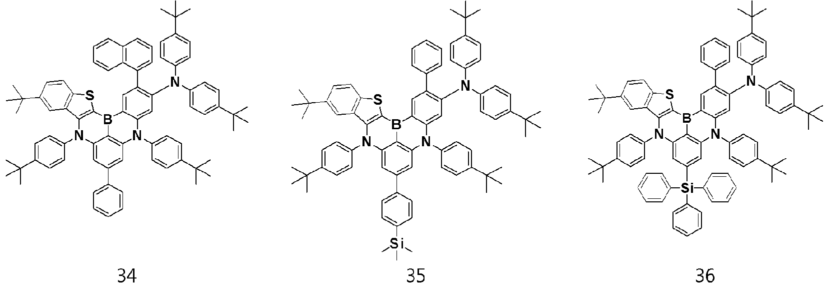

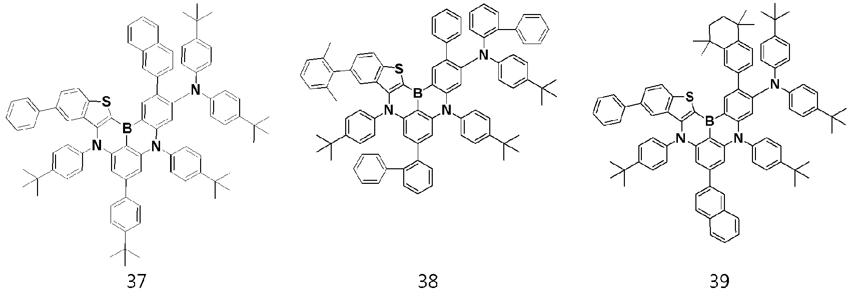

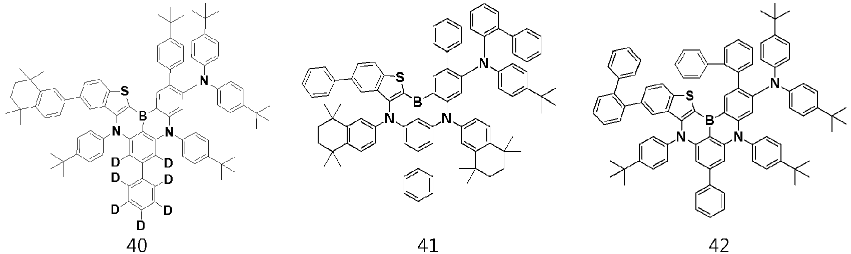

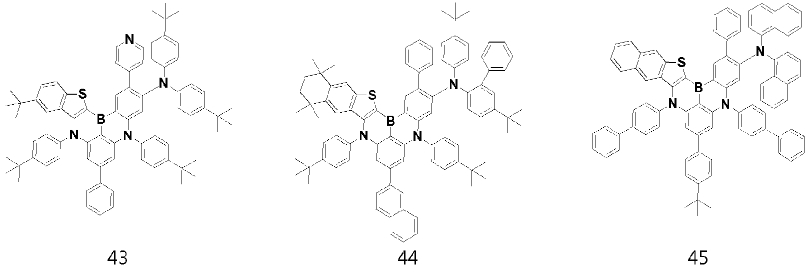

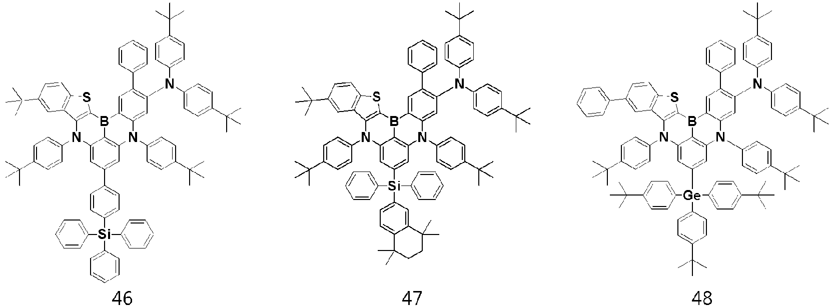

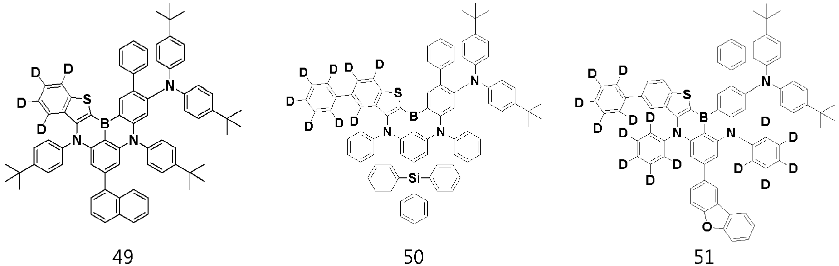

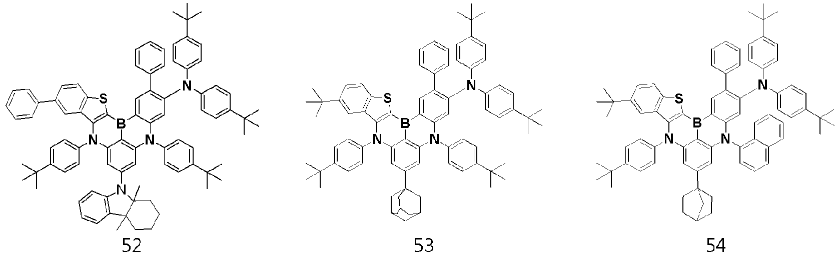

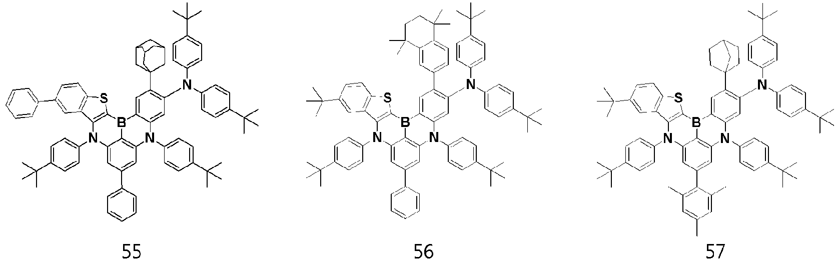

2. Organische lichtemittierende Vorrichtung, umfassend eine erste Elektrode, eine der ersten Elektrode gegenüberliegende zweite Elektrode sowie eine oder mehrere organische Schichten, die zwischen der ersten und der zweiten Elektrode angeordnet sind, wobei eine der organischen Schichten die polyzyklische Verbindung gemäß Anspruch 1 umfasst.

3. Organische lichtemittierende Vorrichtung nach Anspruch 2, wobei die organischen Schichten eine Lochinjektionsschicht, eine Lochtransportschicht, eine Elektronenblockierungsschicht, eine Funktionsschicht, die sowohl Funktionen der Lochinjektion als auch des Lochtransports erfüllt, eine lichtemittierende Schicht, eine Elektronentransportschicht, eine Elektroneninjektionsschicht, eine Lochblockierungsschicht und/oder eine Funktionsschicht, die sowohl Funktionen der Elektroneninjektion als auch des Elektronentransports erfüllt, umfassen.

4. Organische lichtemittierende Vorrichtung nach Anspruch 3, wobei die lichtemittierende Schicht aus einem Wirtsmaterial und einem Dotierstoff besteht und die polyzyklische Verbindung nach Anspruch 1 als der Dotierstoff verwendet wird.

5. Organische lichtemittierende Vorrichtung nach Anspruch 4, wobei eine oder mehrere andere Dotierstoffverbindungen als die polyzyklische Verbindung nach Anspruch 1 in die lichtemittierende Schicht eingemischt oder darin gestapelt sind.

6. Organische lichtemittierende Vorrichtung nach Anspruch 4, wobei der Wirtsstoff eine Anthracenverbindung ist, die durch die Formel 3 dargestellt ist: 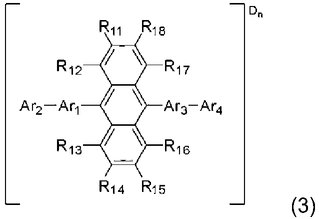 wobei R₁₁ bis R₁₈ gleich oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₂-C₃₀-Alkinyl, substituiertem oder unsubstituiertem C₂-C₃₀-Alkenyl, substituiertem oder unsubstituiertem C₆-C₅₀-Aryl, substituiertem oder unsubstituiertem C₃-C₅₀-Cycloalkyl, substituiertem oder unsubstituiertem C₂-C₅₀-Heterocycloalkyl, substituiertem oder unsubstituiertem C₂-C₅₀-Heteroaryl, zyklischen Gruppen, in denen ein substituierter oder unsubstituierter aliphatischer C₃-C₃₀-Ring und ein aromatischer C₅-C₃₀-Ring miteinander kondensiert sind, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem Amin, substituiertem oder unsubstituiertem Silyl, substituiertem oder unsubstituiertem Germanium, Nitro, Cyano und Halogen, Ar₁ und Ar₃ gleich oder voneinander verschieden sind und jeweils unabhängig voneinander eine Einfachbindung oder ausgewählt aus substituiertem oder unsubstituiertem C₆-C₃₀-Arylen, substituiertem oder unsubstituiertem C₅-C₃₀-Heteroarylen und zweiwertigen cyclischen Gruppen sind, in denen ein substituierter oder unsubstituierter aliphatischer C₃-C₃₀-Ring und ein aromatischer C₅-C₃₀-Ring miteinander kondensiert sind, Ar₂ und Ar₄ gleich oder voneinander verschieden sind und jeweils unabhängig voneinander ausgewählt sind aus substituiertem oder unsubstituiertem C₆-C₅₀-Aryl, substituiertem oder unsubstituiertem C₃-C₃₀-Cycloalkyl, substituiertem oder unsubstituiertem C₃-C₃₀-Heterocycloalkyl, substituiertem oder unsubstituiertem C₂-C₅₀-Heteroaryl und cyclischen Gruppen, in denen ein substituierter oder unsubstituierter aliphatischer C₃-C₃₀-Ring und ein aromatischer C₅-C₃₀-Ring miteinander kondensiert sind, Dₙ die Anzahl der Deuteriumatome bedeutet, die Wasserstoffatome ersetzen, und n eine ganze Zahl von 0 bis 60 ist.

7. Organische lichtemittierende Vorrichtung nach Anspruch 6, wobei die durch Formel 3 dargestellte Verbindung aus den folgenden Verbindungen ausgewählt ist:

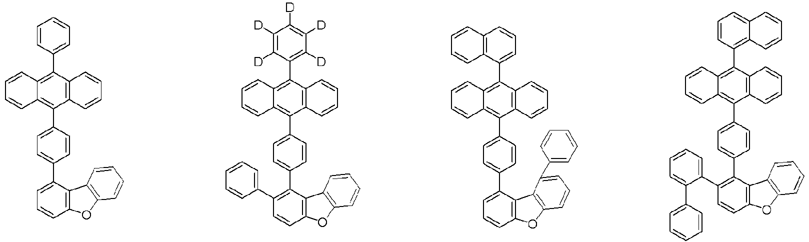

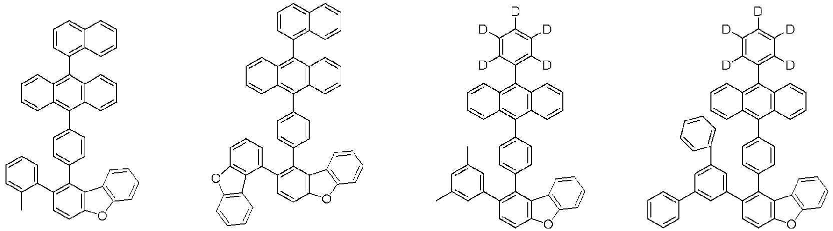

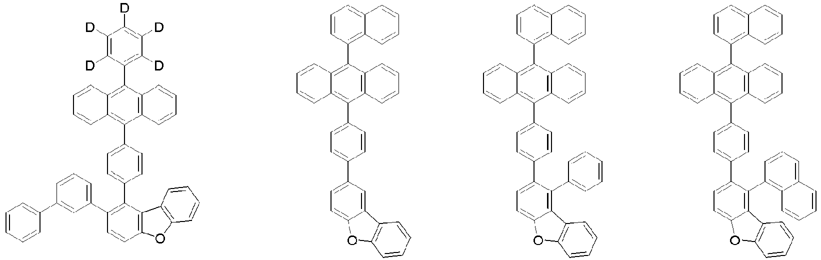

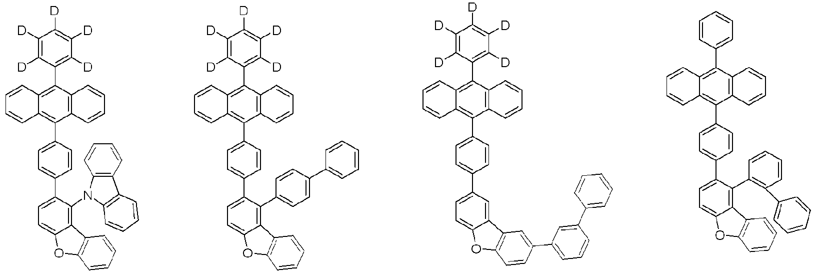

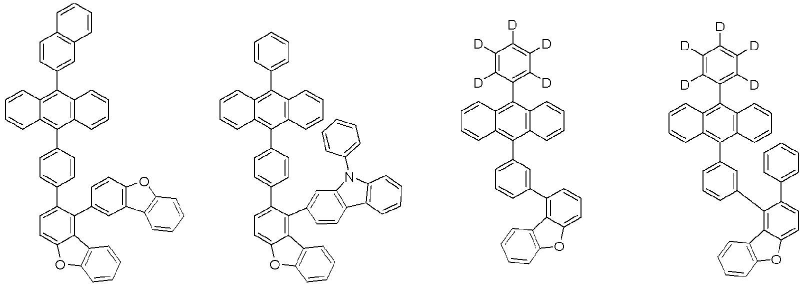

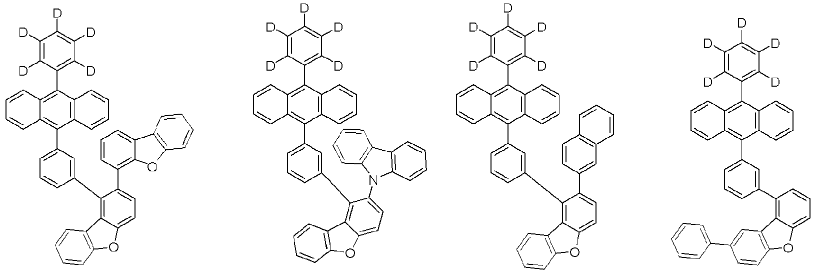

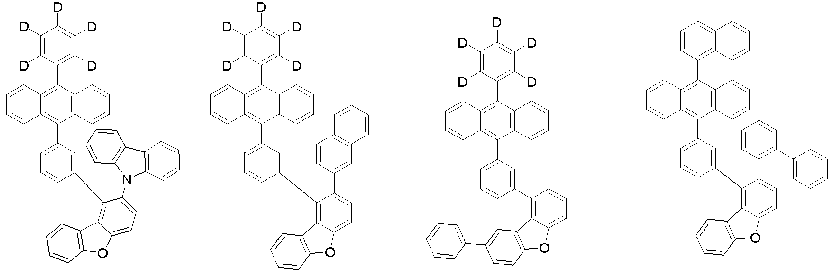

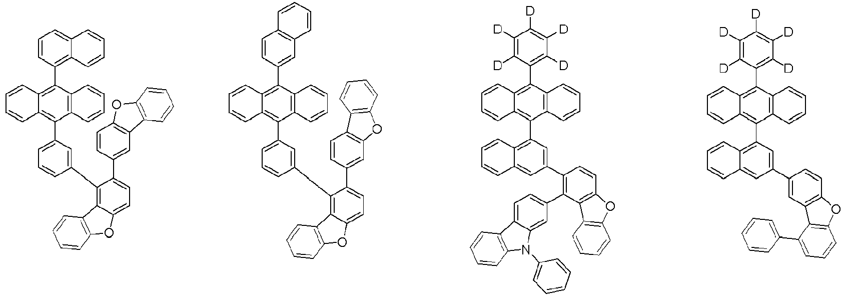

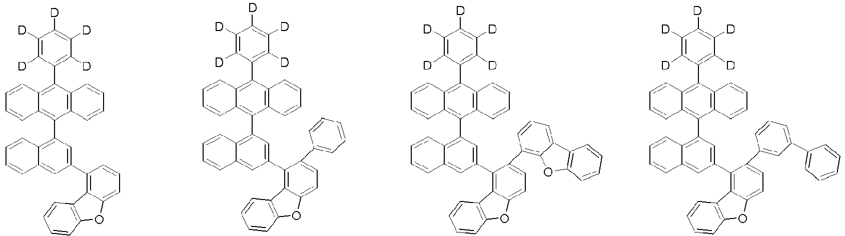

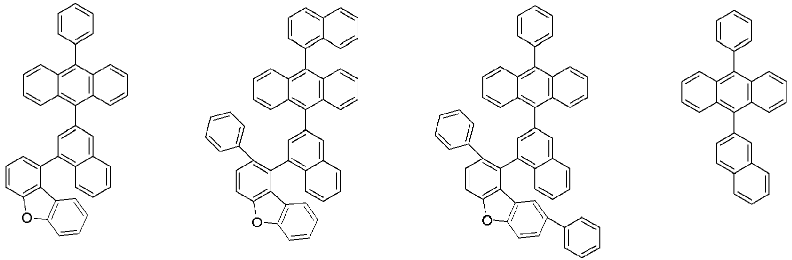

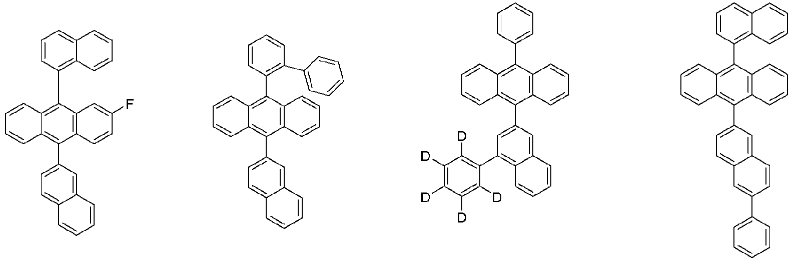

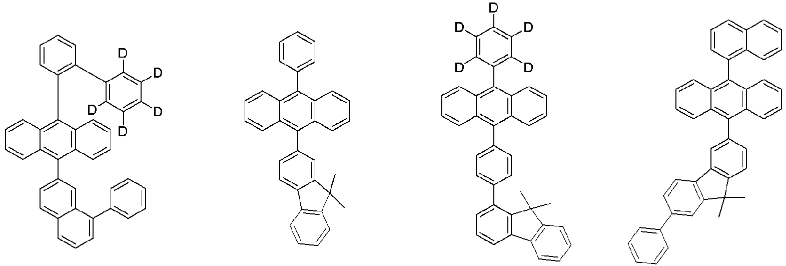

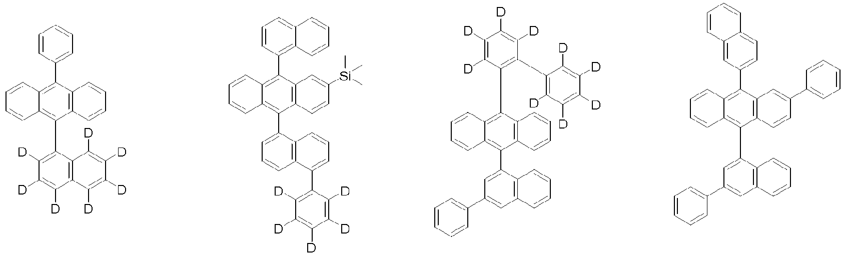

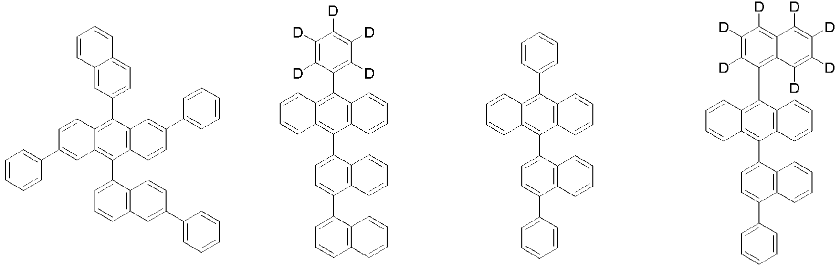

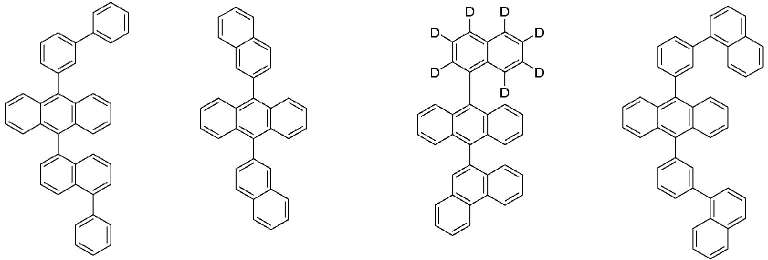

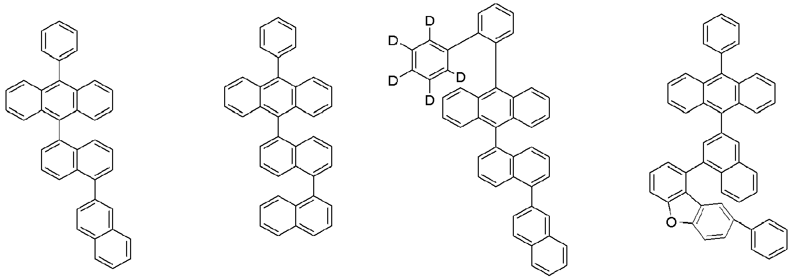

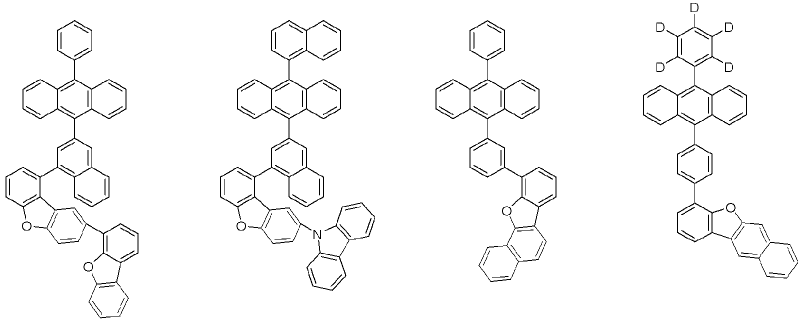

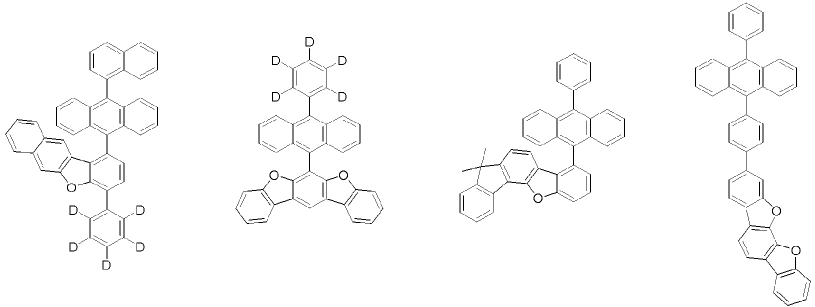

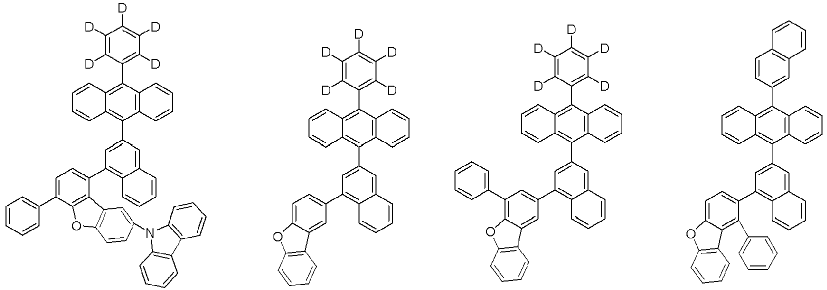

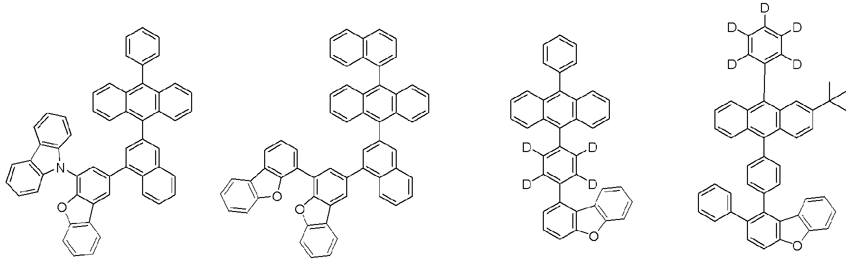

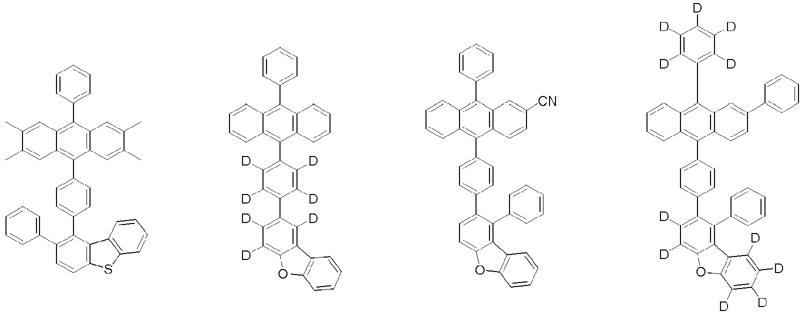

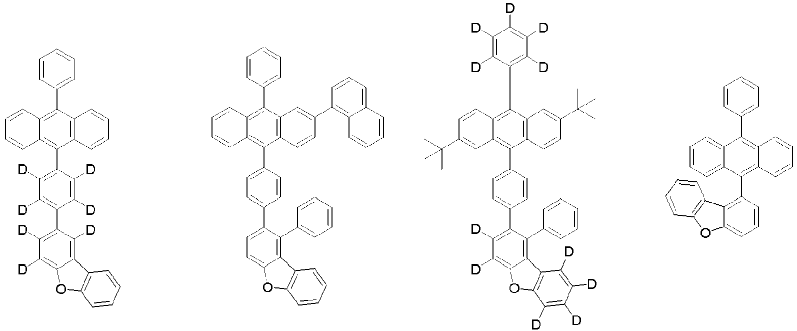

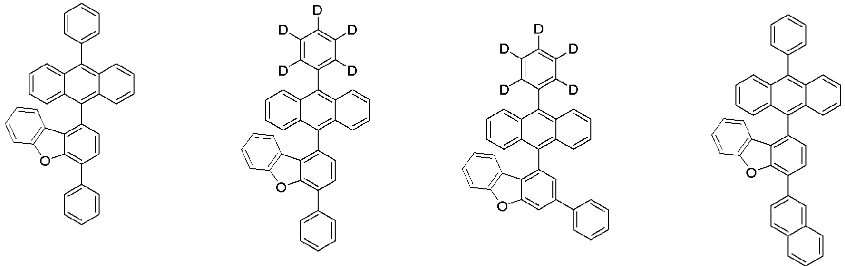

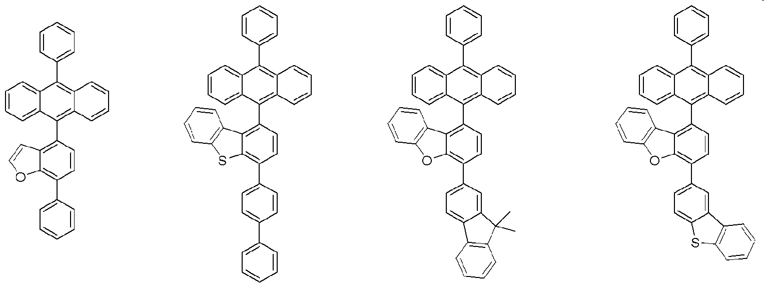

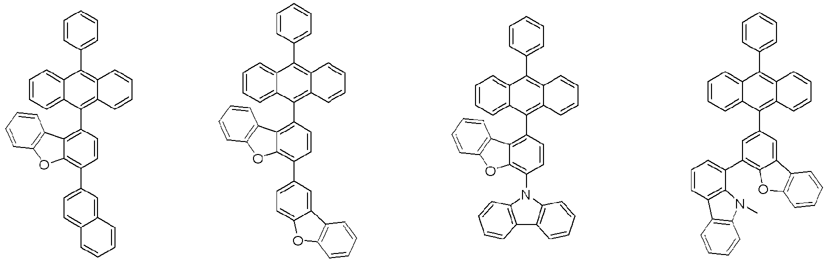

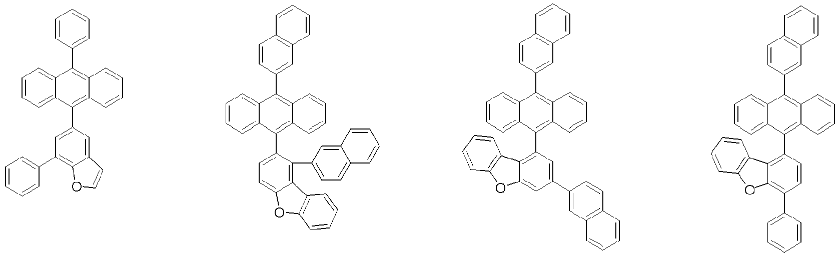

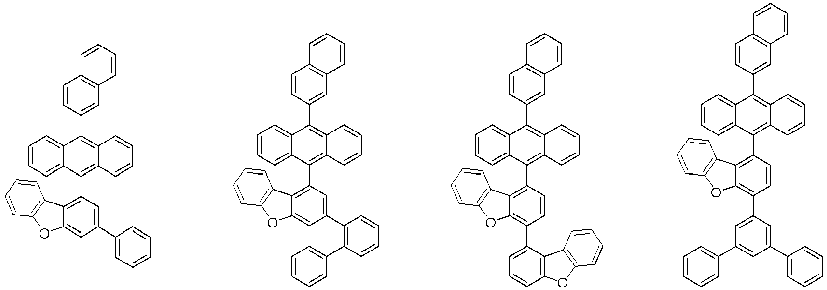

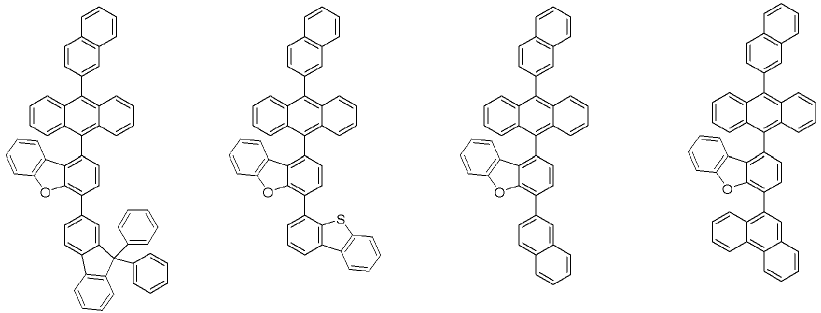

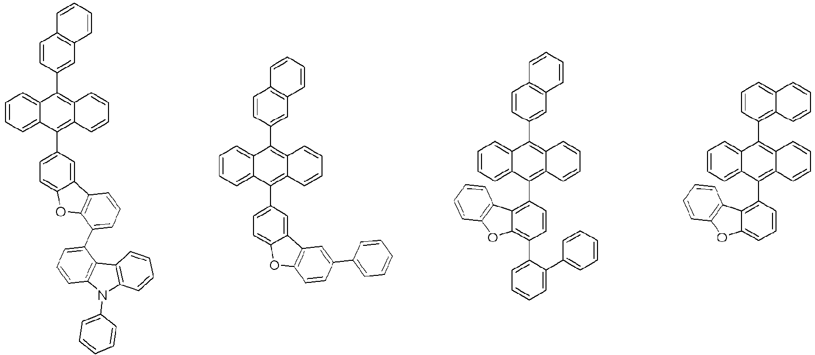

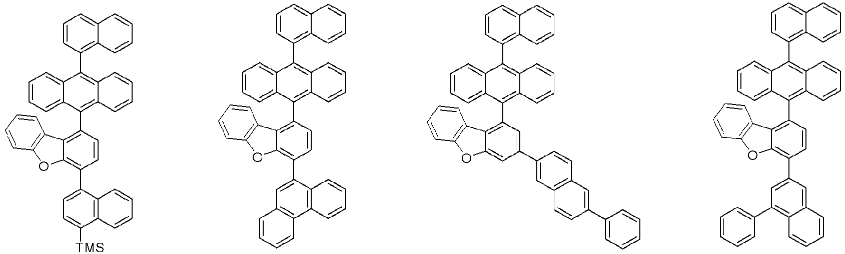

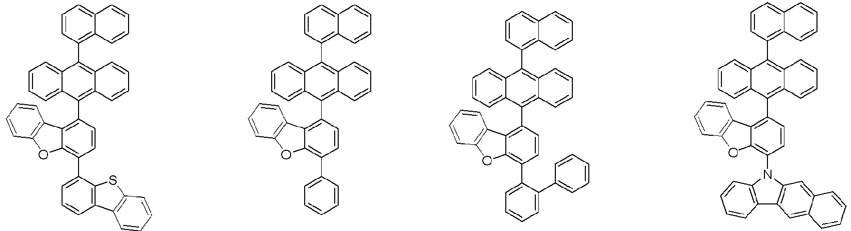

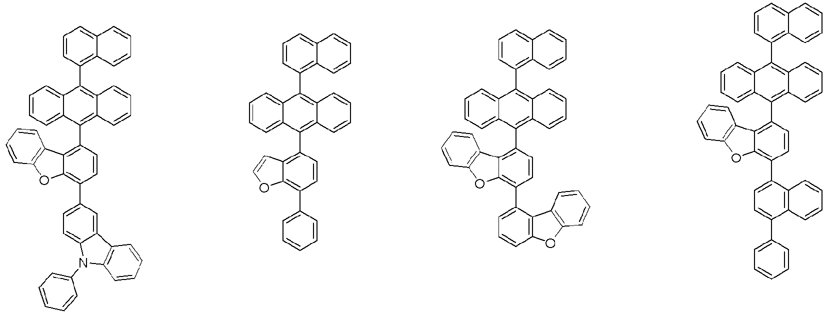

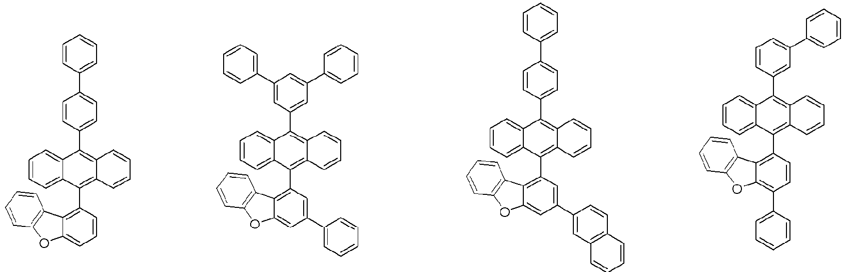

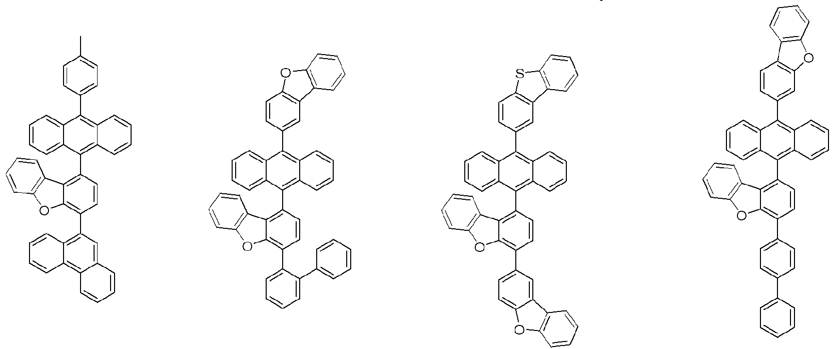

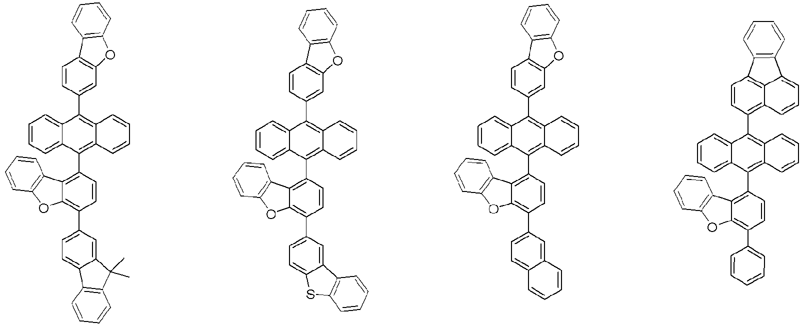

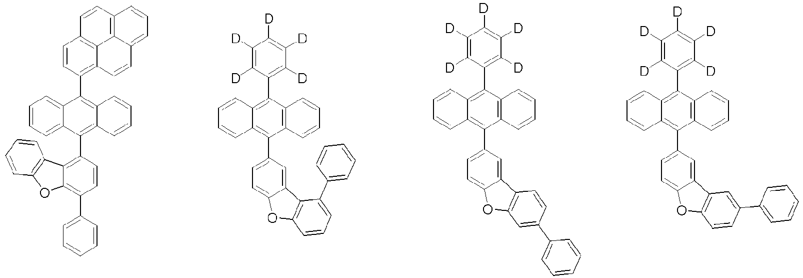

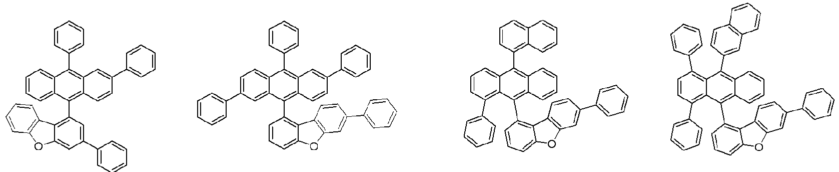

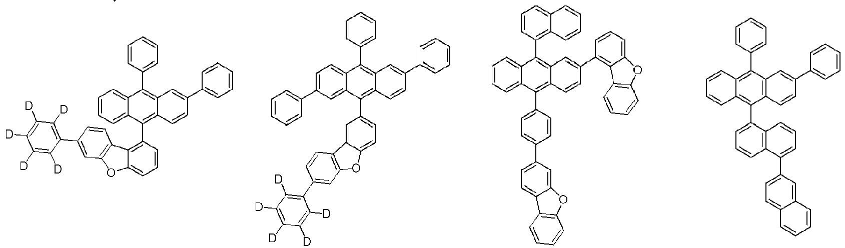

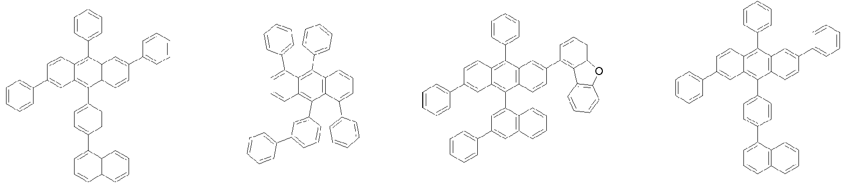

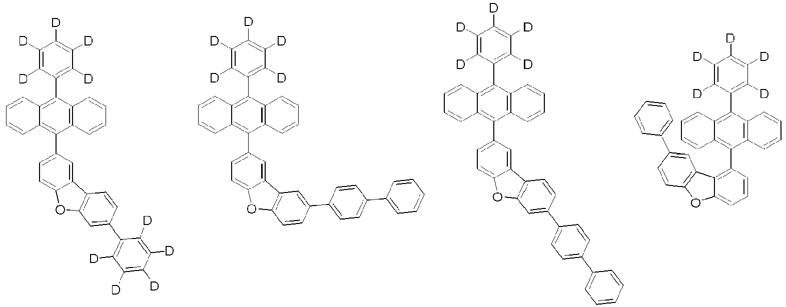

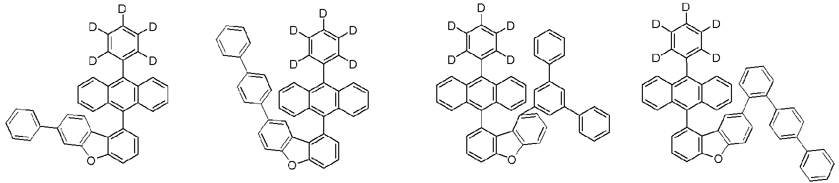

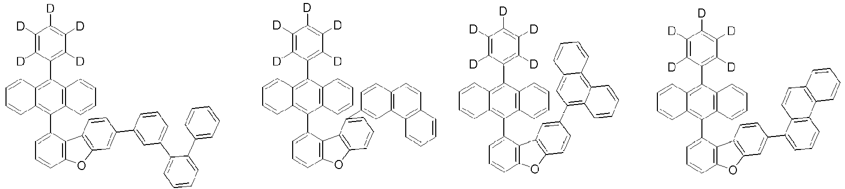

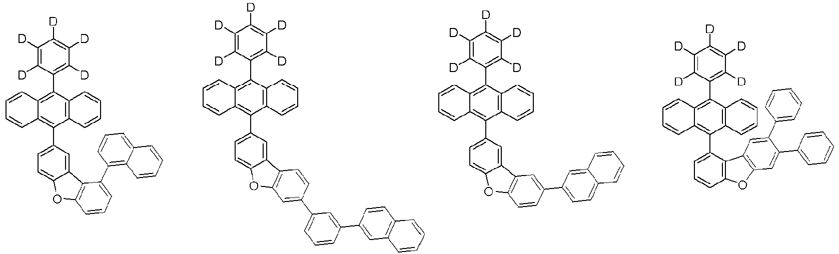

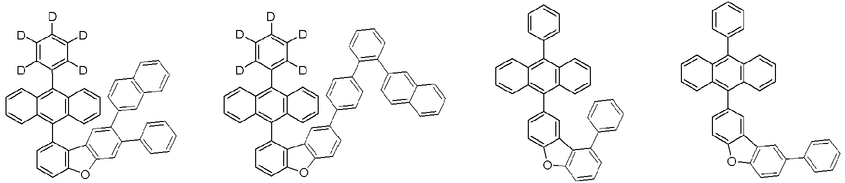

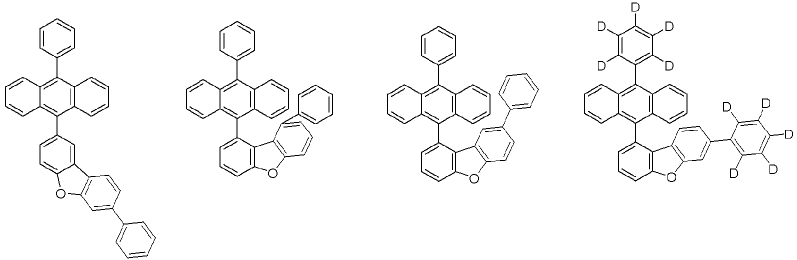

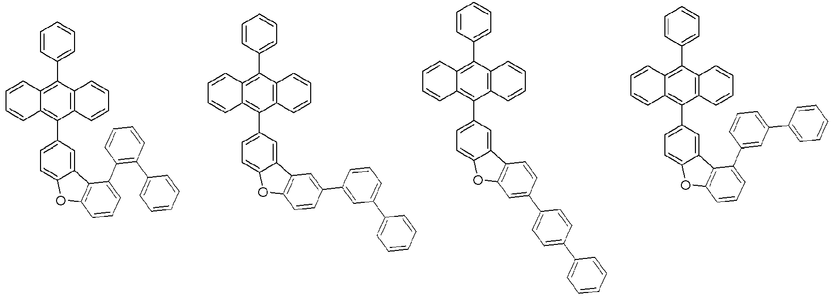

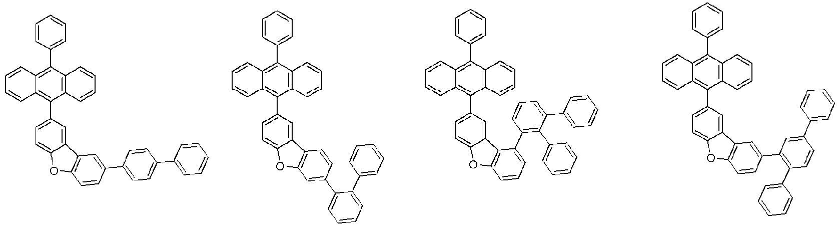

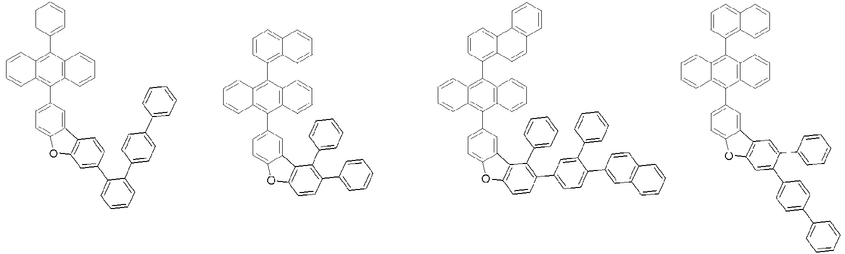

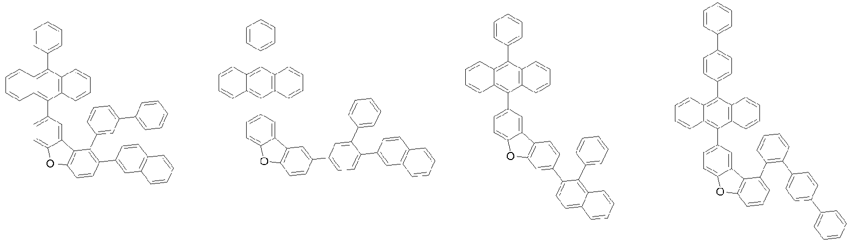

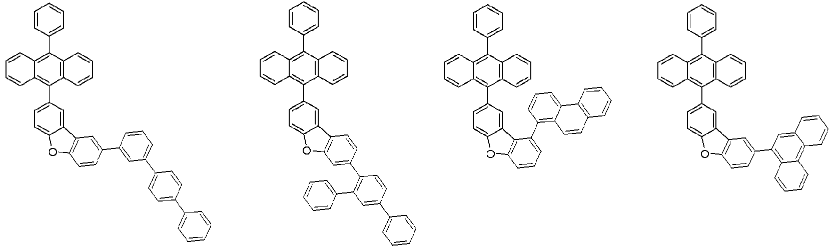

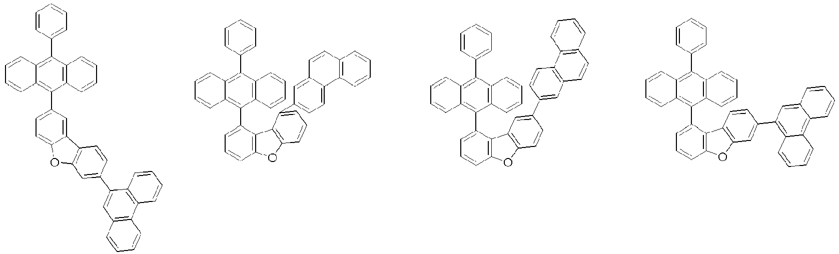

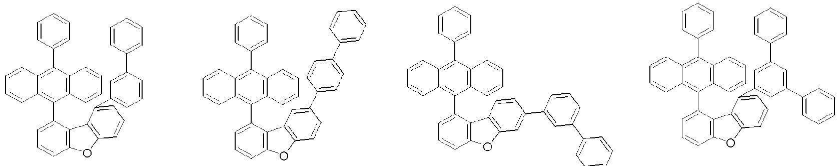

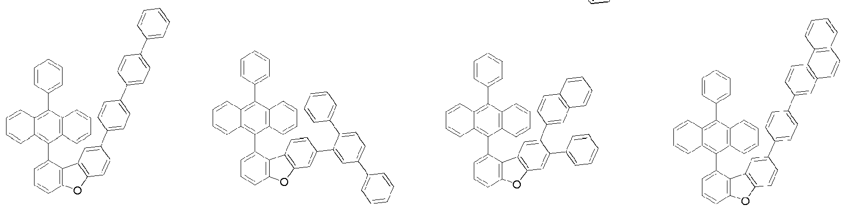

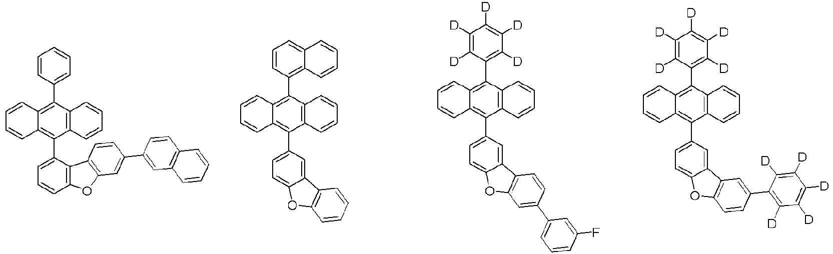

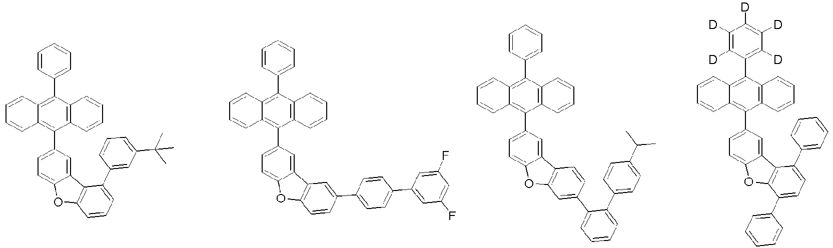

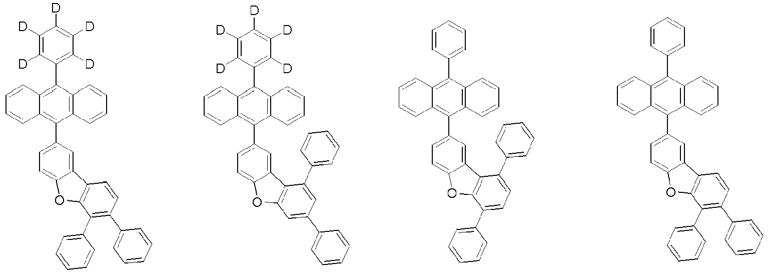

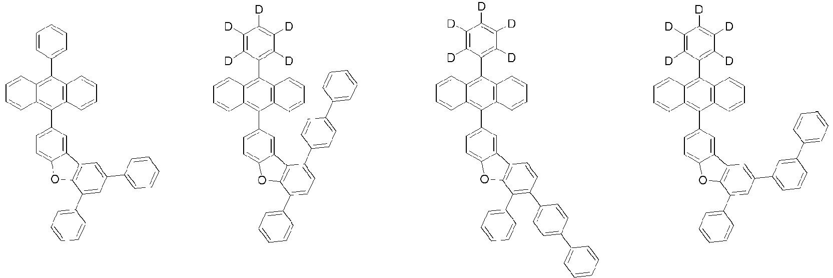

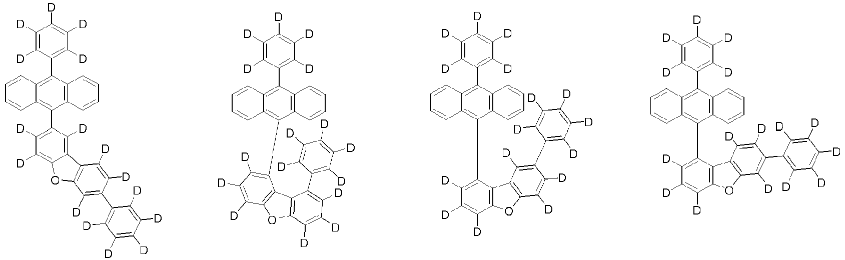

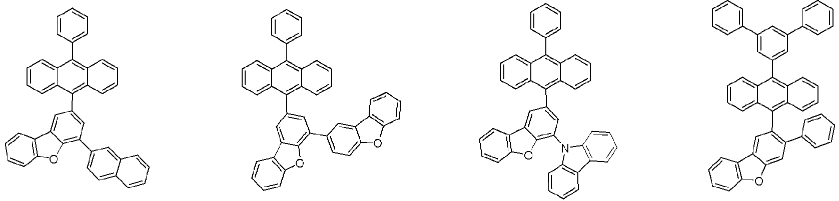

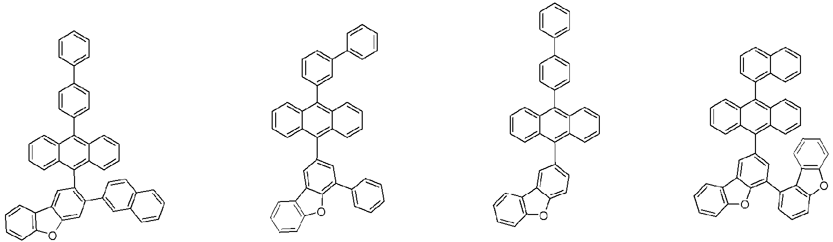

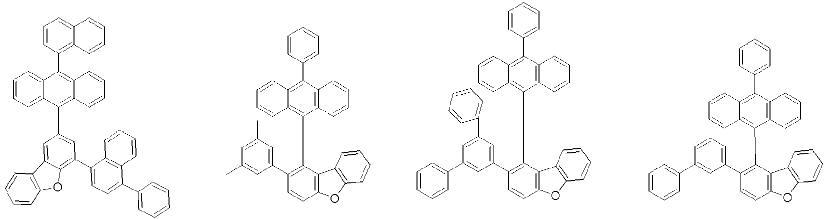

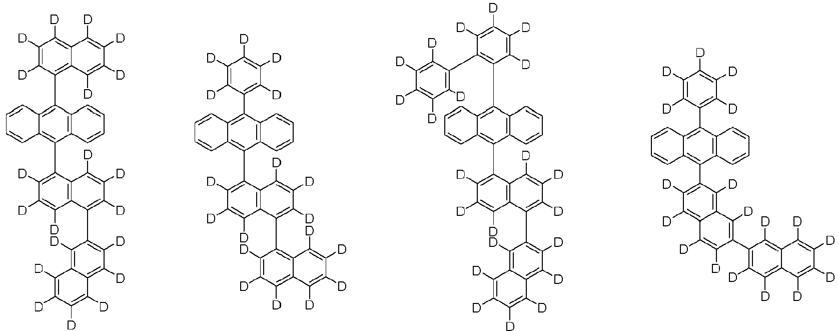

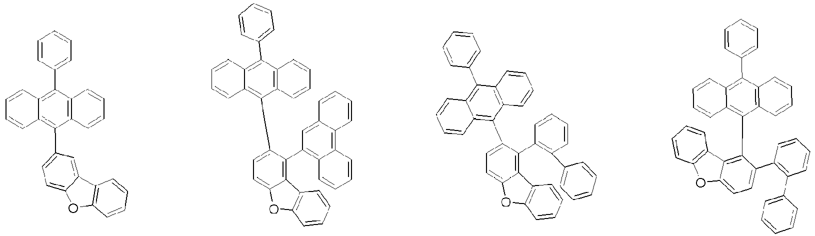

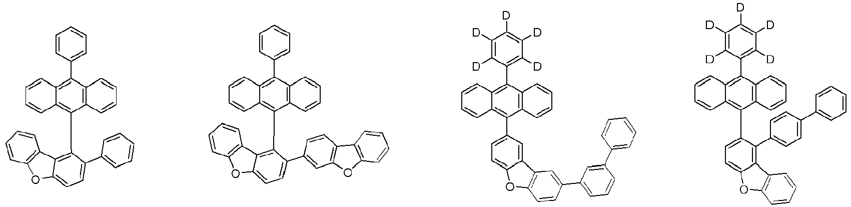

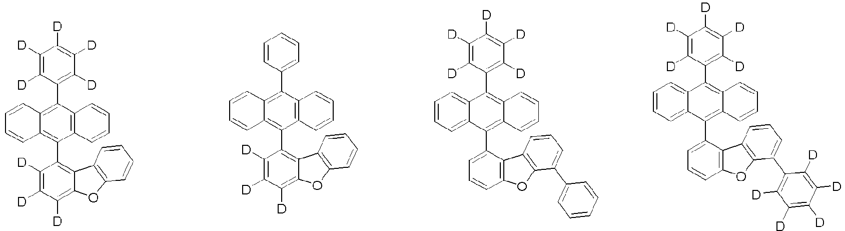

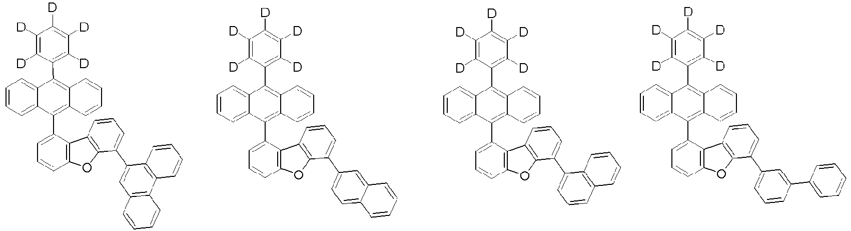

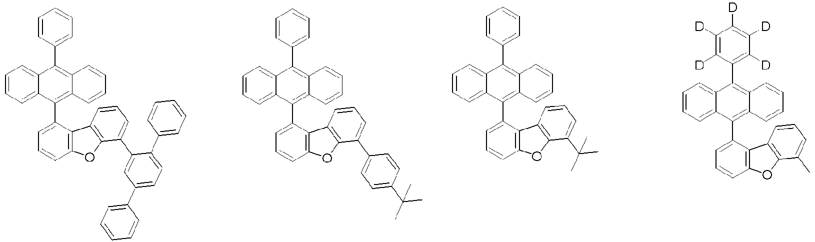

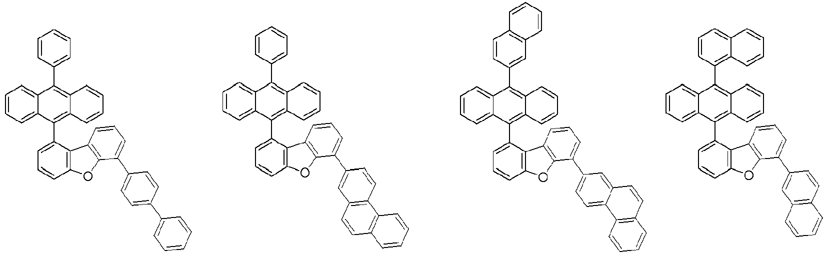

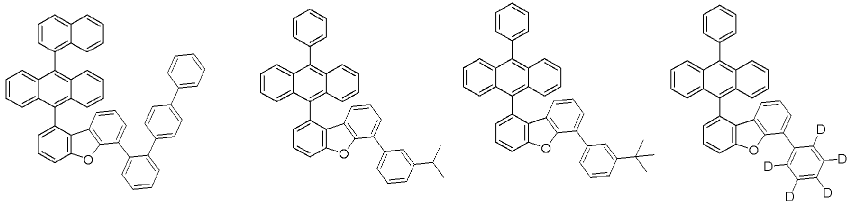

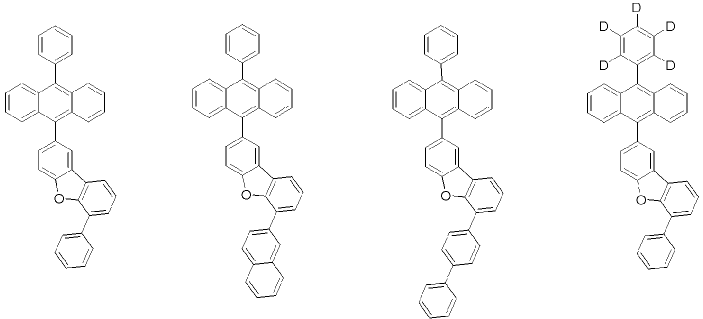

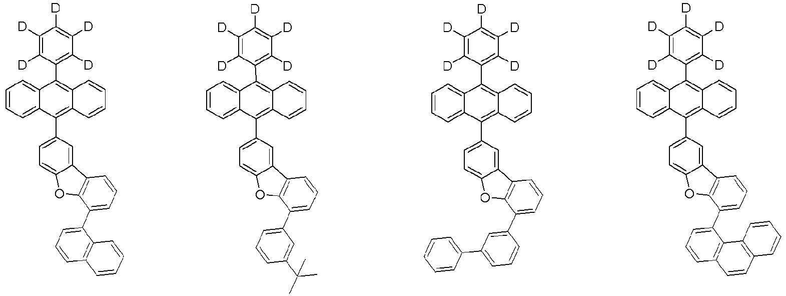

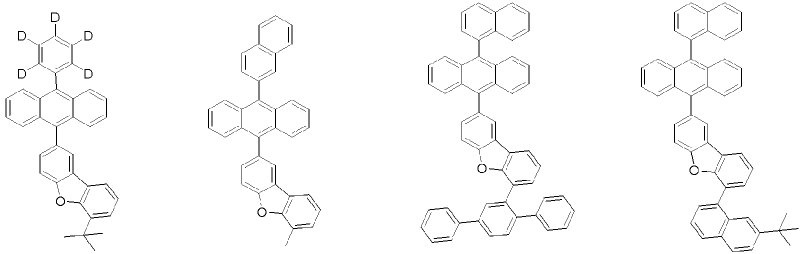

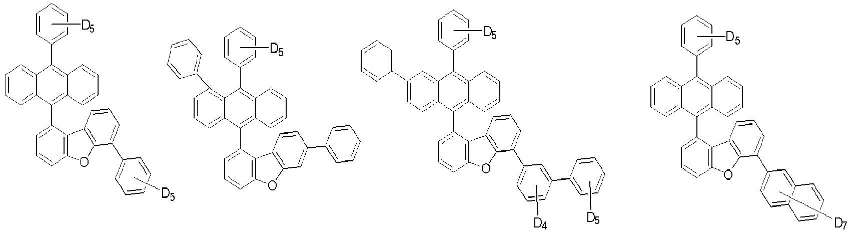

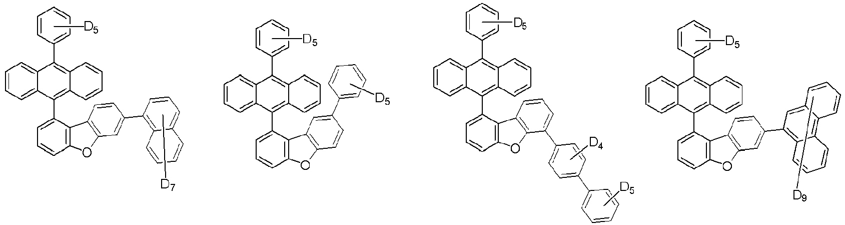

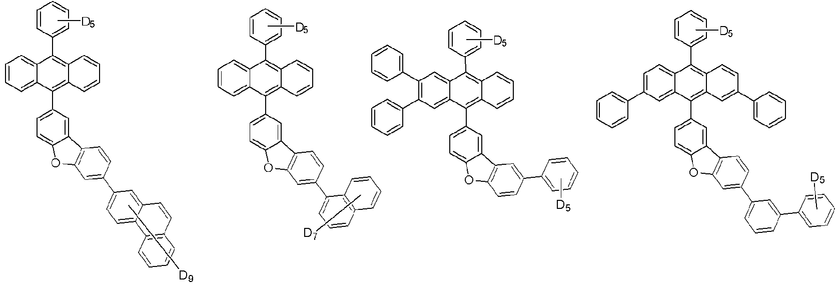

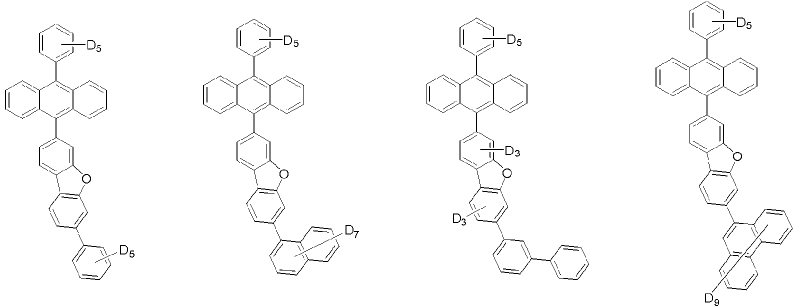

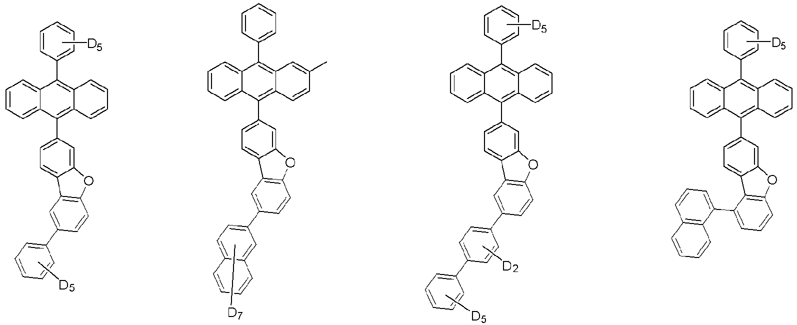

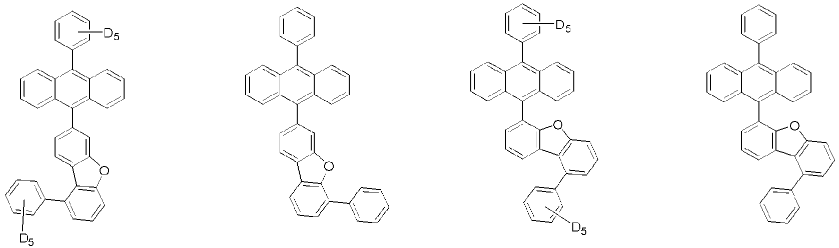

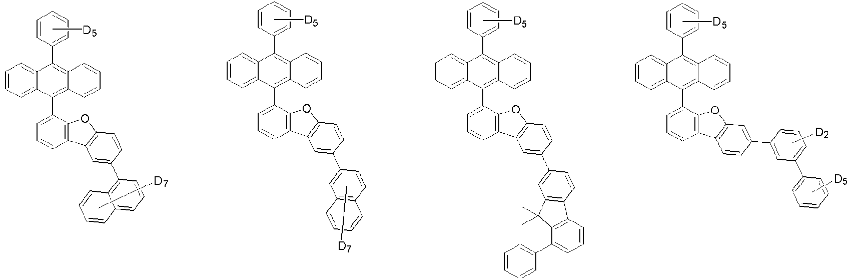

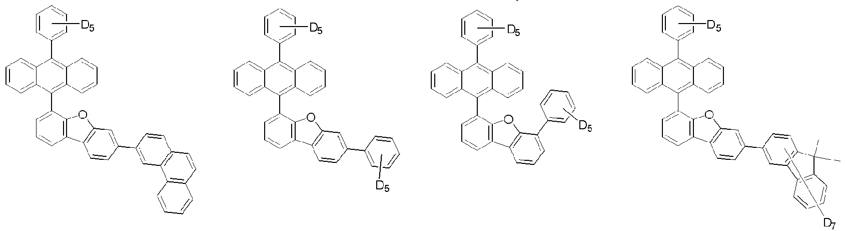

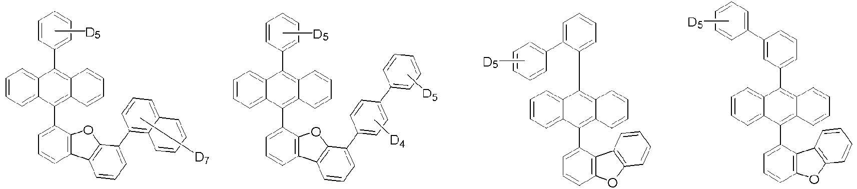

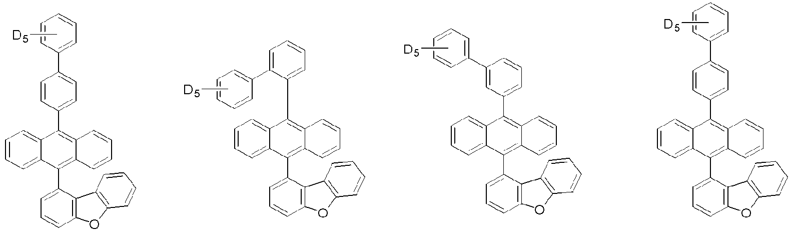

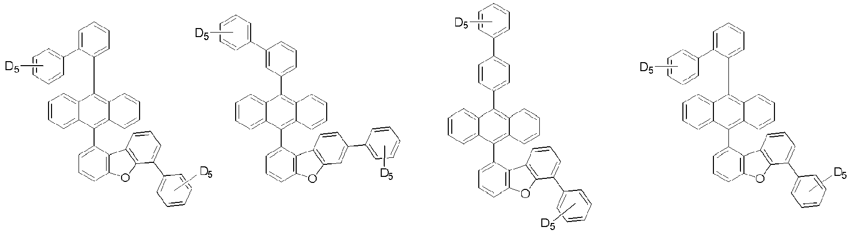

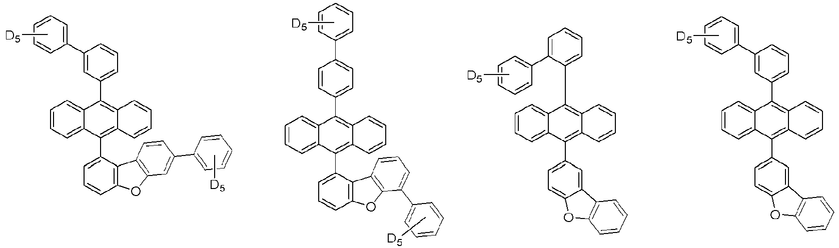

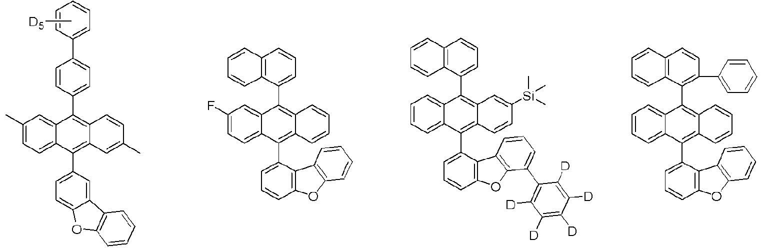

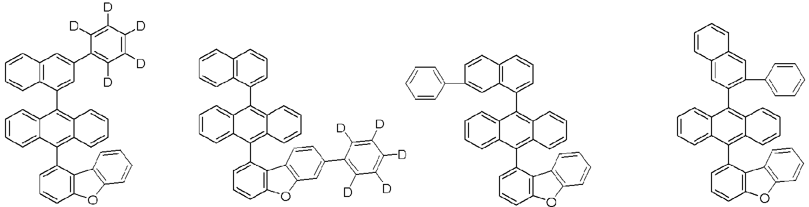

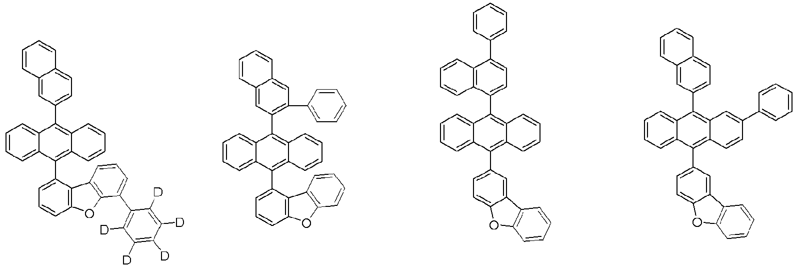

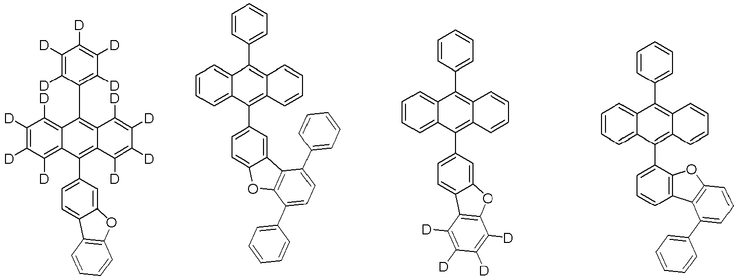

8. Organische lichtemittierende Vorrichtung nach Anspruch 6, wobei eine oder mehrere andere Wirtsverbindungen als die durch die Formel 3 dargestellte Anthracenverbindung in die lichtemittierende Schicht eingemischt oder darin gestapelt sind.

9. Organische lichtemittierende Vorrichtung nach Anspruch 2, wobei die organische lichtemittierende Vorrichtung in einem Display oder Beleuchtungssystem verwendet wird, das aus flachen Paneelen, flexiblen Paneelen, monochromatischen flachen Paneel-Beleuchtungssystemen, weißen flachen Paneel-Beleuchtungssystemen, flexiblen monochromatischen Beleuchtungssystemen, flexiblen weißen Beleuchtungssystemen, Displays für Automobilanwendungen, Displays für Virtual Reality und Displays für Augmented Reality ausgewählt ist.

## Revendications

1. Composé polycyclique choisi parmi les composés suivants 1 à 57 :

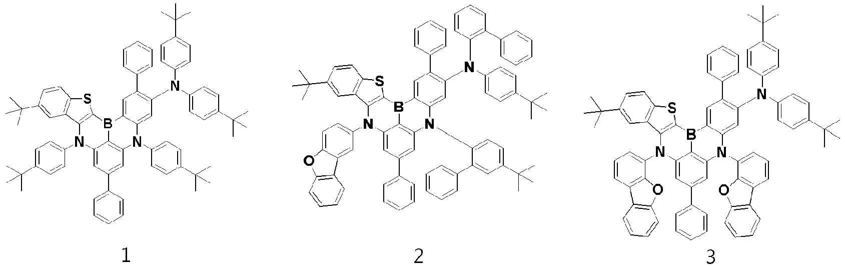

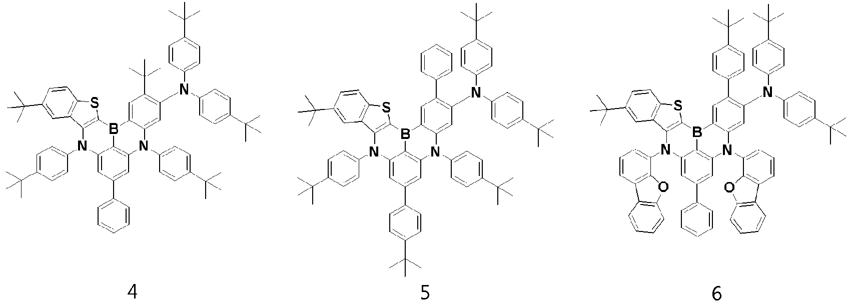

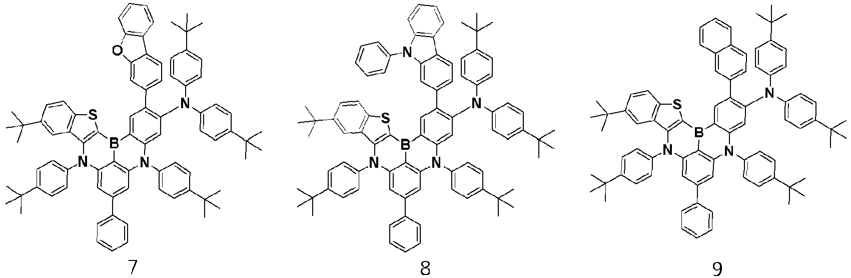

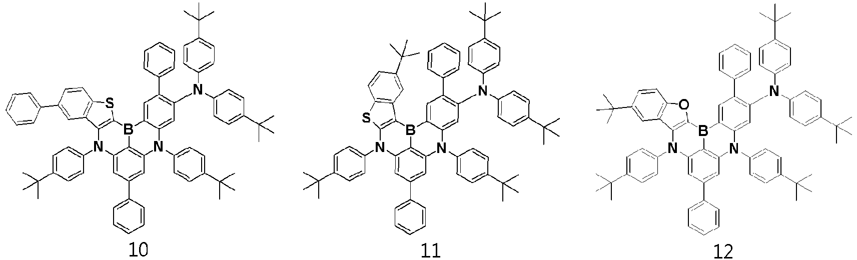

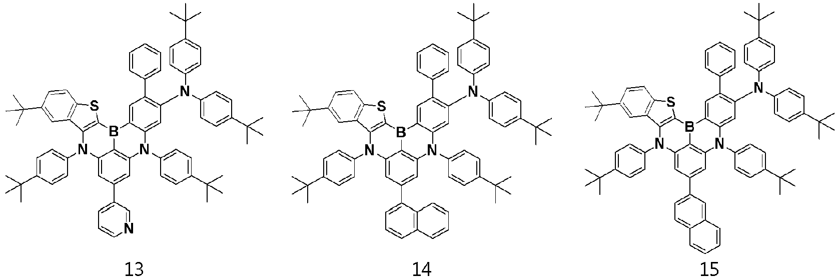

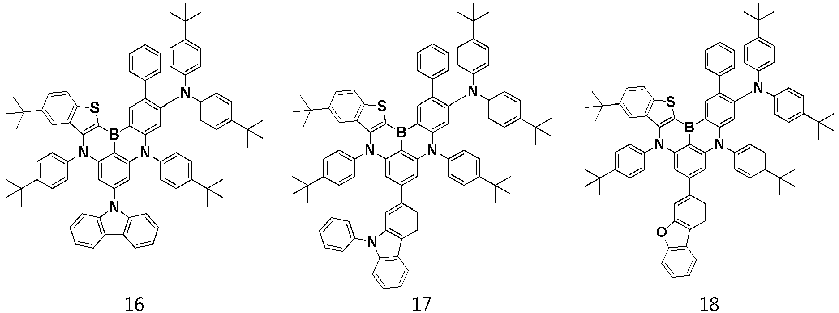

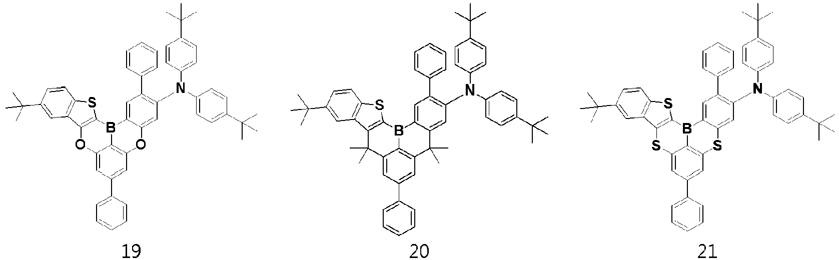

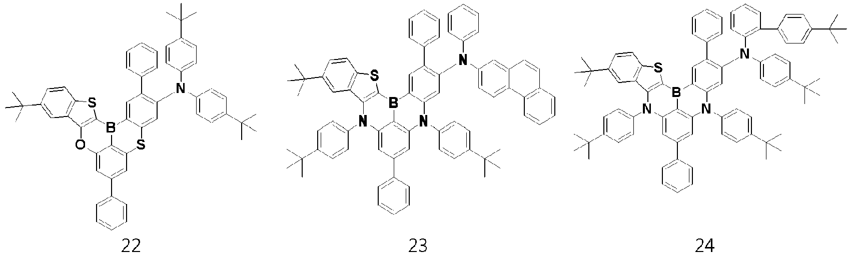

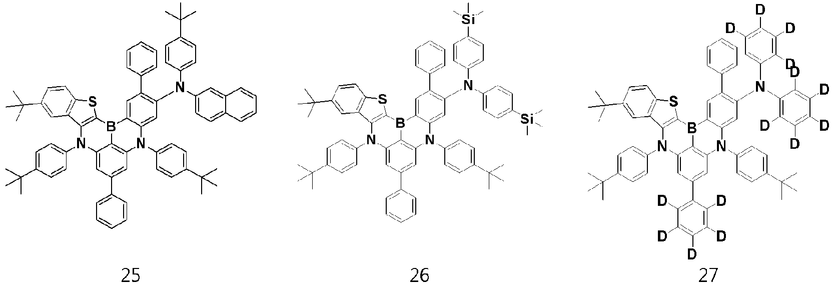

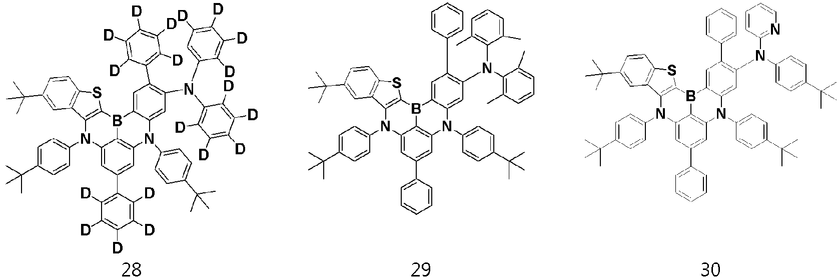

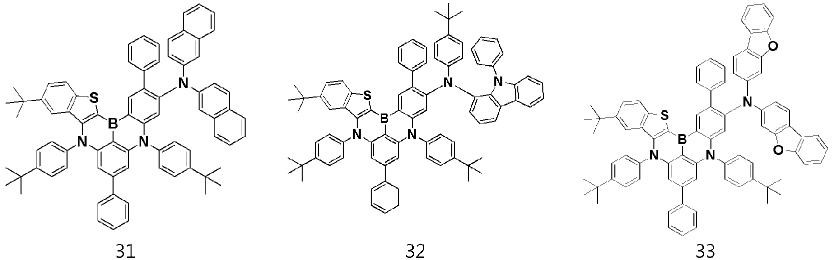

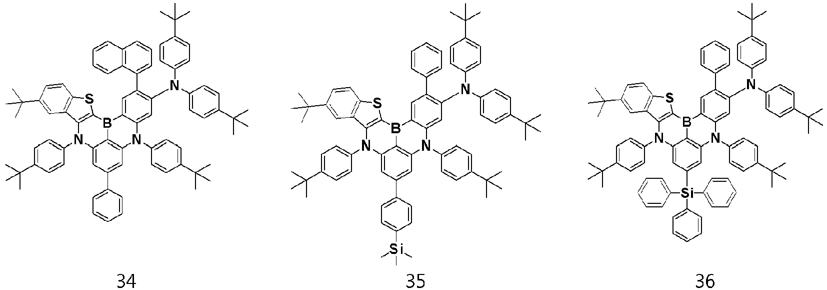

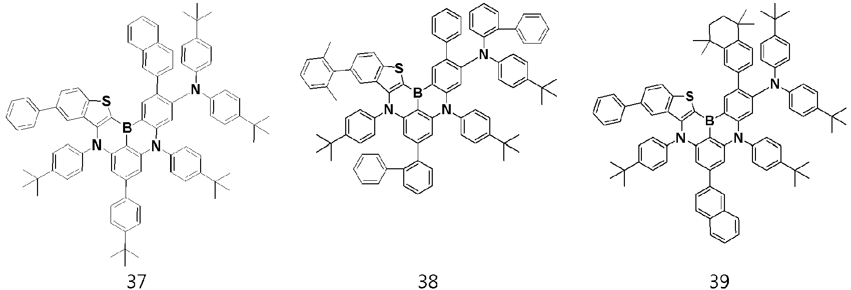

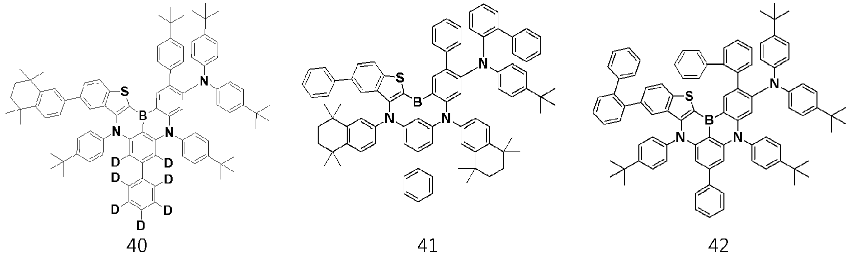

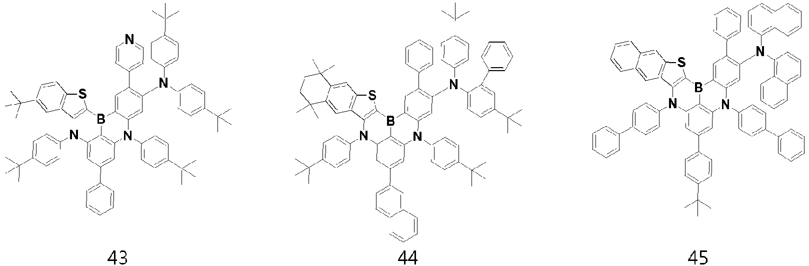

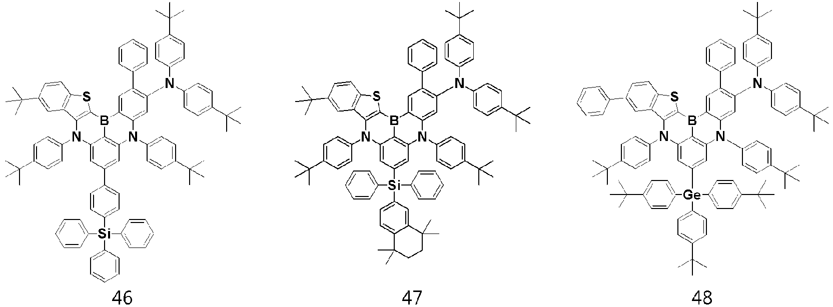

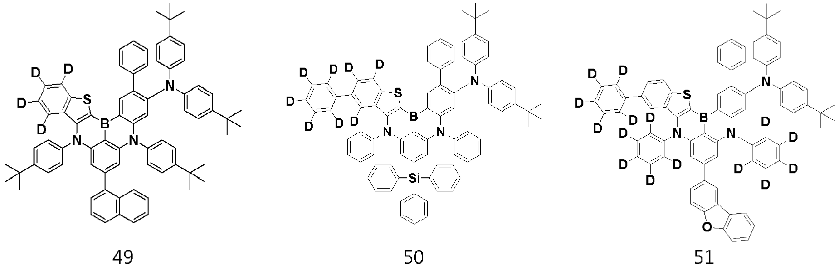

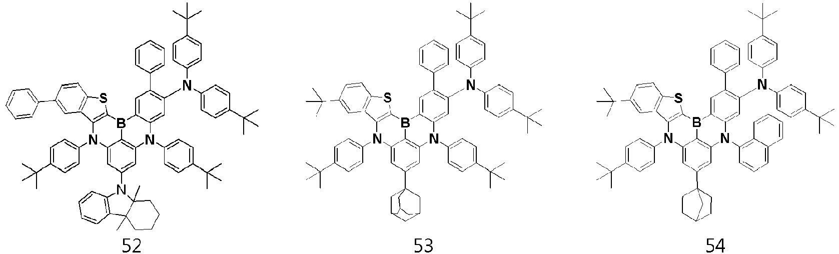

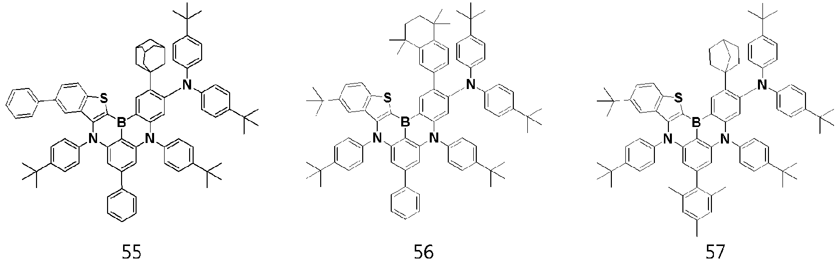

2. Dispositif électroluminescent organique comprenant une première électrode, une deuxième électrode opposée à la première électrode, et une ou plusieurs couches organiques interposées entre les première et deuxième électrodes, une couche des couches organiques comprenant le composé polycyclique selon la revendication 1.

3. Dispositif électroluminescent organique selon la revendication 2, dans lequel les couches organiques comprennent une couche d'injection de trous, une couche de transport de trous, une couche de blocage d'électrons, une couche fonctionnelle ayant des fonctions d'injection de trous et de transport de trous, une couche d'émission de lumière, une couche de transport d'électrons, une couche d'injection d'électrons, une couche de blocage de trous, et/ou une couche fonctionnelle ayant des fonctions d'injection d'électrons et de transport d'électrons.

4. Dispositif électroluminescent organique selon la revendication 3, dans lequel la couche d'émission de lumière est constituée d'un hôte et d'un dopant et le composé polycyclique selon la revendication 1 est utilisé comme dopant.

5. Dispositif électroluminescent organique selon la revendication 4, dans lequel un ou plusieurs composés dopants outre le composé polycyclique selon la revendication 1 sont mélangés ou empilés dans la couche d'émission de lumière.

6. Dispositif électroluminescent organique selon la revendication 4, dans lequel l'hôte est un composé de l'anthracène représenté par la Formule 3 : 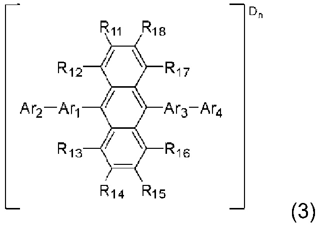 R₁₁ à R₁₈ étant identiques ou différents les uns des autres et étant chacun indépendamment choisis parmi hydrogène, deutérium, alkyle en C₁-C₃₀ substitué ou non substitué, alcynyl en C₂-C₃₀ substitué ou non substitué, alcényle en C₂-C₃₀ substitué ou non substitué, aryle en C₆-C₅₀ substitué ou non substitué, cycloalkyle en C₃-C₅₀ substitué ou non substitué, hétérocycloalkyle en C₂-C₅₀ substitué ou non substitué, hétéroaryle en C₂-C₅₀ substitué ou non substitué, des groupes cycliques dans lesquels un cycle aliphatique en C₃-C₃₀ substitué ou non substitué et un cycle aromatique en C₅-C₃₀ substitué ou non substitué sont condensés, alcoxy en C₁-C₃₀ substitué ou non substitué, aryloxy en C₆-C₃₀ substitué ou non substitué, alkylthioxy en C₁-C₃₀ substitué ou non substitué, arylthioxy en C₅-C₃₀ substitué ou non substitué, amine substituée ou non substituée, silyle substitué ou non substitué, germanium substitué ou non substitué, nitro, cyano, et halogène, Ar₁ et Ar₃ étant identiques ou différents les uns des autres et étant chacun indépendamment une liaison simple ou choisis parmi arylène en C₆-C₃₀ substitué ou non substitué, hétéroarylène en C₅-C₃₀ substitué ou non substitué, et des groupes cycliques divalents dans lesquels un cycle aliphatique en C₃-C₃₀ substitué ou non substitué et un cycle aromatique en C₅-C₃₀ substitué ou non substitué sont condensés, Ar₂ et Ar₄ étant identiques ou différents les uns des autres et étant chacun indépendamment choisis parmi aryle en C₆-C₅₀ substitué ou non substitué, cycloalkyle en C₃-C₃₀ substitué ou non substitué, hétérocycloalkyle en C₃-C₃₀ substitué ou non substitué, hétéroaryle en C₂-C₅₀ substitué ou non substitué, et des groupes cycliques dans lesquels un cycle aliphatique en C₃-C₃₀ substitué ou non substitué et un cycle aromatique en C₅-C₃₀ substitué ou non substitué sont condenses, Dₙ représentant le nombre d'atomes de deutérium remplaçant les atomes d'hydrogène, et n étant un nombre entier de 0 à 60.

7. Dispositif électroluminescent organique selon la revendication 6, dans lequel le composé représenté par la Formule 3 est choisi parmi les composés suivants :

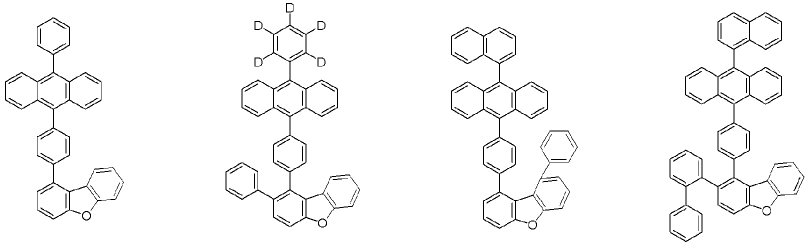

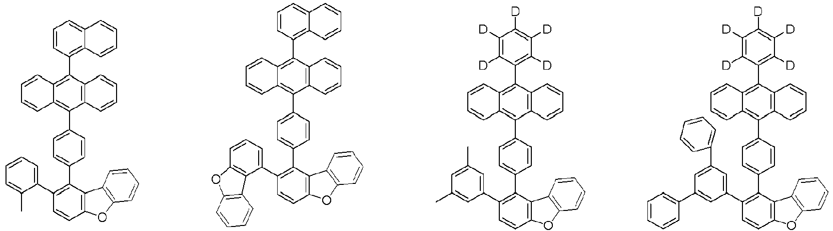

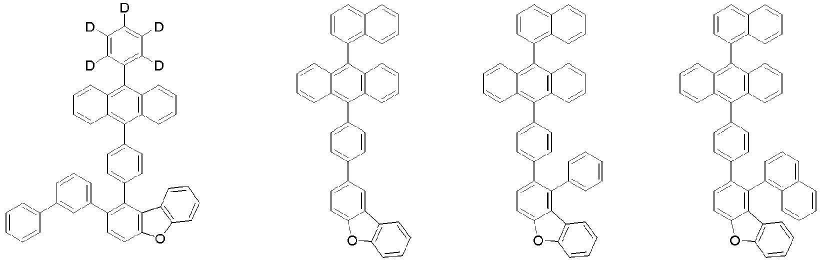

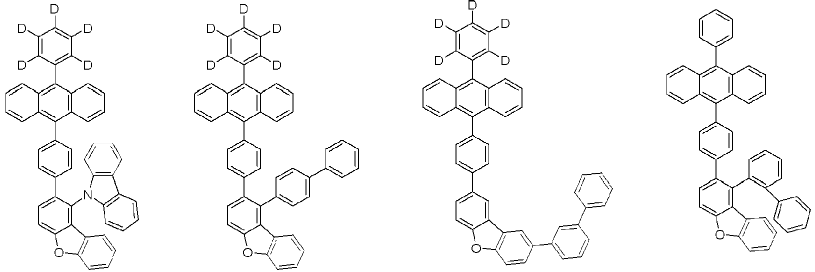

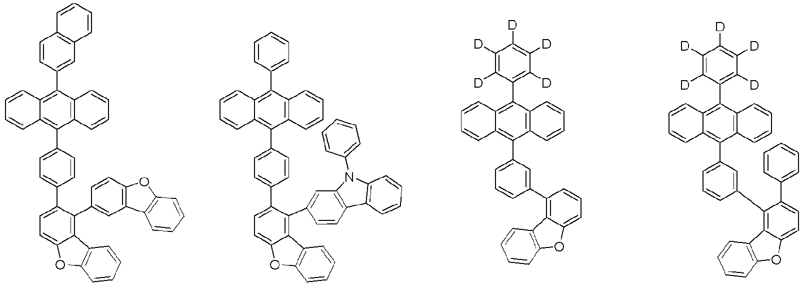

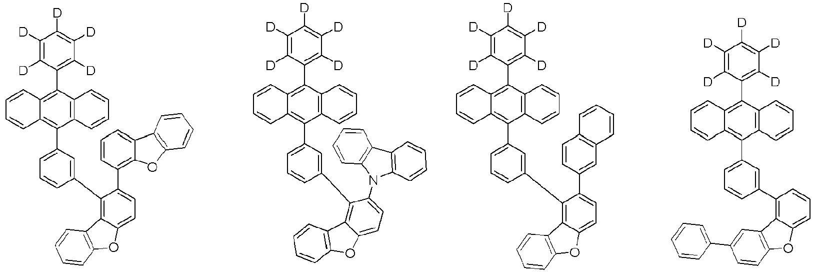

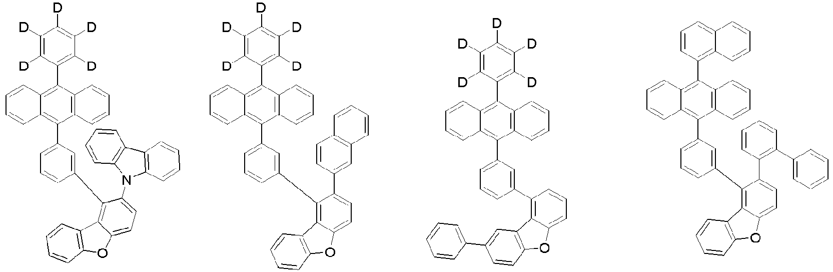

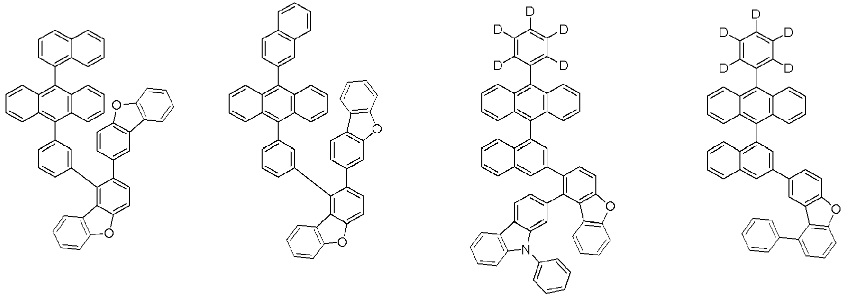

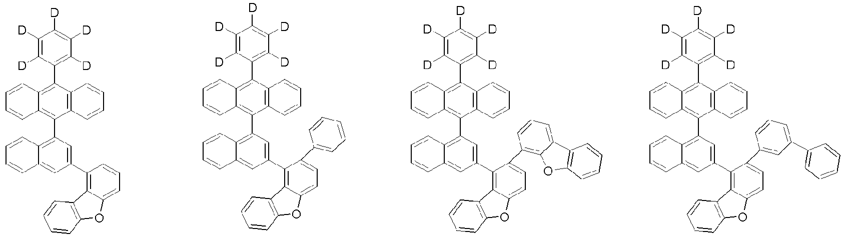

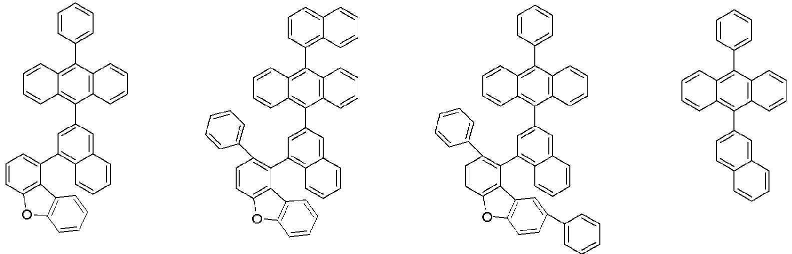

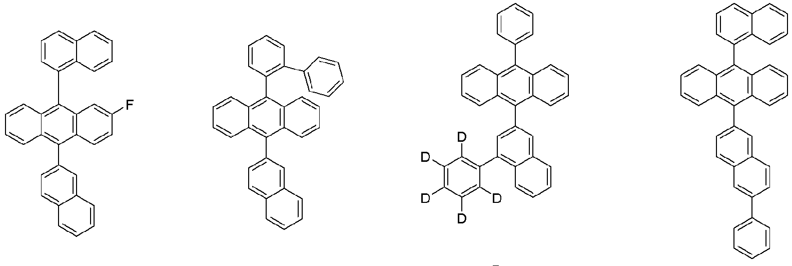

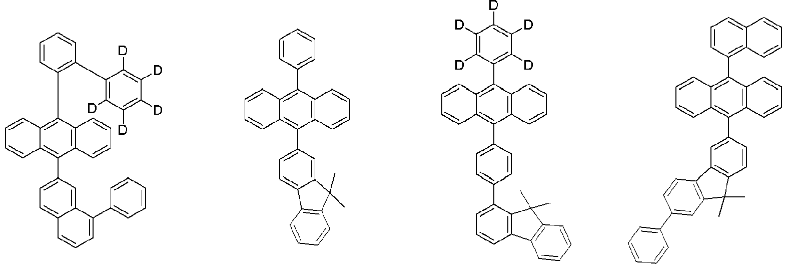

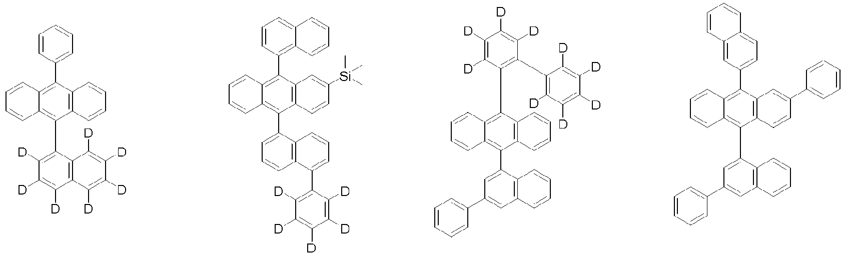

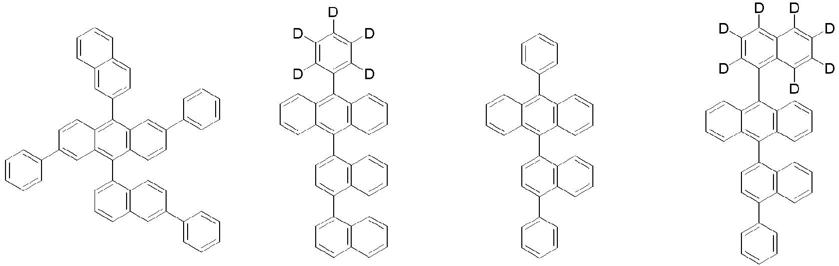

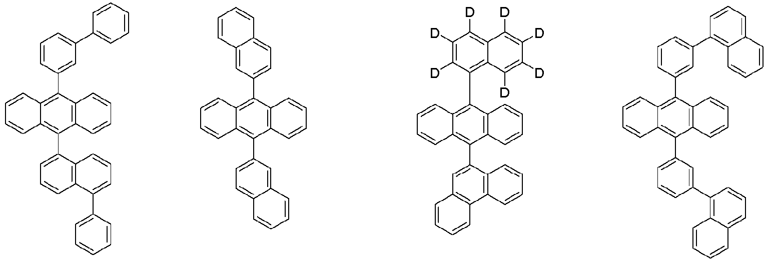

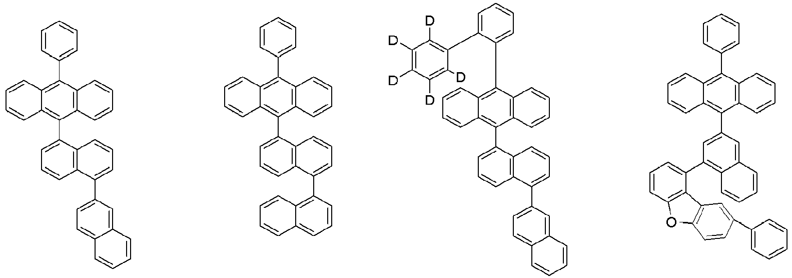

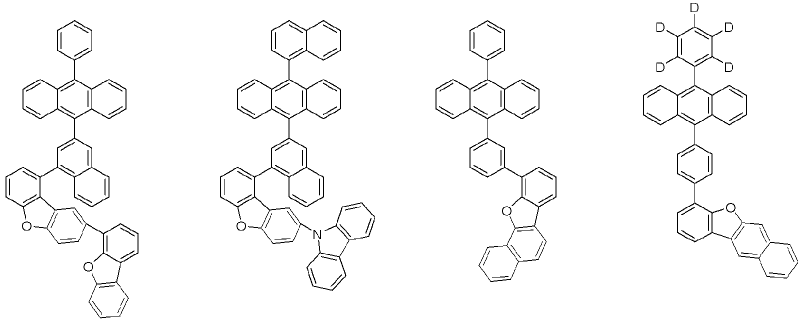

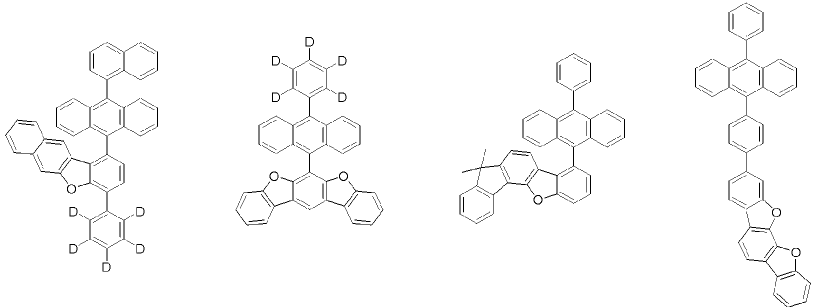

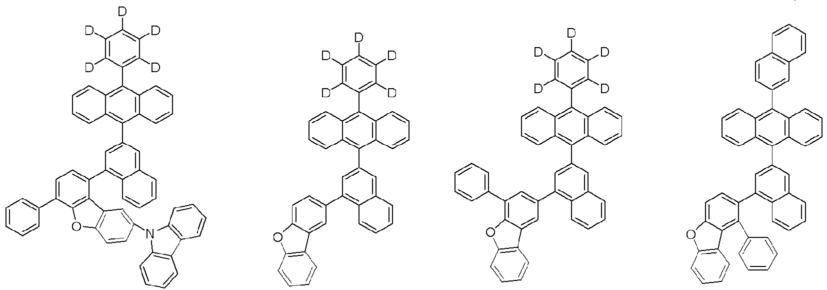

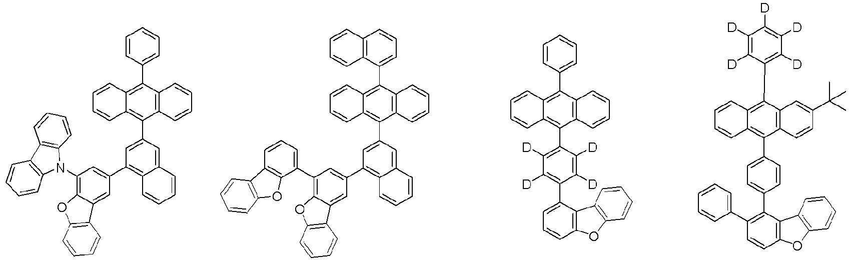

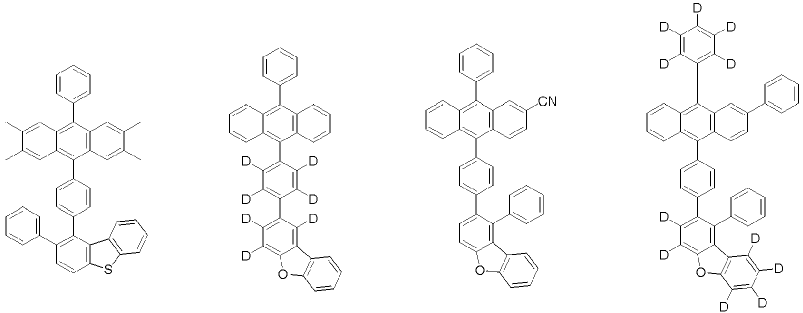

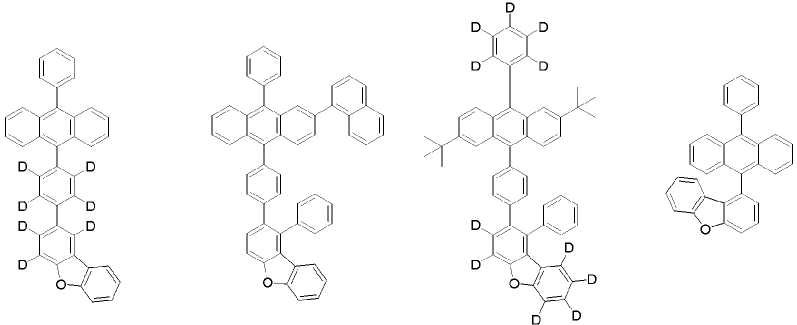

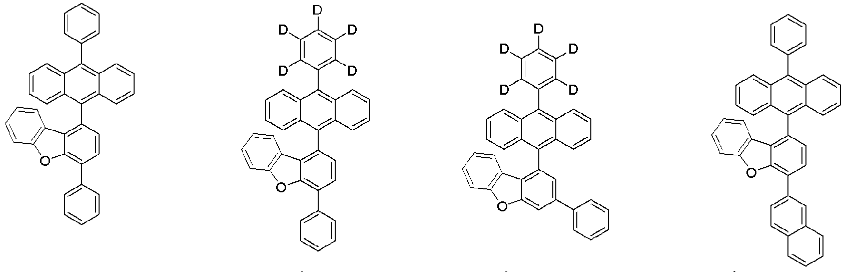

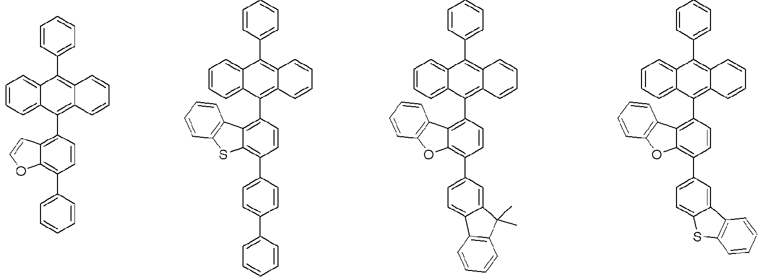

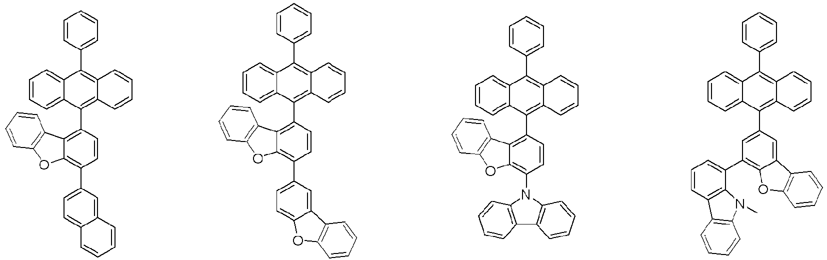

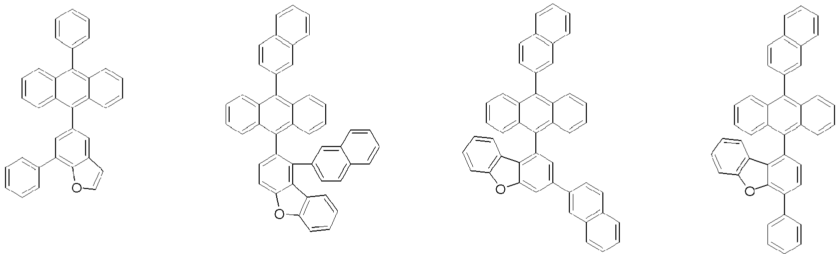

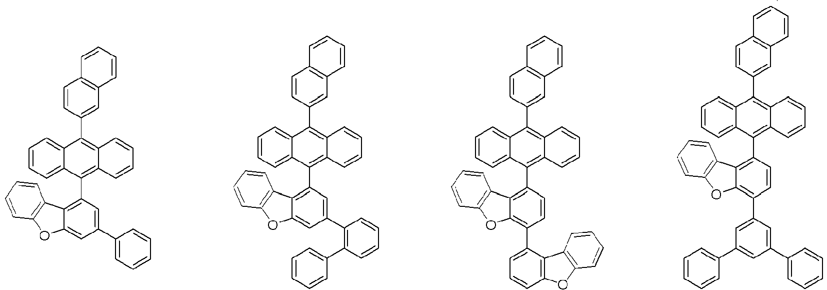

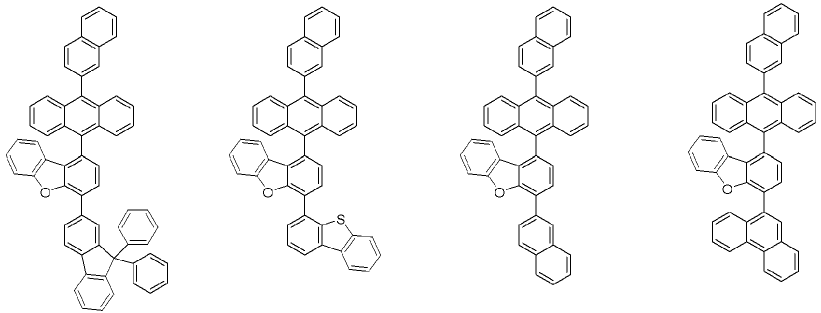

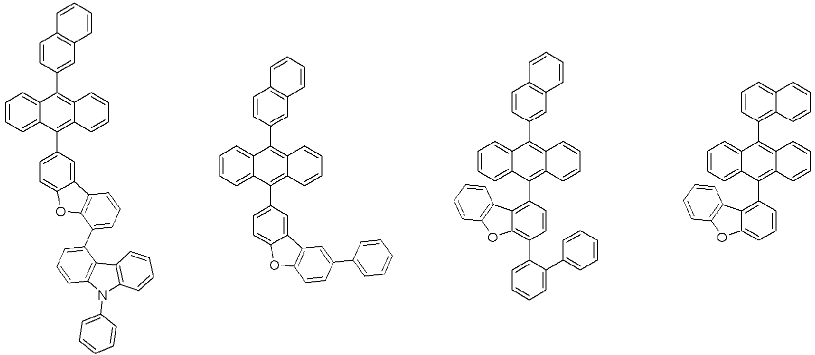

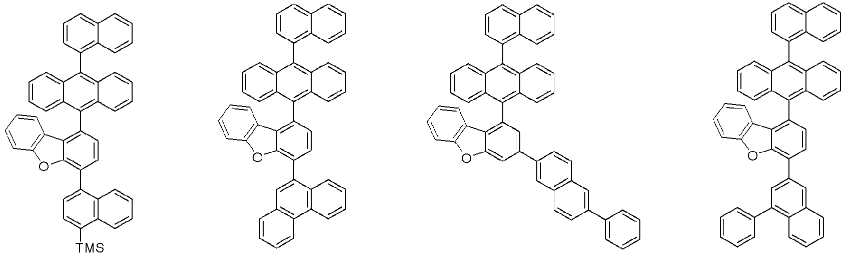

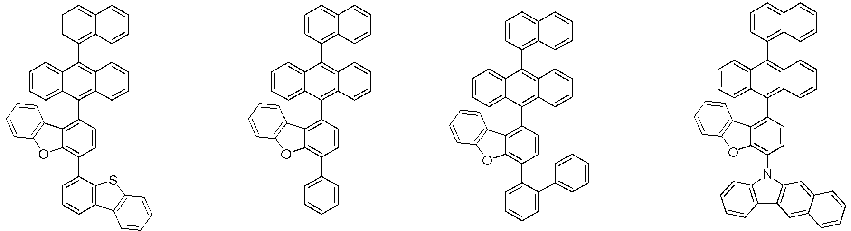

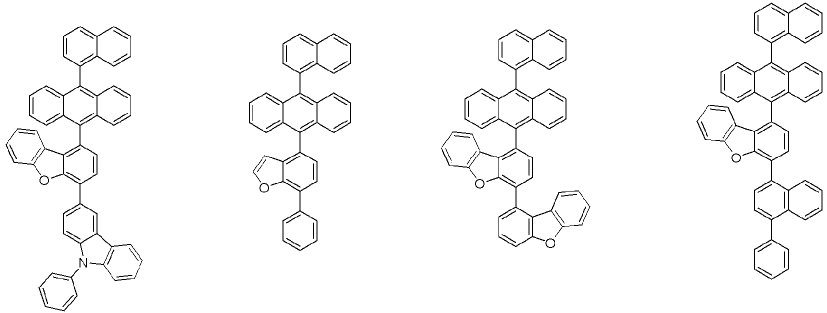

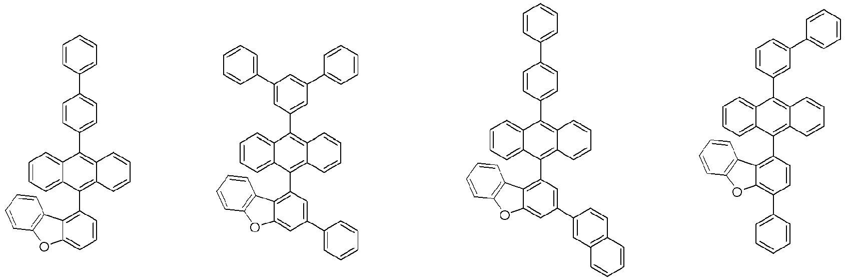

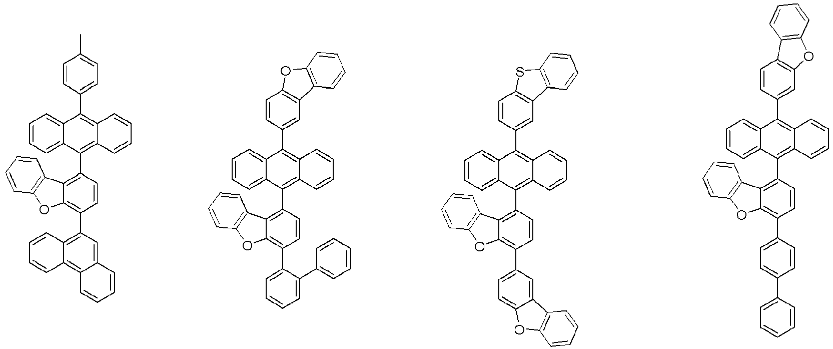

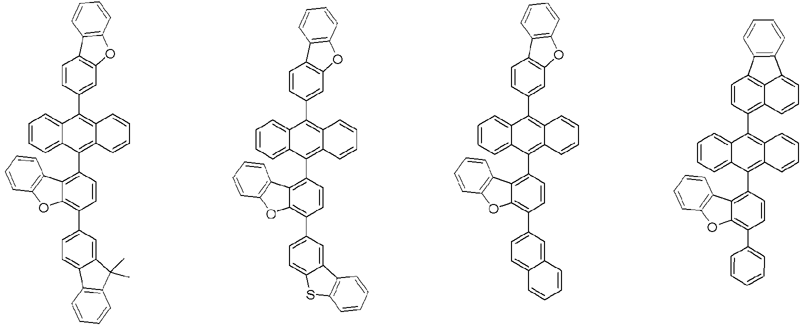

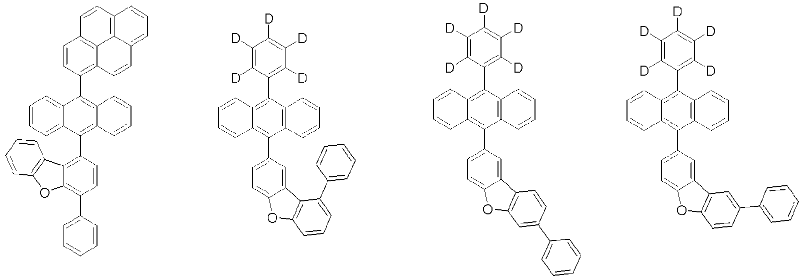

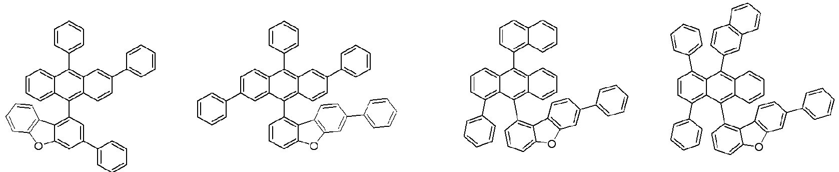

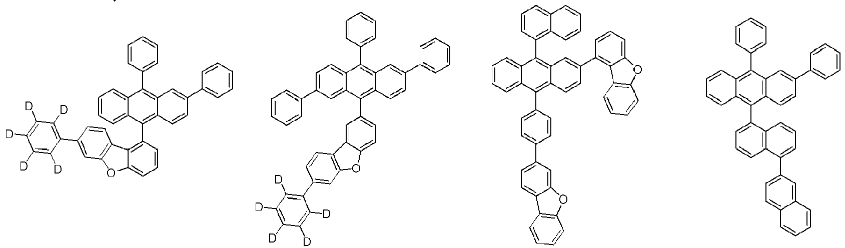

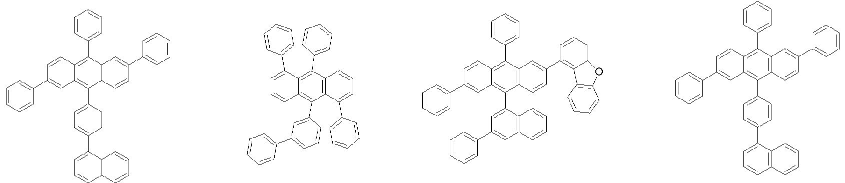

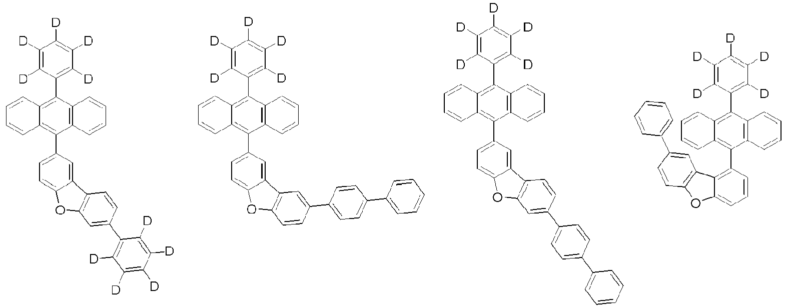

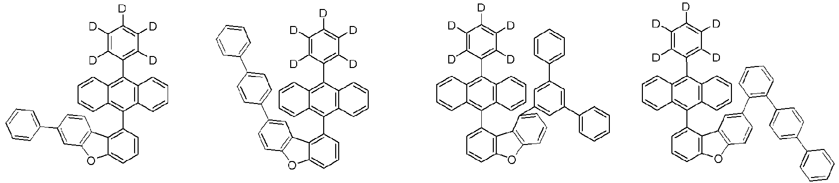

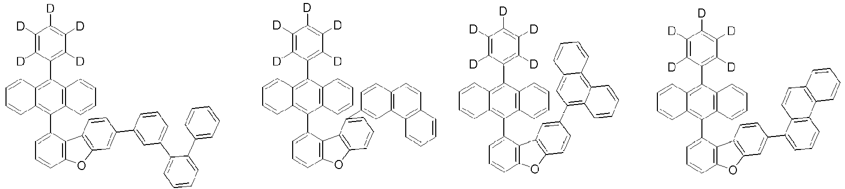

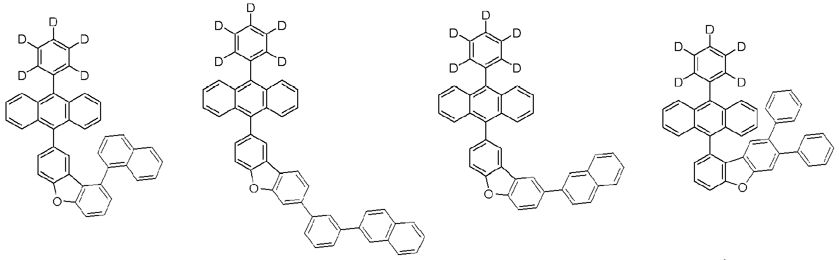

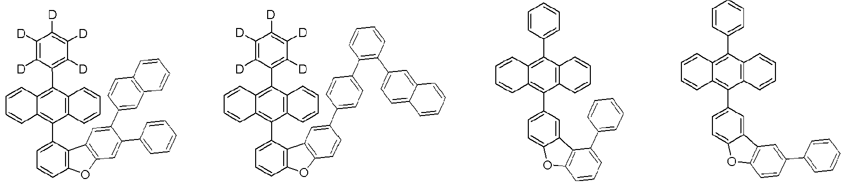

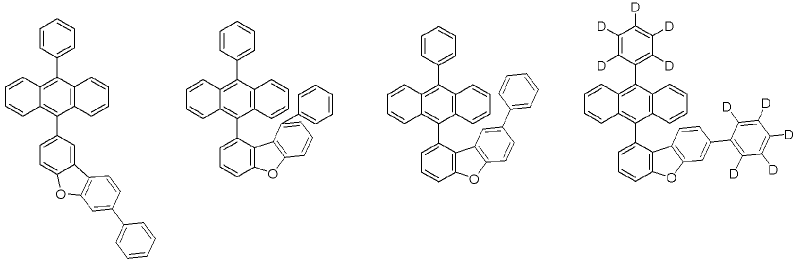

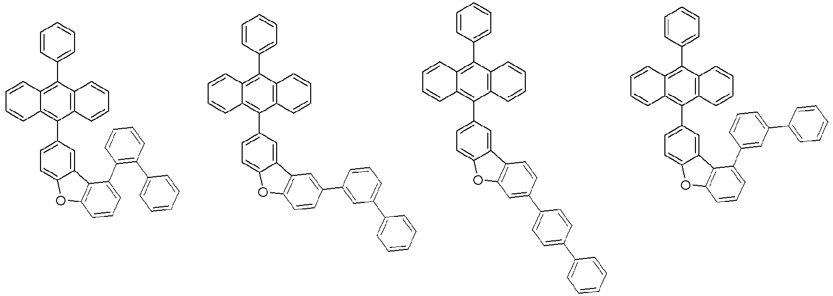

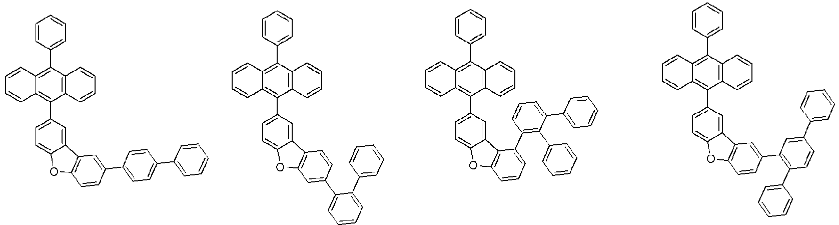

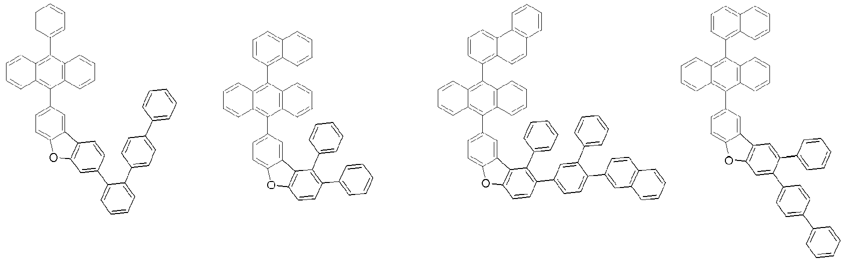

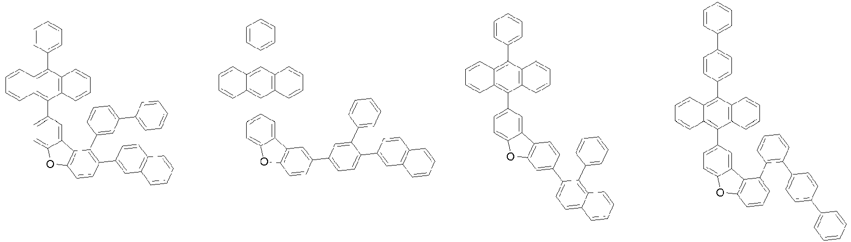

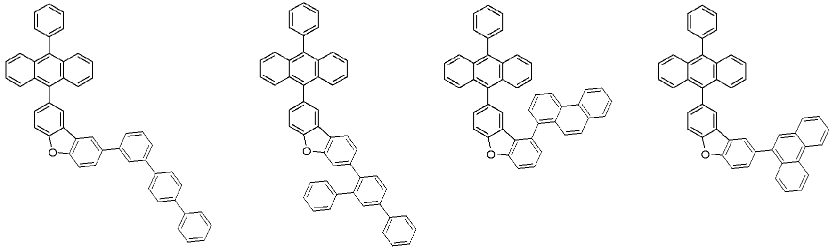

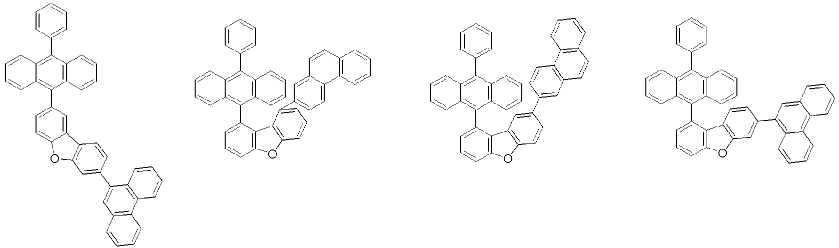

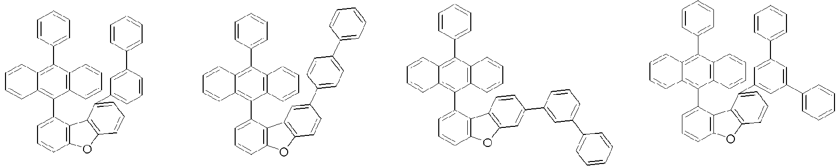

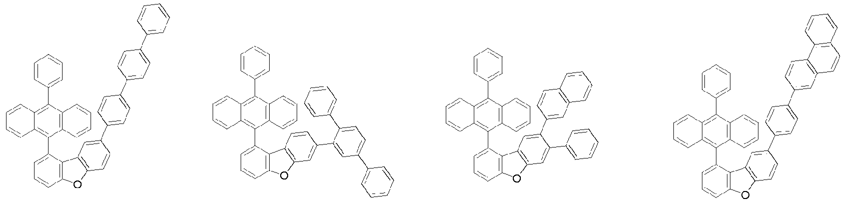

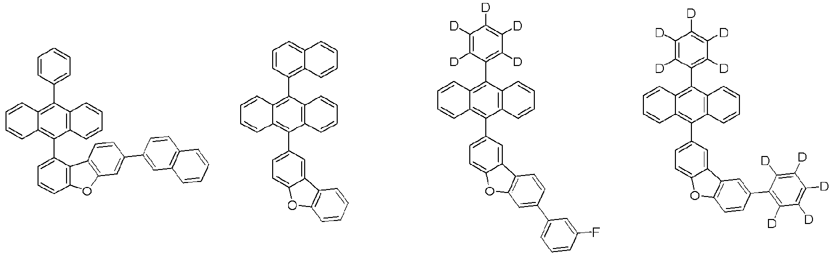

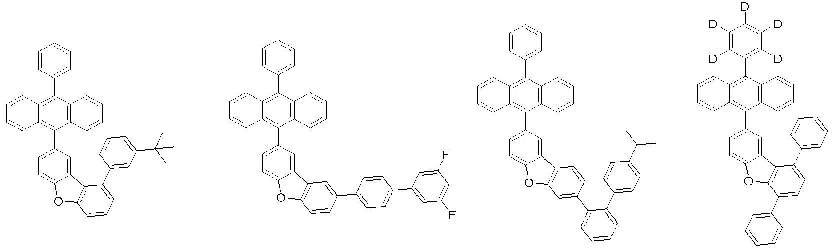

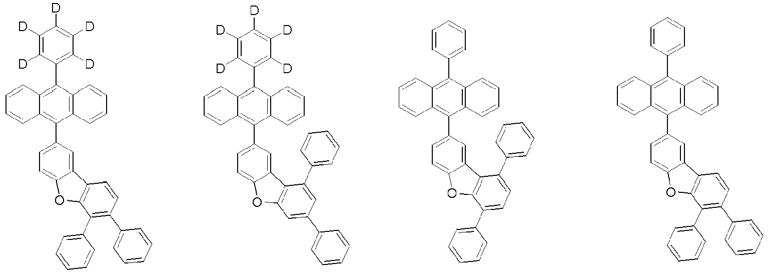

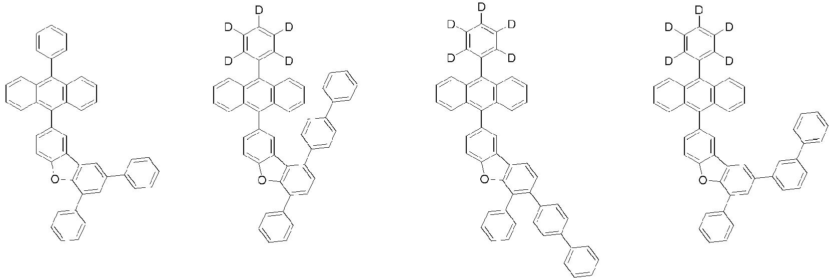

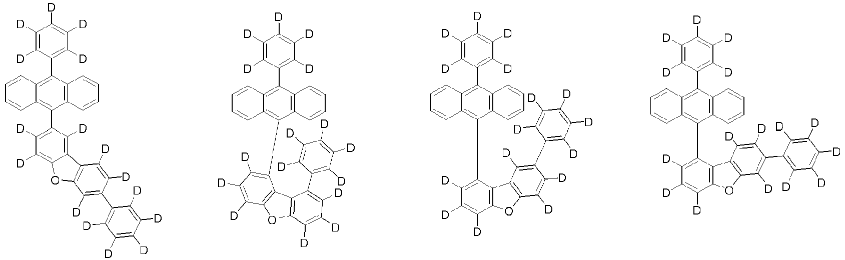

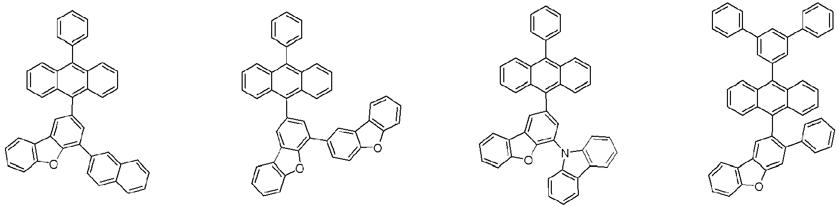

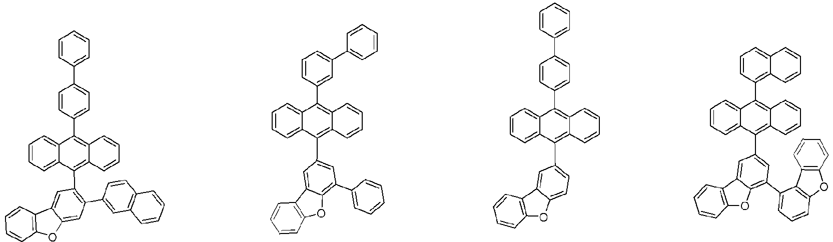

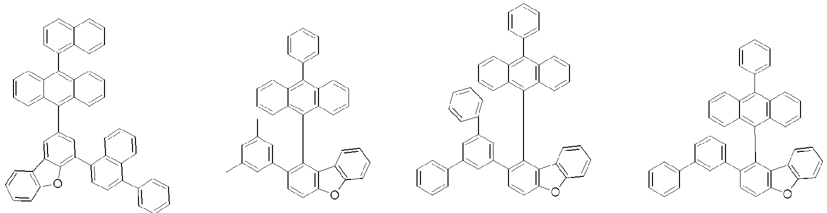

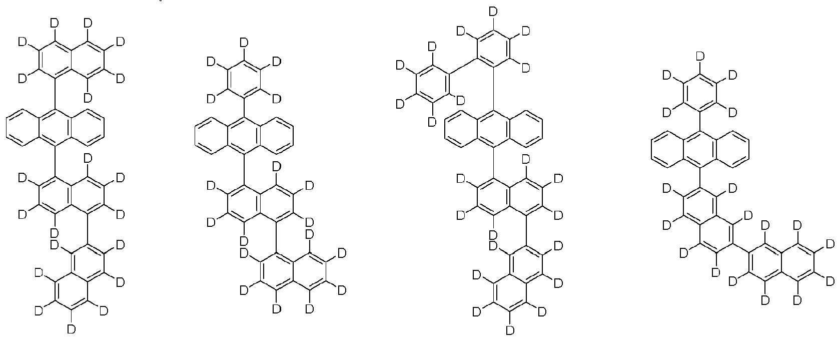

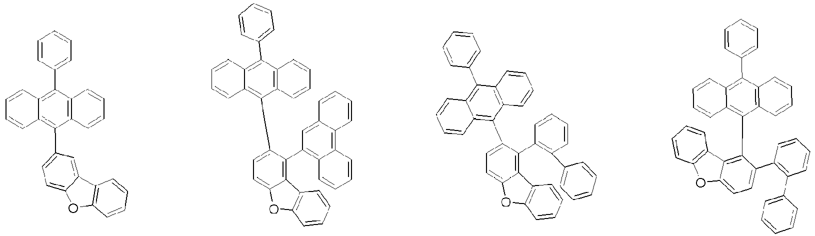

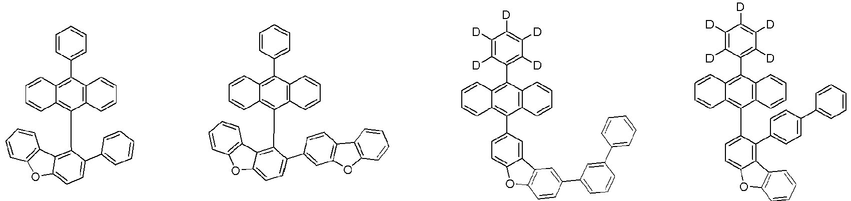

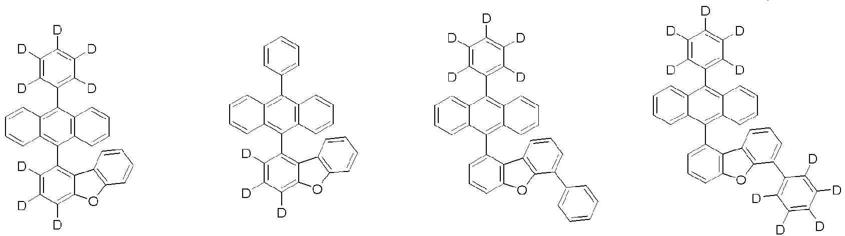

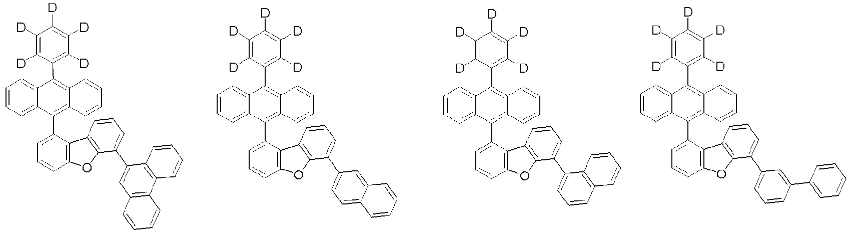

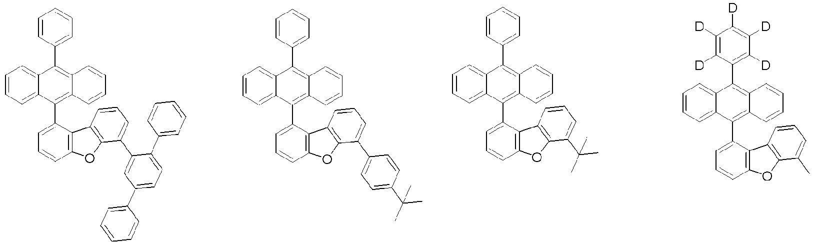

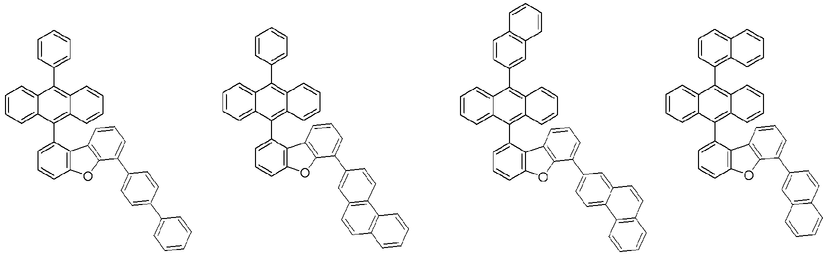

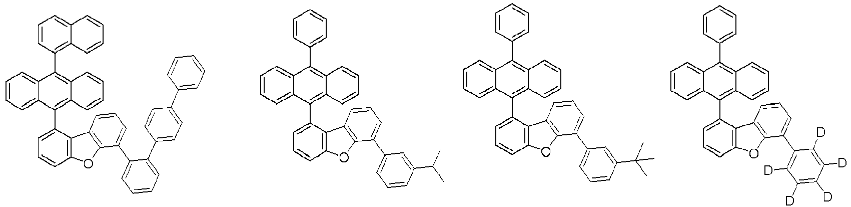

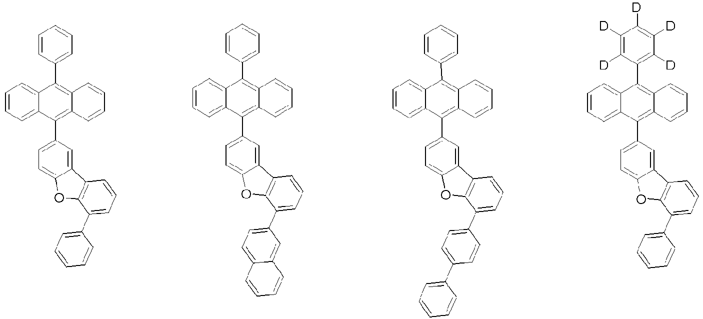

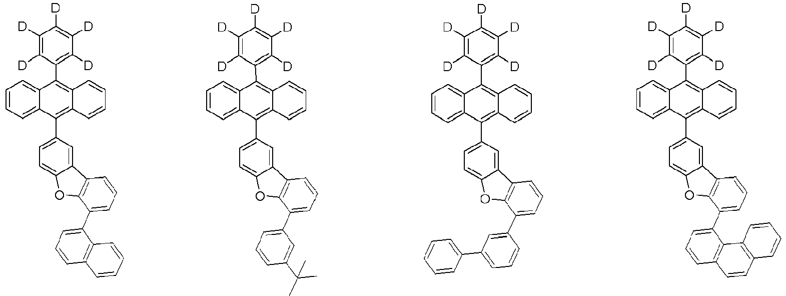

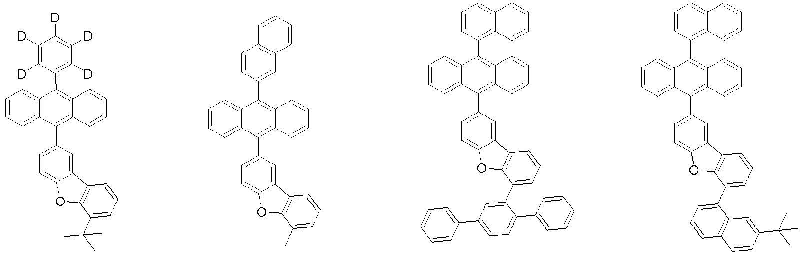

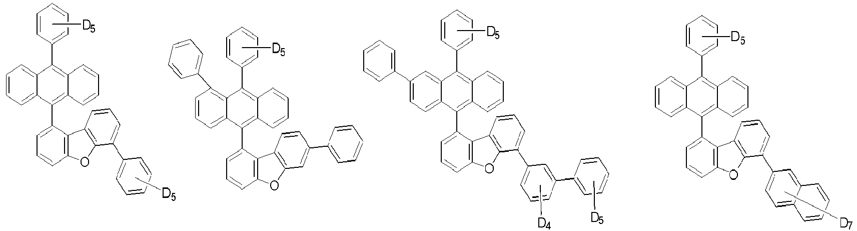

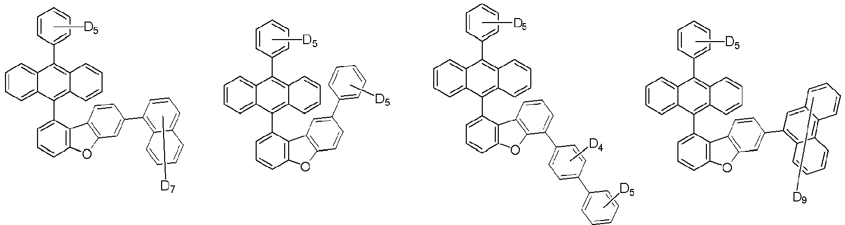

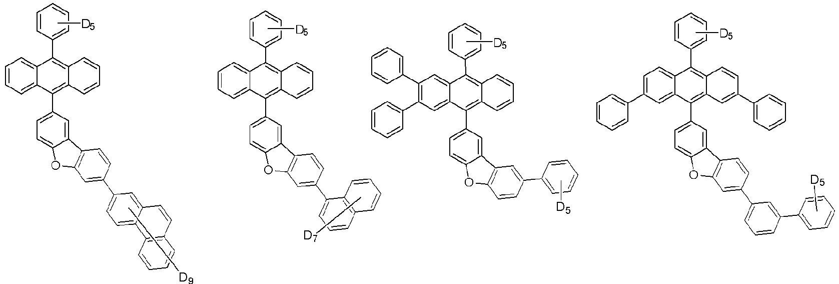

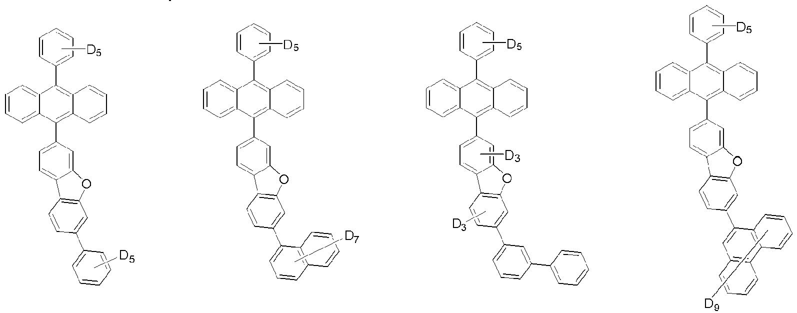

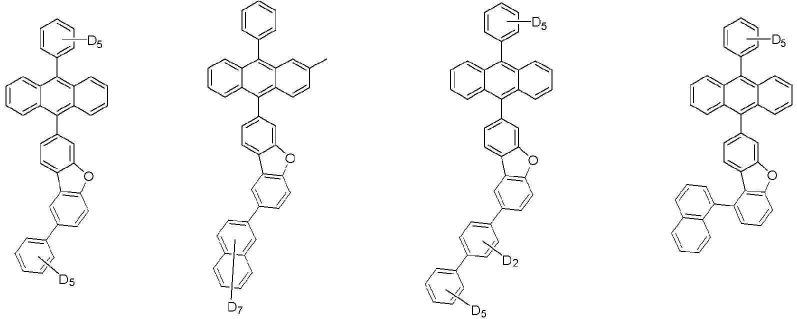

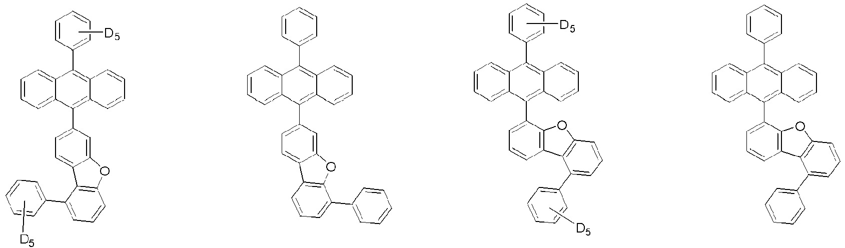

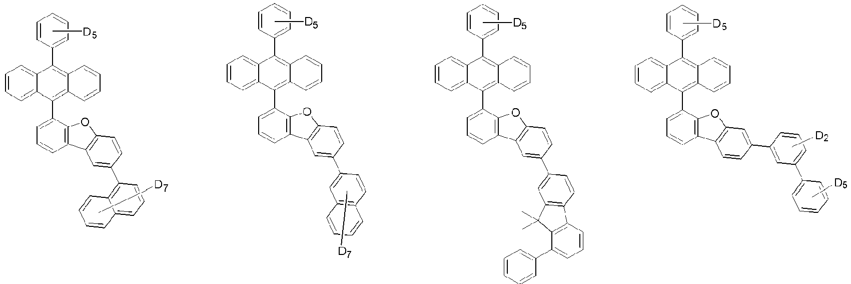

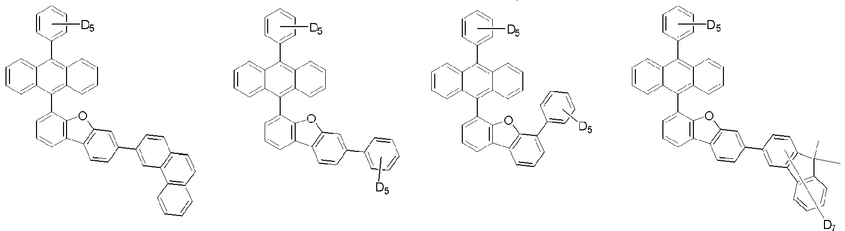

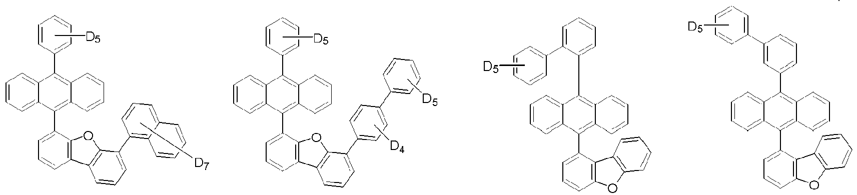

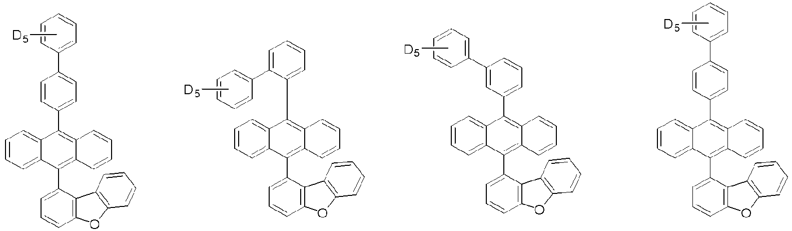

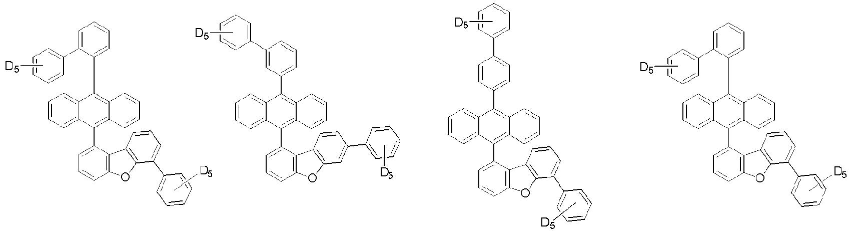

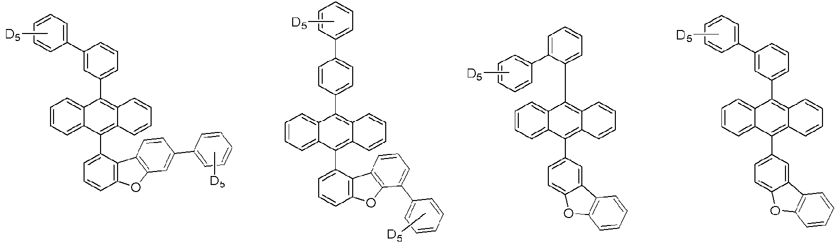

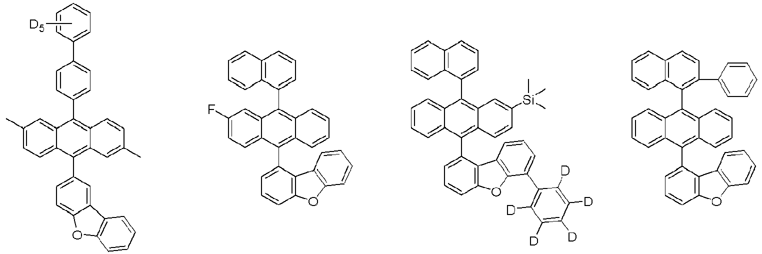

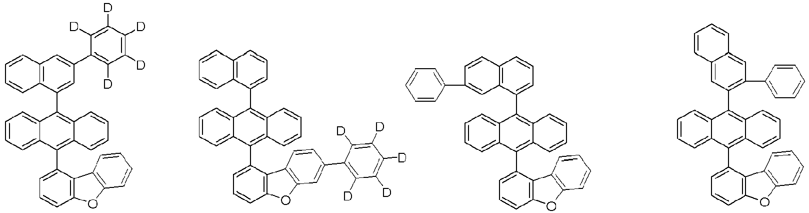

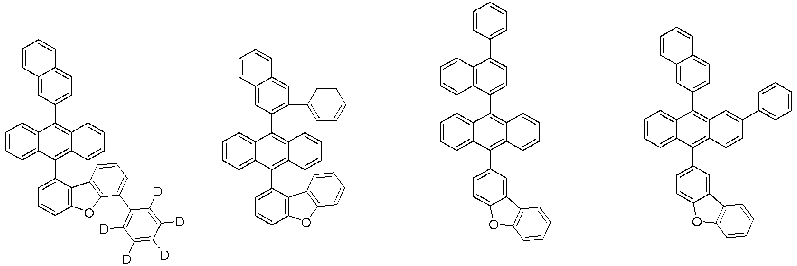

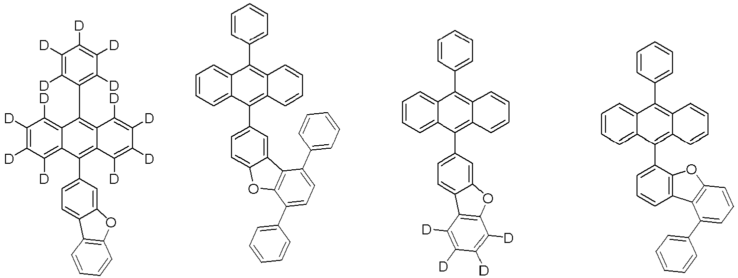

8. Dispositif électroluminescent organique selon la revendication 6, dans lequel un ou plusieurs composés hôte outre le composé de l'anthracène représenté par la Formule 3 sont mélangés ou empilés dans la couche d'émission de lumière.

9. Dispositif électroluminescent organique selon la revendication 2, ledit dispositif électroluminescent organique étant utilisé dans un système d'affichage ou d'éclairage choisi parmi des écrans à panneau plat, des écrans flexibles, des systèmes d'éclairage monochromatique à panneau plat, des systèmes d'éclairage blanc à panneau plat, des systèmes flexibles d'éclairage monochromatique, des systèmes flexibles d'éclairage blanc, des écrans pour applications automobiles, des écrans pour la réalité virtuelle, et des écrans pour la réalité augmentée.
